(19) Europäisches Patentamt
European Patent Office
Office européen des brevets

(11) EP 2 749 399 B1

(12) **EUROPEAN PATENT SPECIFICATION**

(45) Date of publication and mention of the grant of the patent:
**30.11.2016 Bulletin 2016/48**

(21) Application number: **12825642.7**

(22) Date of filing: **17.08.2012**

(51) Int Cl.:
***B29C 55/14*** (2006.01) ***B29C 47/88*** (2006.01)
***C08G 63/82*** (2006.01) ***C08J 5/18*** (2006.01)
***H01L 31/042*** (2006.01) ***B29K 67/00*** (2006.01)
***B29L 7/00*** (2006.01)

(86) International application number:
**PCT/JP2012/070929**

(87) International publication number:
**WO 2013/027678 (28.02.2013 Gazette 2013/09)**

(54) **BIAXIALLY STRETCHED POLYESTER FILM, METHOD OF PRODUCING SAME, AND SOLAR CELL MODULE**

BIAXIAL GESTRECKTE POLYESTERFOLIE, VERFAHREN ZU IHRER HERSTELLUNG UND SOLARZELLENMODUL

FILM POLYESTER À ÉTIRAGE SUIVANT DEUX AXES, PROCÉDÉ PERMETTANT DE PRODUIRE CELUI-CI ET MODULE DE CELLULES SOLAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.08.2011 JP 2011184151**

(43) Date of publication of application:
**02.07.2014 Bulletin 2014/27**

(73) Proprietor: **Fujifilm Corporation**
**Minato-ku**
**Tokyo 106-8620 (JP)**

(72) Inventor: **SHIROKURA, Yukio**
**Fujinomiya-shi**
**Shizuoka 418-8666 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 016 693**
**WO-A1-2007/072893**
**JP-A- 2002 046 172**
**JP-A- 2004 182 975**
**JP-A- 2006 117 819**
**JP-A- 2008 045 082**
**JP-A- 2009 149 066**
**JP-A- 2009 149 066**
**JP-A- 2010 260 903**
**JP-A- 2011 124 428**
**JP-A- 2011 153 209**
**JP-A- 2011 153 209**
**JP-A- 2011 162 777**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

Technical Field

The present invention relates to a biaxially stretched polyester film, a method of producing the same, and a solar cell module.

Background Art

A polyester film has been used for various purposes such as for electrical insulation and for optical use. Recently, usage in electrical insulation, in particular, in a solar cell, such as a back sheet for a solar cell has attracted attention.

Excellent hydrolysis resistant performance is demanded for a polyester film for a rear surface protective sheet for a solar cell (appropriately referred to as a back sheet for a solar cell, or a back sheet) so as to protect elements for a long period of time. In addition, a high voltage is applied for a long period of time during operation of a solar cell system, and thus high electrical insulating properties are demanded for the polyester film for a back sheet. Currently, a solar cell system corresponding to 1000 V has been suggested, but an increase in a system voltage has been demanded for high performance, and thus it is necessary for the insulating properties of the back sheet to be further improved.

Weather resistance, strength, and transparency are demanded for a polyester film for an outdoor type display and the like.

Japanese Patent Application Laid-Open (JP-A) No. 2006-253264 suggests a back sheet for a solar cell. In the back sheet, a gas barrier deposition film in which a deposition layer formed from an inorganic oxide is provided on a base material film, and a polyester film having electrical insulating properties are laminated and are integrated.

JP-A No. 2008-166338 suggests a back sheet for a solar cell. The back sheet includes a resin film that comes into contact with a filler, and a hydrolysis resistant white resin film becomes an outermost layer, and a partial discharge voltage is 1000 V or greater.

JP-A-2010-260903 discloses biaxially stretched PET films for solar cells of low haze and low carboxy end group content.

JP-A-2011/153209 discloses biaxially drawn polyester films of different thicknesses for solar cells. 9 JP-A-2009/149066 discloses high refractive index and breaking strength films for solar cells.

SUMMARY OF INVENTION

Technical Problem

An object of the present invention is to provide a polyester film having hydrolysis resistance properties, electrical insulating properties, strength, and transparency which are sufficient for long-term outdoor use, and a method of manufacturing the polyester film. In addition, another object of the present invention is to provide a solar cell module capable of maintaining photoelectric conversion characteristics over a long period of time. Solution to Problem

To accomplish the objects, the following aspects are provided.

<1> A biaxially stretched polyester film having:a thickness of from 200 μm to 800 μm;fracture strength in both a longitudinal stretching direction (MD) and a lateral stretching direction (TD) of from 180 MPa to 300 MPa;an internal haze (Hin) of from 0.3% to 20%;a difference (AH = Hsur - Hin) between an external haze (Hsur) and the internal haze (Hin) of 2% or less; and an intrinsic viscosity of from 0.68 to 0.90,wherein the biaxially stretched polyester film is formed of a polyester that comprises an ethylene terephthalate unit or a 1,4-cyclohexane dimethylene terephthalate unit as 80% by mole or greater of its constituent unit and that has a concentration of terminal carboxyl groups of 25 eq/ton or less,wherein the external haze (Hsur) represents a scattering magnitude of reflected light on a surface of the film,and wherein with respect to the internal haze (Hin), the biaxially stretched film is put in a quartz cell in which tricresyl phosphate is filled and which has a thickness of 10 mm, and then the internal haze is measured by using a haze meter, while the external haze (Hsur) is directly measured by the same apparatus without immersing the biaxially stretched film in the tricresyl phosphate;with respect to the fracture strength, tension test of a polyester film is carried out by using a tensilon universal tension tester under an environment of 25°C and 60%RH, and a drawing rate of 20%/minute, wherein the polyester film has a size of 1 cm (width) x 20 cm in each of a film production flow direction (MD) and a film width direction (TD) and fracture strength values in the directions MD and TD are obtained; and with respect to the intrinsic viscosity, a polyester is dissolved in a mixed solution of 1,1,2,2-tetrachloroethane/phenol (=2/3 [mass ratio]) at 25°C and the intrinsic viscosity is measured at 25°C by using Ubbelohde viscometer.

<2> The biaxially stretched polyester film according to <1>, wherein a content of voids with a maximum length of 1 μm or greater is one void or less per 400 $μm^2$ of the biaxially stretched polyester film.

<3> The biaxially stretched polyester film according to <1> or <2>, wherein the biaxially stretched polyester film is formed of a polyester that comprises an ethylene terephthalate unit or a 1,4-cyclohexane dimethylene terephthalate unit as 80% by mole or greater of its constituent unit and that has a concentration of terminal carboxyl groups of 25 eq/ton or less.
<4> The biaxially stretched polyester film according to any one of <1> to <3>, wherein:

the biaxially stretched polyester film comprises a polyester that is synthesized using, as a polymerization catalyst, at least one selected from the group consisting of a titanium compound, an aluminum compound and a germanium compound, all of which are soluble in glycol; and
a total of a content of a phosphorous element and a content of a metal element in the biaxially stretched polyester film is from 10 ppm to 300 ppm.

<5> In the biaxially stretched polyester film according to any one of <1> to <4>, wherein 0.1% by mole to 20% by mole or 80% by mole to 100% by mole of its constituent unit is a 1,4-cyclohexane dimethylene terephthalate unit.
<6> A method of producing the biaxially stretched polyester film according to any one of <1> to <5>, the method comprising:

preparing a raw material polyester resin that is synthesized using, as a polymerization catalyst, at least one selected from the group consisting of a titanium compound, an aluminum compound and a germanium compound, all of which are soluble in glycol, and in which a total of a content of a phosphorous element and a content of a metal element is 300 ppm or less;
plasticizing the raw material polyester resin at a temperature in a range from a temperature higher than a melting point of the raw material polyester by 10°C to a temperature higher than the melting point by 35°C, melt-extruding the polyester resin, and cooling the melt-extruded polyester resin to form an unstretched polyester film having a thickness of from 2.5 mm to 7.0 mm; and
longitudinally stretching and laterally stretching the unstretched polyester film to form a biaxially stretched polyester film having a thickness of from 200 $\mu$m to 800 $\mu$m.

<7> The method according to <6>, wherein an intrinsic viscosity IV of the raw material polyester resin is from 0.68 to 0.95.
<8> The method according to <6> or <7>, wherein a compound including a cyclic structure, in which a primary nitrogen and a secondary nitrogen of a carbodiimide group are bonded by a bonding group, is added to the raw material polyester resin before the cooling at an amount of from 0.1% by mass to 5% by mass with respect to a mass of the raw material polyester resin.
<9> A solar cell module comprising the biaxially stretched polyester film according to any one of <1> to <5>.

Advantageous Effects of Invention

According to the present invention, a polyester film that has hydrolysis resistance, electrical insulating properties, strength, and transparency which are sufficient for long-term outdoor use, and a method of manufacturing the polyester film may be provided. In addition, according to the present invention, a solar cell module capable of maintaining photoelectric conversion characteristics over a long period of time may be provided.

BRIEF DESCRIPTION OF DRAWINGS

Fig. 1 is a schematic diagram illustrating an example of a configuration of a twin-screw extruder for carrying out a method of manufacturing a polyester film according to an embodiment of the present invention.
Fig. 2 is a diagram illustrating an exemplary embodiment of a flow for carrying out the method of manufacturing a polyester film according to an embodiment of the present invention.

DESCRIPTION OF EMBODIMENTS

An expression of a numerical value range in this specification represents a range including a numerical value expressed as the lower limit of the numerical value range and a numerical value expressed as the upper limit of the numerical value range as a minimum value and a maximum value, respectively.
In a case of referring to an amount of a component contained in a composition, when plural materials corresponding to the component are present in the composition, the amount represents the total amount of the plural materials that are present in the composition unless otherwise stated.

With regard to a term of "process", not only an individual process but also a process that is not clearly discriminated from other processes is included in the term as long as an operation intended by the present process is achieved thereby.

A unit of "ppm" that represents an abundance of a component in a composition is a value in terms of a mass (that is, an expression of a mass of the component with respect to the total mass of the composition) unless otherwise stated.

<Biaxially Stretched Polyester Film>

A biaxially stretched polyester film (appropriately referred to as a "polyester film" or a "film), which is an embodiment of the present invention, has a thickness of from 200 μm to 800 μm, fracture strength in both a longitudinal stretching direction and a lateral stretching direction of from 180 MPa to 300 MPa, an internal haze (Hin) of from 0.3% to 20%, a difference (ΔH = Hsur - Hin) between an external haze (Hsur) and the internal haze (Hin) of 2% or less, and an intrinsic viscosity of from 0.68 to 0.90.

The polyester film has a thickness of 200 μm or greater, and has high transparency. That is, the polyester film is thick polyester having a low haze. In addition, the polyester film has a thickness of 200 μm or greater, and has high hydrolysis resistant performance and fracture stress.

- Film Thickness -

The thickness of the biaxially stretched polyester film is from 200 μm to 800 μm, preferably from 240 μm to 500 μm, and more preferably from 240 μm to 400 μm.

When the film thickness is less than 200 μm, it is difficult to obtain a partial discharge voltage of 1 kV or greater. From the viewpoint of securing the partial discharge voltage of 1 kV or greater in a relatively stable manner, the film thickness is preferably 240 μm or greater.

When the film thickness exceeds 800 μm, a huge amount of tension is necessary to carry out biaxial stretching, and thus productivity may deteriorate. From the viewpoints of winding, cutting, and conveying properties for secondary processing of the biaxially stretched film that is obtained, the film thickness is preferably 500 μm or less.

- Fracture Strength -

From the viewpoints of securing physical strength sufficient for a back sheet for a solar cell or a protective film for an outdoor display, the fracture strength of the polyester film in longitudinal and lateral stretching directions is from 180 MPa to 300 MPa, and preferably from 200 MPa to 250 MPa. When the fracture strength exceeds 300 MPa, fracture tends to occur during stretching of the film, and thus productivity may deteriorate. An optimal range of the fracture strength which is capable of securing satisfactory productivity and practical strength of the film is from 205 MPa to 240 MPa.

- Haze -

The smaller a haze of a film, the more satisfactory the transparency, but the fracture strength of the film decreases. From this viewpoint, an internal haze (Hin) of the polyester film is set to from 0.3% to 20%, preferably from 0.5% to 15%, and more preferably from 1% to 10%. When the internal haze is less than 0.3%, the fracture strength of the film may not be sufficiently secured in some cases. In addition, when the internal haze exceeds 20%, the film tends to be fractured during stretching, and thus productivity becomes poor.

In the biaxially stretched polyester film, a difference (ΔH = Hsur - Hin) between the internal haze (Hin) and an external haze (Hsur) is 2% or less. Hsur represents a scattering magnitude of reflected light on a surface of the film. When ΔH exceeds 2%, flatness of the film surface is poor, and thus surface glossiness decreases. When ΔH to less than 0.1%, it is necessary to greatly lower a production rate so as to greatly suppress scratches and the like which occur due to contact with a roll during a film stretching process, and thus productivity may decrease. When ΔH is 1% or less, satisfactory surface flatness and/or surface glossiness of the film may be obtained. Accordingly, in an embodiment, ΔH is preferably from 0.1% to 1%.

With regard to measurement of the internal haze (Hin), the biaxially stretched film is put in a quartz cell in which tricresyl phosphate is filled and which has a thickness of 10 mm, and then the internal haze is measured using a haze meter (for example, SM color computer manufactured by Suga Test Instruments Co., Ltd., product name: SM-T-H1 type). When the film is immersed in tricresyl phosphate, an effect of reflection, scattering, and the like due to scratches or unevenness in a film surface is removed, and thus the haze inside the film may be measured. The external haze

(Hsur) is directly measured by the same apparatus without immersing the biaxially stretched film in the tricresyl phosphate.

- Void in Film -

The biaxially stretched polyester film preferably has a content of voids with a maximum length of 1 μm or greater of one void/400 $\mu m^2$ or less, and preferably has substantially no void having the above-described size. The voids in the film are confirmed by cutting the film using a sharp cutter and observing a cross-section thereof using an electronic microscope at a magnification of 1000 times.

When an insoluble component is present in polyester during a film manufacturing process, an interface between the insoluble component and the polyester is separated during biaxial stretching, and voids are generated in the film. A catalyst and additives which are used for polymerization of polyester, and foreign substances in glycol and a dicarboxylic acid compound, which are raw materials, become a cause of void generation. When the voids are present, fracture tends to occur during longitudinal stretching and lateral stretching in the film manufacturing process. In addition, intersperseed voids serve as an origin of the film fracture, and fracture strength is not stabilized. The content of the voids with the maximum length of 1 μm or greater is more preferably 0.5 voids or less per 400 $\mu m^2$ of the film, and still more preferably 0.2 voids or less.

- Content of Polyethylene terephthalate Component -

The polyester film is preferably formed from polyester mainly composed of polyethylene terephthalate or poly-1,4-cyclohexane dimethylene terephthalate.

In a case in which the polyester film is formed from polyester mainly composed of polyethylene terephthalate, in an embodiment, a content of an ethylene terephthalate unit in the polyester is preferably 80% by mole or greater, more preferably 85% by mole or greater, and still more preferably 90% by mole or greater, with respect to the total of polymerizable components (that is, constituent units) that form the polyester.

In a case in which the polyester film is formed from polyester mainly composed of poly-1,4-cyclohexane dimethylene terephthalate, in an embodiment, the content of a 1,4-cyclohexanedimethanol (CHDM) unit in polyester is preferably 80% by mole or greater, more preferably 85% by mole or greater, and still more preferably 90% by mole or greater, with respect to the total of polymerizable components (that is, constituent units) that form the polyester. When the ethylene terephthalate unit or the CHDM unit is 80% by mole or greater, excellent heat resistance or hydrolysis resistance may be obtained in the film.

In an embodiment, when the content of the ethylene terephthalate unit or the CHDM unit is set to the preferable range, and another copolymerizable component may be added in a range not exceeding 20% by mole to vary a crystallization speed and crystallinity of polyethylene terephthalate or poly-1,4-cyclohexane dimethylene terephthalate to thereby reduce the internal haze of the film.

In addition, in an embodiment, in a case in which the polyester film is formed from a polyester containing poly-1,4-cyclohexane dimethylene terephthalate, the content of a 1,4-cyclohexane dimethylene terephthalate (CHDM) unit in the polyester may be from 0.1% by mole to 100% by mole with respect the total constituent units of the polyester, and in an embodiment, the content is preferably 80% by mole or greater. In addition, in an embodiment, the content is preferably from 0.1% by mole to 20% by mole or from 80% by mole to 100% by mole, more preferably from 0.5% by mole to 16% by mole or from 83% by mole to 98% by mole, and still more preferably from 1% by mole to 12% by mole or from 86% by mole to 96% by mole. When the content of the CHDM unit is in this range, weather resistance of the film may become excellent.

In the preferable embodiments, the reason why two regions including the region in which the content of the CHDM unit is small (0.1% by mole to 20% by mole) and the region in which the content of the CHDM unit is large (80% by mole to 100% by mole) are present is that in these regions, the polyester particularly easily forms a crystal, and a "tie chain", which is a non-crystal introduced between crystals and bridges therebetween, is easily formed. That is, in these two regions, the polyester can easily have a crystalline structure, and can easily exhibit high mechanical strength and high heat resistance. When such a CHDM unit-derived structure is present in polyester molecules, the orientation of the polyester molecules increases, and generation of the tie chain is promoted. The reason of the phenomenon is considered as follows.

- Cyclic Structure Compound -

In an embodiment, the polyester film may contain: (A) polyester; and (B) at least one of: a compound (hereinafter, also referred to as a "cyclic carbodiimide compound) including a cyclic structure in which primary nitrogen and secondary nitrogen of a carbodiimide group are bonded by a bonding group; or a component having a structure derived from the cyclic carbodiimide compound.

In an embodiment, the cyclic carbodiimide compound may be added in a content of 0.1 % by mass to 5% by mass with respect to a content of a polyester that forms the polyester film during manufacturing of the polyester film.

The (B) cyclic carbodiimide compound is a so-called terminal blocking agent and blocks a terminal carboxyl group of the (A) polyester, and thus may improve heat and humidity resistance of the polyester film.

A molecular weight of the cyclic carbodiimide compound is preferably 400 or greater, and more preferably from 500 to 1500.

The cyclic carbodiimide compound may have plural cyclic structures.

In the cyclic carbodiimide compound, the cyclic structure has one carbodiimide group (-N=C=N-), and primary nitrogen and secondary nitrogen are bonded by a bonding group. Only one carbodiimide group is included in one cyclic structure. The cyclic carbodiimide compound may have one or plural carbodiimide groups in a molecule thereof. For example, in a case in which the cyclic carbodiimide compound has plural cyclic structures such as a spiro ring in a molecule thereof, one carbodiimide group is included in each cyclic structure that is bonded to a spiro atom, and thus plural carbodiimide groups may be present in one molecule of the compound. The number of atoms in the cyclic structure is preferably from 8 to 50, more preferably from 10 to 30, still more preferably from 10 to 20, and still more preferably from 10 to 15.

Here, the number of atoms in the cyclic structure represents the number of atoms that directly constitutes the cyclic structure. For example, when the cyclic structure is an 8-membered ring, the number of atoms is 8, and when the cyclic structure is a 50-membered ring, the number of atoms is 50. When the number of atoms in the cyclic structure is 8 or greater, stability of the cyclic carbodiimide compound is improved, and storage and use may be easy. An upper limit of the number of members of the ring is not particularly limited from the viewpoint of reactivity, while it may be preferably 50 from the viewpoint of avoiding a cost increase due to a difficulty in a synthesis.

It is preferable that the cyclic structure has a structure expressed by the following

Formula (1).

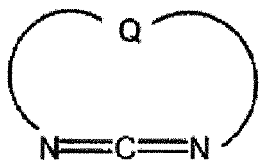

(1)

In Formula (1), Q represents a bonding group having a valence of from 2 to 4 and selected from the group consisting of an aliphatic group, a cyclic group, an aromatic group, and a combination of two or more groups selected from the groups. In addition, the combination of two or more groups may be an embodiment in which plural members of the same group are combined.

The aliphatic group, the cyclic group, and the aromatic group which form Q may respectively contain at least one of a heteroatom or a substituent group. Herein, the heteroatom represents O, N, S, or P. Two valences of the valences of the bonding group are used to form the cyclic structure. In a case in which Q is a trivalent or tetravalent bonding group, Q is bonded to a polymer or another cyclic structure through at least one of a single bond, a double bond, an atom, or an atomic group.

Preferably, each bonding group may contain at least one of a heteroatom or a substituent group. The bonding group represents an aliphatic group having a valence of from 2 to 4 and having 1 to 20 carbon atoms, a cyclic group having a valence of from 2 to 4 and having 3 to 20 carbon atoms, an aromatic group having a valence of from 2 to 4 and having 5 to 15 carbon atoms, and a combination of two or more groups selected from these. The bonding group is a bonding group having carbon atoms necessary to form the cyclic structure defined above. Examples of the combination include a structure such as an alkylene-arylene group in which an alkylene group and an arylene group are bonded.

It is preferable that the bonding group (Q) be a bonding group having a valence of from 2 to 4 and expressed by the following Formula (1-1), (1-2), or (1-3).

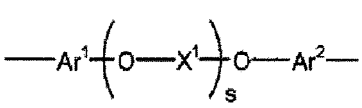

(1 − 1)

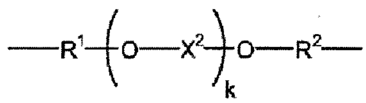

(1-2)

$-X^3-$ (1-3)

In the Formulae, each of $Ar^1$ and $Ar^2$ independently represents an aromatic group having a valence of from 2 to 4 and having 5 to 15 carbon atoms. Each of $Ar^1$ and $Ar^2$ may independently contain at least one of a heteroatom or a monovalent substituent group.

Examples of the aromatic group include an arylene group having 5 to 15 carbon atoms, an arenetriyl group having 5 to 15 carbon atoms, and an arenetetrayl group having 5 to 15 carbon atoms, each of which may contain a heteroatom to have a heterocycle structure. Examples of the arylene group (divalent) include a phenylene group and a naphthalenediyl group. Examples of the arenetriyl group (trivalent) include a benzenetriyl group and a naphthalenetriyl group. Examples of the arenetetrayl group (tetravalent) include a benzenetetrayl group and a naphthalenetetrayl group. These aromatic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, and an aldehyde group.

Each of $R^1$ and $R^2$ independently represents an aliphatic group having a valence of from 2 to 4 and having 1 to 20 carbon atoms, an alicyclic group having a valence of from 2 to 4 and having 3 to 20 carbon atoms, a combination of two or more groups selected from these, or a combination of the aliphatic group or the alicyclic group and an aromatic group having a valence of from 2 to 4 and having 5 to 15 carbon atoms, each of which may independently contain at least one of a heteroatom or a monovalent substituent group.

Examples of the aliphatic group include an alkylene group having 1 to 20 carbon atoms, an alkanetriyl group having 1 to 20 carbon atoms, and an alkanetetrayl group having 1 to 20 carbon atoms. Examples of the alkylene group include a methylene group, an ethylene group, a propylene group, a butylene group, a pentylene group, a hexylene group, a heptylene group, an octylene group, a nonylene group, a decylene group, a dodecylene group, and a hexadecylene group. Examples of the alkanetriyl group include a methanetriyl group, an ethanetriyl group, a propanetriyl group, a butanetriyl group, a pentanetriyl group, a hexanetriyl group, a heptanetriyl group, an octanetriyl group, a nonanetriyl group, a decanetriyl group, a dodecanetriyl group, and a hexadecanetriyl group. Examples of the alkanetetrayl group include a methanetetrayl group, an ethanetetrayl group, a propanetetrayl group, a butanetetrayl group, a pentanetetrayl group, a hexanetetrayl group, a heptanetetrayl group, an octanetetrayl group, a nonanetetrayl group, a decanetetrayl group, a dodecanetetrayl group, and a hexadecanetetrayl group. The aliphatic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, and an aldehyde group.

Examples of the alicyclic group include a cycloalkylene group having 3 to 20 carbon atoms, a cycloalkanetriyl group having 3 to 20 carbon atoms, and a cycloalkanetetrayl group having 3 to 20 carbon atoms. Examples of the cycloalkylene group include a cyclopropylene group, a cyclobutylene group, a cyclopentylene group, a cyclohexylene group, a cycloheptylene group, a cyclooctylene group, a cyclononylene group, a cyclodecylene group, a cyclododecylene group, and a cyclohexadecylene group. Examples of the alkanetriyl group include a cyclopropanetriyl group, a cyclobutanetriyl group, a cyclopentanetriyl group, a cyclohexanetriyl group, a cycloheptanetriyl group, a cyclooctanetriyl group, a cyclononanetriyl group, a cyclodecanetriyl group, a cyclododecanetriyl group, and a cyclohexadecanetriyl group. Examples of the alkanetetrayl group include a cyclopropanetetrayl group, a cyclobutanetetrayl group, a cyclopentanetetrayl group, a cyclohexanetetrayl group, a cycloheptanetetrayl group, a cyclooctanetetrayl group, a cyclononanetetrayl group, a cyclodecanetetrayl group, a cyclododecanetetrayl group, and a cyclohexadecanetetrayl group. The alicyclic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, an aldehyde group, and the like.

Examples of the aromatic group include an arylene group having 5 to 15 carbon atoms, an arenetriyl group having 5 to 15 carbon atoms, and an arenetetrayl group having 5 to 15 carbon atoms, each of which may contain a heteroatom to have a heterocycle structure. Examples of the arylene group include a phenylene group, a naphthalenediyl group, and the like. Examples of the arenetriyl group (trivalent) include a benzenetriyl group, a naphthalenetriyl group, and the like. Examples of the arenetetrayl group (tetravalent) include a benzenetetrayl group, a naphthalenetetrayl group, and the like. These aromatic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, and an aldehyde group.

In Formulae (1-1) and (1-2), each of $X^1$ and $X^2$ independently represents an aliphatic group having a valence

of from 2 to 4 and having 1 to 20 carbon atoms, an alicyclic group having a valence of from 2 to 4 and having 3 to 20 carbon atoms, an aromatic group having a valence of from 2 to 4 and having 5 to 15 carbon atoms, or a combination of two or more groups selected from these, each of which may contain at least one of a heteroatom or a monovalent substituent group.

Examples of the aliphatic group include an alkylene group having 1 to 20 carbon atoms, an alkanetriyl group having 1 to 20 carbon atoms, and an alkanetetrayl group having 1 to 20 carbon atoms. Examples of the alkylene group include a methylene group, an ethylene group, a propylene group, a butylene group, a pentylene group, a hexylene group, a heptylene group, an octylene group, a nonylene group, a decylene group, a dodecylene group, a hexadecylene group, and the like. Examples of the alkanetriyl group include a methanetriyl group, an ethanetriyl group, a propanetriyl group, a butanetriyl group, a pentanetriyl group, a hexanetriyl group, a heptanetriyl group, an octanetriyl group, a nonanetriyl group, a decanetriyl group, a dodecanetriyl group, and a hexadecanetriyl group. Examples of the alkanetetrayl group include a methanetetrayl group, an ethanetetrayl group, a propanetetrayl group, a butanetetrayl group, a pentanetetrayl group, a hexanetetrayl group, a heptanetetrayl group, an octanetetrayl group, a nonanetetrayl group, a decanetetrayl group, a dodecanetetrayl group, and a hexadecanetetrayl group. The aliphatic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, and an aldehyde group.

Examples of the alicyclic group include a cycloalkylene group having 3 to 20 carbon atoms, a cycloalkanetriyl group having 3 to 20 carbon atoms, and a cycloalkanetetrayl group having 3 to 20 carbon atoms. Examples of the cycloalkylene group include a cyclopropylene group, a cyclobutylene group, a cyclopentylene group, a cyclohexylene group, a cycloheptylene group, a cyclooctylene group, a cyclononylene group, a cyclodecylene group, a cyclododecylene group, and a cyclohexadecylene group. Examples of the alkanetriyl group include a cyclopropanetriyl group, a cyclobutanetriyl group, a cyclopentanetriyl group, a cyclohexanetriyl group, a cycloheptanetriyl group, a cyclooctanetriyl group, a cyclononanetriyl group, a cyclodecanetriyl group, a cyclododecanetriyl group, and a cyclohexadecanetriyl group. Examples of the alkanetetrayl group include a cyclopropanetetrayl group, a cyclobutanetetrayl group, a cyclopentanetetrayl group, a cyclohexanetetrayl group, a cycloheptanetetrayl group, a cyclooctanetetrayl group, a cyclononanetetrayl group, a cyclodecanetetrayl group, a cyclododecanetetrayl group, and a cyclohexadecanetetrayl group. The alicyclic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, and an aldehyde group.

Examples of the aromatic group include an arylene group having 5 to 15 carbon atoms, an arenetriyl group having 5 to 15 carbon atoms, and an arenetetrayl group having 5 to 15 carbon atoms, each of which may contain a heteroatom to have a heterocycle structure. Examples of the arylene group include a phenylene group, a naphthalenediyl group, and the like. Examples of the arenetriyl group (trivalent) include a benzenetriyl group and a naphthalenetriyl group. Examples of the arenetetrayl group (tetravalent) include a benzenetetrayl group and a naphthalenetetrayl group. These aromatic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, and an aldehyde group.

In Formulae (1-1) and (1-2), s and k preferably represent an integer from 0 to 10, respectively, more preferably an integer from 0 to 3, and still more preferably an integer from 0 to 1. When s and k is 10 or less, a cost increase due to a difficulty in a synthesis of the cyclic carbodiimide compound may be avoided. When s and k is 2 or greater, $X^1$ or $X^2$ as a repeating unit may be the same as or different from another $X^1$ or $X^2$.

In Formula (1-3), $X^3$ represents an aliphatic group having a valence of from 2 to 4 and having 1 to 20 carbon atoms, an alicyclic group having a valence of from 2 to 4 and having 3 to 20 carbon atoms, an aromatic group having a valence of from 2 to 4 and having 5 to 15 carbon atoms, or a combination of two or more groups selected from the groups, each of which may contain at least one of a heteroatom or a monovalent substituent group.

Examples of the aliphatic group include an alkylene group having 1 to 20 carbon atoms, an alkanetriyl group having 1 to 20 carbon atoms, and an alkanetetrayl group having 1 to 20 carbon atoms. Examples of the alkylene group include a methylene group, an ethylene group, a propylene group, a butylene group, a pentylene group, a hexylene group, a heptylene group, an octylene group, a nonylene group, a decylene group, a dodecylene group, and a hexadecylene group. Examples of the alkanetriyl group include a methanetriyl group, an ethanetriyl group, a propanetriyl group, a butanetriyl group, a pentanetriyl group, a hexanetriyl group, a heptanetriyl group, an octanetriyl group, a nonanetriyl group, a decanetriyl group, a dodecanetriyl group, and a hexadecanetriyl group. Examples of the alkanetetrayl group include a methanetetrayl group, an ethanetetrayl group, a propanetetrayl group, a butanetetrayl group, a pentanetetrayl group, a hexanetetrayl group, a heptanetetrayl group, an octanetetrayl group, a nonanetetrayl group, a decanetetrayl group, a dodecanetetrayl group, and a hexadecanetetrayl group. The aliphatic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, an

aldehyde group, and the like.

Examples of the alicyclic group include a cycloalkylene group having 3 to 20 carbon atoms, a cycloalkanetriyl group having 3 to 20 carbon atoms, and a cycloalkanetetrayl group having 3 to 20 carbon atoms. Examples of the cycloalkylene group include a cyclopropylene group, a cyclobutylene group, a cyclopentylene group, a cyclohexylene group, a cycloheptylene group, a cyclooctylene group, a cyclononylene group, a cyclodecylene group, a cyclododecylene group, and a cyclohexadecylene group. Examples of the alkanetriyl group include a cyclopropanetriyl group, a cyclobutanetriyl group, a cyclopentanetriyl group, a cyclohexanetriyl group, a cycloheptanetriyl group, a cyclooctanetriyl group, a cyclononanetriyl group, a cyclodecanetriyl group, a cyclododecanetriyl group, and a cyclohexadecanetriyl group. Examples of the alkanetetrayl group include a cyclopropanetetrayl group, a cyclobutanetetrayl group, a cyclopentanetetrayl group, a cyclohexanetetrayl group, a cycloheptanetetrayl group, a cyclooctanetetrayl group, a cyclononanetetrayl group, a cyclodecanetetrayl group, a cyclododecanetetrayl group, and a cyclohexadecanetetrayl group. The alicyclic groups may have a substituent group. Examples of the substituent group include an alkyl group having 1 to 20 carbon atoms, an arylene group having 6 to 15 carbon atoms, a halogen atom, a nitro group, an amide group, a hydroxyl group, an ester group, an ether group, and an aldehyde group.

Examples of the aromatic group include an arylene group having 5 to 15 carbon atoms, an arenetriyl group having 5 to 15 carbon atoms, and an arenetetrayl group having 5 to 15 carbon atoms, each of which may contain a heteroatom to have a heterocycle structure. Examples of the arylene group include a phenylene group and a naphthalenediyl group. Examples of the arenetriyl group (trivalent) include a benzenetriyl group and a naphthalenetriyl group. Examples of the arenetetrayl group (tetravalent) include a benzenetetrayl group and a naphthalenetetrayl group. These aromatic groups may have a substituent group. Examples of the substituent group include an alkyl group having 1 to 20 carbon atoms, an aryl group having 6 to 15 carbon atoms, a halogen atom, a nitro group, an amide group, a hydroxyl group, an ester group, an ether group, and an aldehyde group.

$Ar^1$, $Ar^2$, $R^1$, $R^2$, $X^1$, $X^2$, and $X^3$ may contain a heteroatom. When Q is a divalent bonding group, all of $Ar^1$, $Ar^2$, $R^1$, $R^2$, $X^1$, $X^2$, and $X^3$ represent divalent groups. When Q is a trivalent bonding group, one of $Ar^1$, $Ar^2$, $R^1$, $R^2$, $X^1$, $X^2$, and $X^3$ represents a trivalent group. When Q is a tetravalent bonding group, one of $Ar^1$, $Ar^2$, $R^1$, $R^2$, $X^1$, $X^2$, and $X^3$ represents a tetravalent group, or two of them represent trivalent groups.

Examples of the cyclic carbodiimide compound include the following compounds expressed by (a) to (c).

(Cyclic Carbodiimide Compound (a))

Examples of the cyclic carbodiimide compound include a compound (hereinafter, referred to as a "cyclic carbodiimide compound (a)) expressed by the following Formula (2).

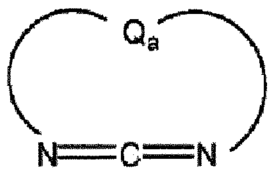

(2)

In Formula (2), $Q_a$ represents a divalent bonding group of an aliphatic group, an alicyclic group, an aromatic group, or a combination of two or more groups selected from the groups, and may contain a heteroatom. Definition or details of the aliphatic group, the alicyclic group, the aromatic group, and the combination group are the same as that described with respect to the aliphatic group, the alicyclic group, the aromatic group, and the combination group which are expressed by Q of Formula (1). Note that in the compound of Formula (2), all of the aliphatic group, the alicyclic group, the aromatic group, and the combination group which are expressed by $Q_a$ are divalent. It is preferable that $Q_a$ be a divalent bonding group expressed by the following Formulae (2-1), (2-2), or (2-3).

$$-Ar_a^1\left(O-X_a^1\right)_s O-Ar_a^2- \qquad (2-1)$$

$$-R_a^1\left(O-X_a^2\right)_k O-R_a^2- \qquad (2-2)$$

$-X_a^3-$ (2-3)

In Formulae (2-1), (2-2), and (2-3), definition and details of $Ar_a^1$, $Ar_a^2$, $R_a^1$, $R_a^2$, $X_a^1$, $X_a^2$, $X_a^3$, s, and k are the same as that described with respect to $Ar^1$, $Ar^2$, $R^1$, $R^2$, $X^1$, $X^2$, $X^3$, s, and k in Formulae (1-1) to (1-3). Note that all of $Ar_a^1$, $Ar_a^2$, $R_a^1$, $R_a^2$, $X_a^1$, $X_a^2$, and $X_a^3$ are divalent.

Examples of the cyclic carbodiimide compound (a) include the following compounds.

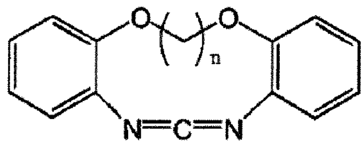

(n represents an integer from 1 to 6.)

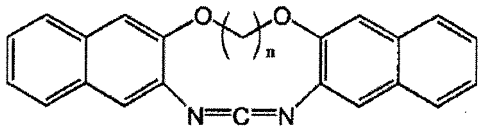

(n represents an integer from 1 to 6.)

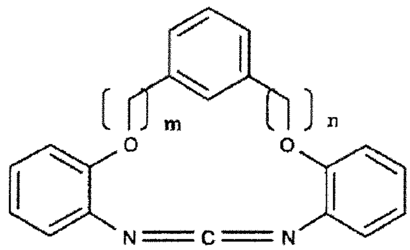

(m represents an integer from 0 to 3, and n represents an integer from 0 to 3.)

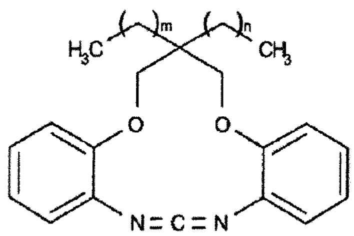

(m represents an integer from 0 to 5, and n represents an integer from 0 to 5.)

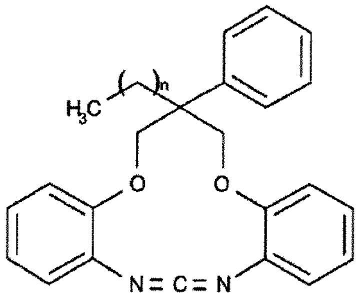

(n represents an integer from 0 to 5.)

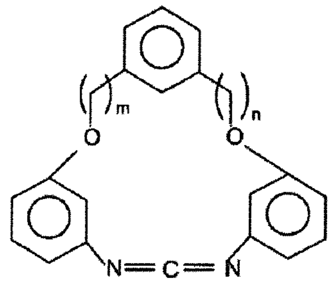

(m and n respectively represent an integer from 0 to 3.)

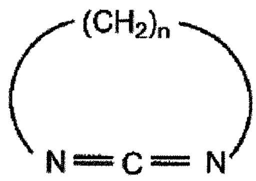

(n represents an integer from 5 to 20.)

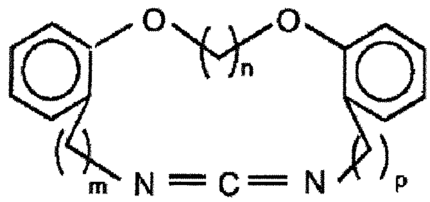

(m, n, p, and q respectively represent an integer from 1 to 6.)

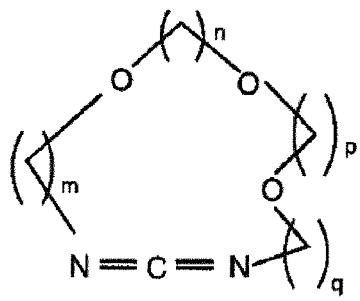

(m, n, p, and q respectively represent an integer from 1 to 6.)

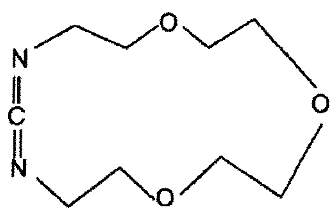

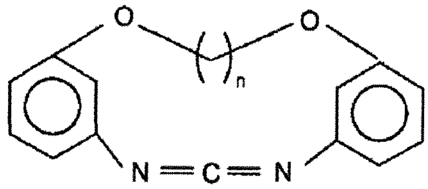

(n represents an integer from 1 to 6.)

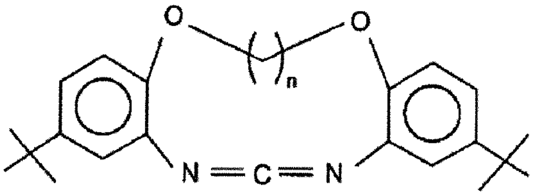

(n represents an integer from 1 to 6.)

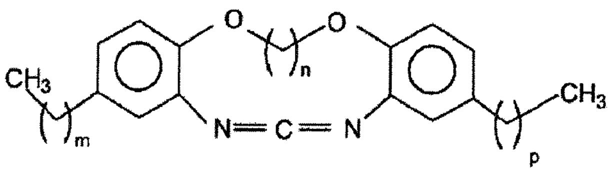

(m and p represent an integer from 1 to 5, and n represents an integer from 1 to 6.)

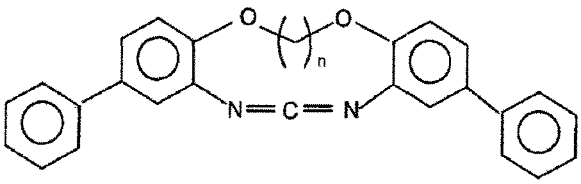

(n represents an integer from 1 to 6.)

(Cyclic Carbodiimide Compound (b))

Examples of the cyclic carbodiimide compound include a compound (hereinafter, referred to as a "cyclic carbodiimide compound (b)) expressed by the following Formula (3).

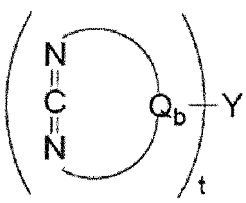

(3)

In Formula (3), $Q_b$ represents a trivalent bonding group of an aliphatic group, an alicyclic group, an aromatic group, or a combination of two or more groups selected from theese, and may contain a heteroatom. t represents an integer of 2 or greater. Y represents a carrier that carries a cyclic structure. Definition or details of the aliphatic group, the alicyclic group, the aromatic group, and the combination group are the same as that described with respect to the aliphatic group, the alicyclic group, the aromatic group, and the combination group which are expressed by Q of Formula (1). However, in the compound of Formula (3), $Q_b$ is trivalent. Accordingly, in a case in which $Q_b$ is a trivalent bonding group which is the combination group, one group among groups that form the combination group is trivalent.

It is preferable that $Q_b$ be a trivalent bonding group expressed by the following Formulae (3-1), (3-2), or (3-3).

$$-Ar_b^1\left(O-X_b^1\right)_s O-Ar_b^2- \qquad (3-1)$$

$$-R_b^1\left(O-X_b^2\right)_k O-R_b^2- \qquad (3-2)$$

$$-X_b^3- \qquad (3-3)$$

In Formulae (3-1), (3-2), and (3-3), definition and details of $Ar_b^1$, $Ar_b^2$, $R_b^1$, $R_b^2$, $X_b^1$, $X_b^2$, $X_b^3$, s, and k are the same as that described with respect to $Ar^1$, $Ar^2$, $R^1$, $R^2$, $X^1$, $X^2$, $X^3$, s, and k in Formulae (1-1) to (1-3). Note that one of $Ar_b^1$, $Ar_b^2$, $R_b^1$, $R_b^2$, $X_b^1$, $X_b^2$, and $X_b^3$ is a trivalent group.

It is preferable that Y be a single bond, a double bond, an atom, an atomic group, or a polymer. Plural cyclic structures are bonded through Y to form a structure expressed by Formula (3).

Examples of the cyclic carbodiimide compound (b) include the following compounds.

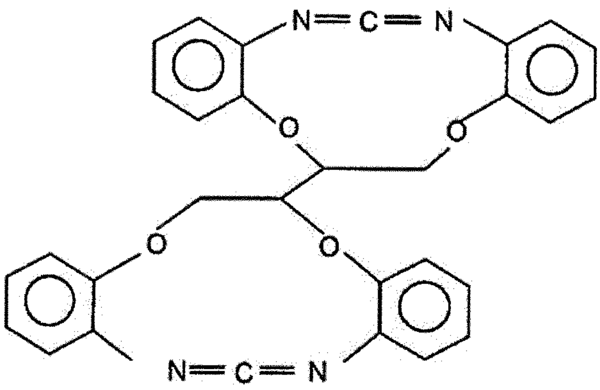

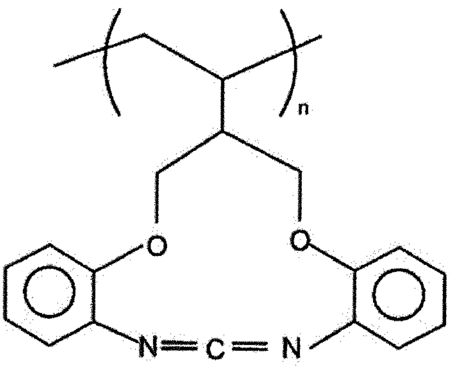

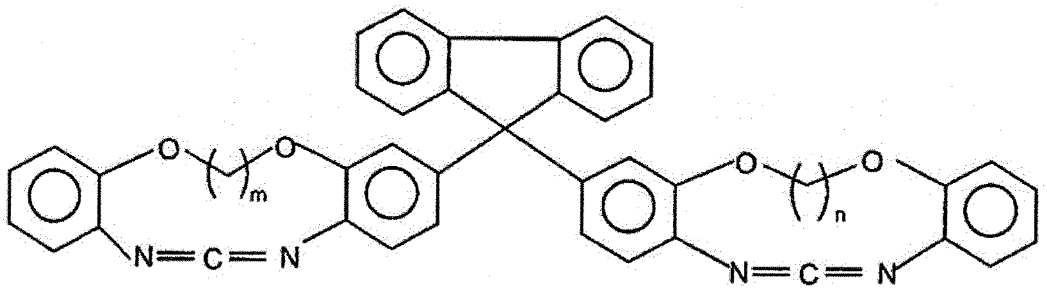

m and n respectively represent an integer from 1 to 6.

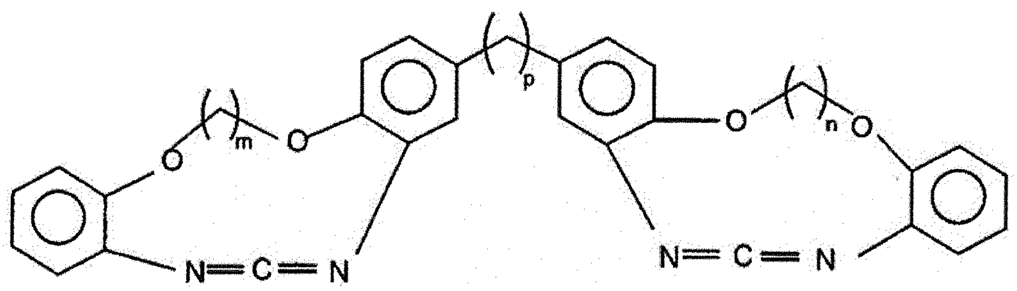

p, m, and n respectively represent an integer from 1 to 6.

(Cyclic Carbodiimide Compound (c))

Examples of the cyclic carbodiimide compound include a compound (hereinafter, referred to as a "cyclic carbodiimide compound (c)) expressed by the following Formula (4).

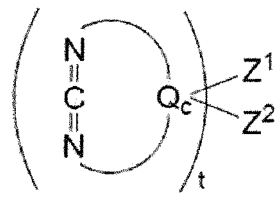

(4)

In Formula (4), $Q_c$ represents a tetravalent bonding group of an aliphatic group, an alicyclic group, an aromatic group, or a combination of two or more groups selected from the groups, and may contain a heteroatom. t represents an integer of 2 or greater. $Z^1$ and $Z^2$ are carriers that carry a cyclic structure. $Z^1$ and $Z^2$ may be bonded to each other to form a cyclic structure. Definition or details of the aliphatic group, the alicyclic group, the aromatic group, and the combination group are the same as that described with respect to the aliphatic group, the alicyclic group, the aromatic group, and the combination group which are expressed by Q of Formula (1). Note that in the compound of Formula (4), $Q_c$ is tetravalent. Accordingly, in a case in which $Q_c$ is a tetravalent bonding group which is the combination group, one group among groups that form the combination group is a tetravalent group, or two groups among groups that form the combination group are trivalent groups.

It is preferable that $Q_c$ be a tetravalent bonding group expressed by the following Formulae (4-1), (4-2), or (4-3).

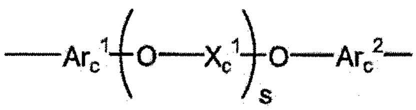

(4-1)

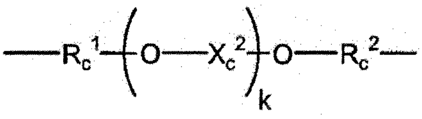

(4-2)

$-X_c^3-$ (4-3)

In Formulae (4-1), (4-2), and (4-3), definition and details of $Ar_c^1$, $Ar_c^2$, $R_c^1$, $R_c^2$, $X_c^1$, $X_c^2$, $X_c^3$, s, and k are the same as that described with respect to $Ar^1$, $Ar^2$, $R^1$, $R^2$, $X^1$, $X^2$, $X^3$, s, and k in Formulae (1-1) to (1-3). Note that one of $Ar_C^1$, $Ar_c^2$, $R_c^1$, $R_c^2$, $X_c^1$, $X_c^2$, and $X_c^3$ is a tetravalent group, or two of them are trivalent groups.

It is preferable that each of $Z^1$ and $Z^2$ independently be a single bond, a double bond, an atom, an atomic group, or a polymer. Plural cyclic structures are bonded to each other through $Z^1$ and $Z^2$ to form a structure expressed by Formula (4).

Examples of the cyclic carbodiimide compound (c) include the following compounds.

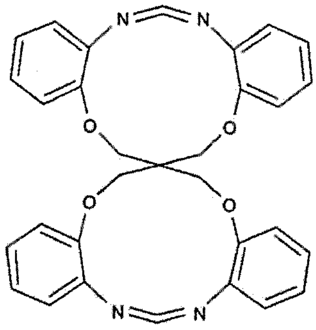

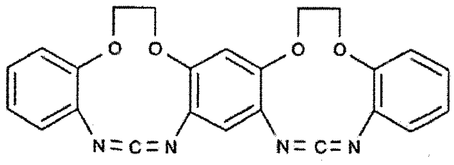

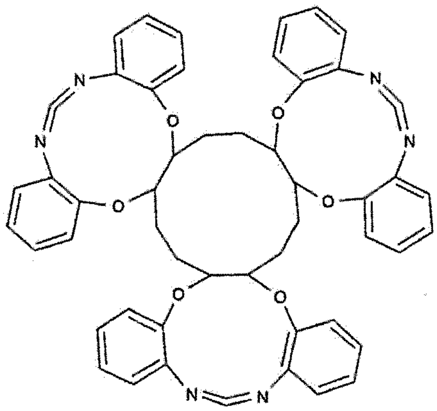

When a cyclic carbodiimide compound is added to polyester, the cyclic carbodiimide compound reacts with carboxylic acid at a terminus of the polyester, and a compound generated by the reaction reacts with a hydroxyl group at a terminus of the polyester or water in the polyester film, whereby various structures may be generated. Specifically, for example, in a case of using the following cyclic carbodiimide compound and using polyethylene terephthalate as polyester, a reaction product (1) or a reaction product (2) which are components having a structure derived from the cyclic carbodiimide component are generated by the following reaction scheme, and a part of the reaction product (1) or the reaction product (2) reacts with the hydroxyl group at a terminus of the polyester, and thus a reaction product (3) or a reaction product (4) may be generated.

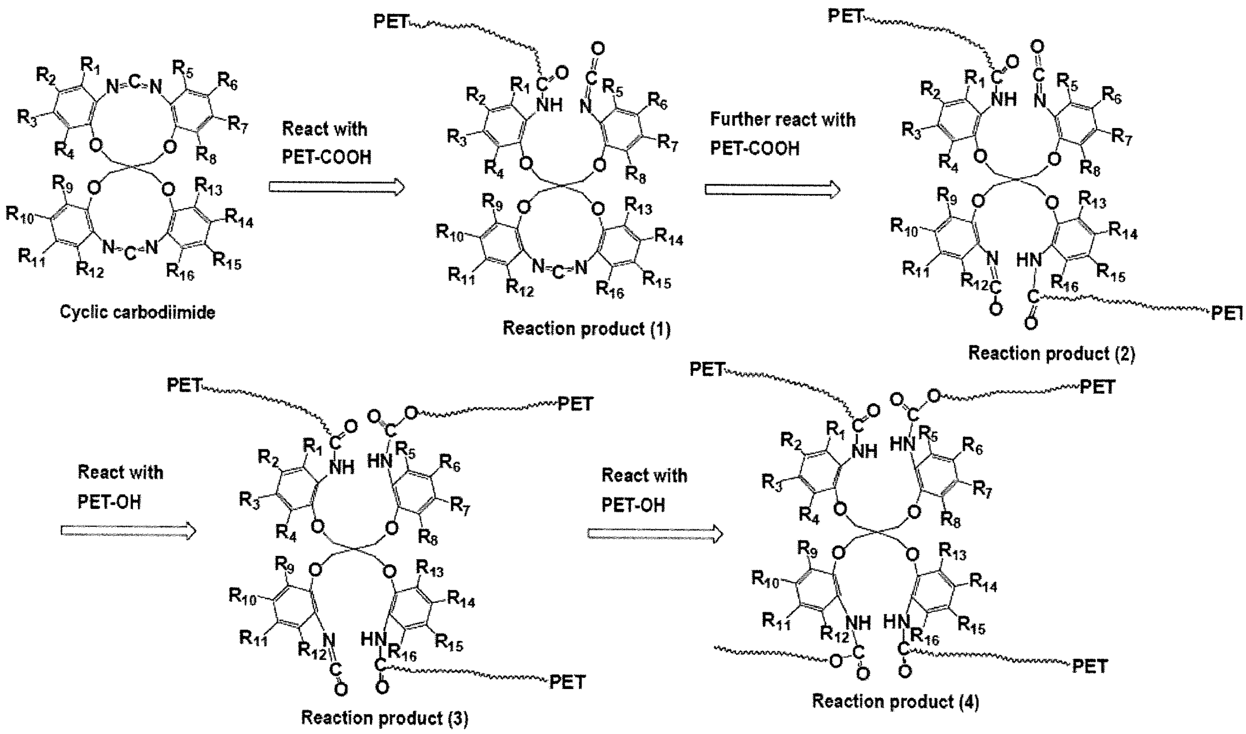

(Method of Manufacturing Cyclic Carbodiimide Compound)

The cyclic carbodiimide compound may be synthesized on the basis of a method described in JP-A No. 2011-256337 and the like.

- Concentration of Terminal Carboxyl Group and Intrinsic Viscosity -

An intrinsic viscosity (IV) of polyester that forms the film is from 0.68 to 0.90. When IV is set to from 0.68 to 0.90, fracture during film stretching is small, and thus the film may be manufactured with high productivity. A concentration (AV) of a terminal carboxyl group of the polyester that forms the film is preferably 25 eq/ton or less. When the AV is set to 25 eq/ton or less, the hydrolysis resistance of the film may be improved, and thus an outdoor usable period may increase. The higher the IV, the further the fracture strength of the film increases. However, when the IV increases, a melting viscosity of polyester increases, and thus shear heat generation tends to occur during a melt extrusion process for manufacturing the film. Polyester may be decomposed due to the heat generation, and thus the AV may increase due to the decomposition. From such a viewpoint, more preferably, the AV is 22 eq/ton or less and the IV is from 0.70 to 0.90, and still more preferably, the AV is 20 eq/ton or less and the IV is from 0.72 to 0.85. In an embodiment, it is also preferable that another component capable of reacting with the carboxylic acid group be added during polymerization of the polyester and/or the polyester film manufacturing process so as to reduce the AV.

- Total of P Component and Metal Component in Film -

A polyester that forms the polyester film is preferably synthesized using, as a polymerization catalyst, at least one selected from the group consisting of a titanium compound (Ti compound), an aluminum compound (Al compound), and a germanium compound (Ge compound) which are soluble in glycol. Herein, a total of a content (value in terms of a phosphorous element) of P component and a content (value in terms of a metal element) of a metal component in the film is preferably from 10 ppm to 300 ppm. Here, the P component and the metal component include a phosphorous compound (P compound) for improving resistance to heat discoloration and known compounds used for promotion of an esterification reaction, application of film formation properties of polyester, color adjustment and the like such as Mg compounds, Mn compounds, Zn compounds, and Co compounds, in addition to the polymerization catalyst. According to this, precipitation of insoluble particles during polymerization of polyester and melt extrusion may be effectively suppressed. The total of the content (value in terms of a phosphorous element) of the P component and the content (value in terms of a metal element) of the metal component in the film is preferably from 20 ppm to 250 ppm, and more preferably from 50 ppm to 200 ppm. The less the content of the metal component in polyester, the less the insoluble particles are generated, and thus voids in the film decrease. As a result, the fracture strength of the film is stabilized. On the other hand, when the total of the content (value in terms of a phosphorous element) of the P component and the content (value in terms of a metal element) of the metal component in the film is less than 10 ppm, a polymerization speed of polyester decreases, and thus productivity may deteriorate. In addition, coloring stability during melting tends to decrease.

- Use -

The use of the biaxially stretched polyester film is not particularly limited. Since the biaxially stretched polyester film is a thick polyester film which is capable of maintaining film strength and electrical insulating properties over a long period of time and which has high transparency, the film may be appropriately used for an outdoor display, an electrical insulating film, various packages, a protective film, and the like, in addition to a back sheet for a solar cell.

<Solar Cell Module>

As a configuration example for a solar cell module use which is an embodiment of the present invention, a configuration in which a power generation element (solar cell element) that is connected to a lead interconnection that takes out electricity is sealed with a sealing agent such as ethylene-vinyl acetate copolymer-based (EVA-based) resin, and the resultant sealed element is bonded to a transparent substrate such as glass and the polyester film (back sheet) such that the sealed element is interposed therebetween may be exemplified. Various kinds of known solar cell elements may be applied as the solar cell element, examples of which including silicon-based elements such as a single crystal silicon-based element, a polycrystalline silicon-based element, and amorphous silicon-based element, group III-Vi or group II-Vi compound semiconductor-based elements such as a copper-indium-gallium-selenium semiconductor-based element, a copper-indium-selenium semiconductor-based element, a cadmium-tellurium semiconductor-based element, a gallium-arsenide semiconductor-based element, and the like.

<Method of Manufacturing Polyester Film>

Examples of the method of manufacturing the polyester film which is an embodiment of the present invention include a method which includes at least: preparing a raw material polyester resin which is synthesized using, as a polymerization catalyst, at least one compound selected from the group consisting of a Ti compound, an Al compound, and a Ge compound, all of which are soluble in glycol, and in which a total of a content of a P component (value in terms of a phosphorous element) and a content of a metal component (value in terms of a metal element) is 300 ppm or less; melt-extruding the raw material polyester resin and cooling the melt-extruded polyester resin to form an unstretched polyester film having a thickness of from 2.5 mm to 7.0 mm; and longitudinally stretching and laterally stretching the unstretched polyester film to form a biaxially stretched polyester film having a thickness of from 200 μm to 800 μm.

In a case of manufacturing the polyester film, for example, an internal haze of from 0.3% to 20% may be realized by suppressing crystallization in the vicinity of a center in a thickness direction to be low by combining the following conditions (1) to (3) for formation.

(1) High Stretching Magnification

The biaxial stretching is carried out at a low temperature and at a high stretching magnification to obtain a polyester film having sufficient fracture strength, whereby polyester molecules that form polyester are allowed to sufficiently orient in a stretching direction.

In the same polyester material, the higher a degree of orientation of molecules, the higher hydrolysis resistance of the film. Therefore, the biaxial stretching is carried out at a high stretching magnification so as to increase hydrolysis resistance.

In an embodiment, in a case in which the thickness of an unstretched sheet is 3 mm or greater, it is preferable that two or more vertical pairs of near infrared heaters, between the heaters in each pair of which the sheet being interposed, are provided in a flow direction in a stretching zone in the longitudinal stretching, so as to carry out heating sufficiently up to the inside of the sheet so that generation of voids due to the stretching is suppressed. In addition, it is preferable to divide a stretching zone into two parts by providing a free roll having no driving force in the stretching zone (between two stretching rolls different in a peripheral speed) so that shrinkage (a neck in phenomenon) of the sheet in a width direction due to the stretching is reduced.

(2) Not Having Insoluble Component

It is considered that voids in a polyester film are generated due to interface separation between an insoluble component and polyester in an unstretched polyester sheet. Therefore, in an embodiment of the invention, the insoluble component in polyester is preferably as less as possible. Examples of the insoluble component include insoluble deteriorated materials (gel or scorching) which are generated due to thermal deterioration, hydrolysis, and the like during melt extrusion of polyester, and non-molten materials, in addition to precipitates such as a catalyst and an additive which are added during a polyester polymerization process, foreign substances in a raw material, and foreign substances and dust which are mixed-in in each of a polyester polymerization process, a resin drying process, an extrusion process, and a stretching process.

The precipitates of the catalyst, the additive, and the like which are added during the polyester polymerization process may be reduced by using, as a polymerization catalyst at least one selected from the group consisting of the Ti compound, the Al compound, and the Ge compound, all of which are soluble in glycol, and by setting a total of a content (value in terms of a phosphorous element) of a P component and a content (value in terms of a metal element) of a metal component in the film to 300 ppm or less. The P component and the metal component include a phosphorous compound (P compound) for improving resistance to heat discoloration, known compounds used for promotion of an esterification reaction, imparting of film formation properties of polyester, color adjustment, and the like, for example, Mg compounds, Mn compounds, Zn compounds, and Co compounds, as well as the polymerization catalyst. The total of the content (value in terms of a phosphorous element) of the P component and the content (value in terms of a metal element) of the metal component in the film is preferably from 20 ppm to 250 ppm, and more preferably from 50 ppm to 200 ppm.

To reduce foreign substances in a raw material and an amount of foreign substances and dust which are mixed-in in each of a polyester polymerization process, a resin drying process, an extrusion process, and a stretching process, the following measures and the like may be taken. That is, a raw material in which the foreign substances are sufficiently less is used. In addition, a filter that removes foreign substances and dust is provided to each unit that carries out at least one of a melt polymerization process, a solid-phase polymerization process, or an extrusion process so as to remove the foreign substances and dust. In addition, a medium from which foreign substances are removed by a filter in advance or during the processes is used as a medium (water that cools polymerized polyester when being cut in a

chip shape, air that is supplied for air conveying of chips, or the like) that comes into contact with a resin during processes.

The smaller an aperture of the filter, the higher an effect of removing the foreign substances, but productivity tends to decrease due to filter clogging. In an embodiment, it is preferable that a filter used in polyester melt polymerization and/or extrusion have filtration accuracy of from 3 μm to 20 μm, and it is preferable that a filter used to remove foreign substances from a medium (water, air, a nitrogen gas during a solid-phase polymerization process, or the like) that comes into contact with the resin have filtration accuracy of from 0.5 μm to 10 μm.

In a raw material polyester resin, it is preferable that the content of a component having a melting point of 300°C or higher be 1000 ppm or less. A method of obtaining the raw material polyester resin may include a process of obtaining chip-shaped polyester having an intrinsic viscosity of from 0.4 to 0.65 by melt polymerization, and a process of raising the intrinsic viscosity to from 0.69 to 0.90 by solid-phase polymerization.

The component having a melting point of 300°C or higher may be generated by allowing polyester having a specific surface area larger than that of chips to have a molecular weight higher than that of the chips by the solid-phase polymerization. Examples of the polyester include chip powders adhered to polyester chips which are supplied for the solid-phase polymerization and has an intrinsic viscosity of integer from 0.5 to 0.65, and string-shaped materials generated due to contact with a pipe wall surface in an air-blowing pipe, and the like. Accordingly, when the component having a melting point of 300°C or higher is set to 1000 ppm or less, a concentration of the chip powders in the polyester chips that are supplied for the solid-phase polymerization is preferably set to 500 ppm or less. In addition, the polyester chip after the solid-phase polymerization is preferably subjected to dust removal by a dust separator in a step of an air blowing path before the melt extrusion. As a method of setting the chip powders in the polyester chips that are supplied for the solid-phase polymerization to 500 ppm or less, the following method may be exemplified. In the method, chipping of molten polyester is carried out using a cutter in water, and the chip powders are removed by a filter during circulation while supplying pure water in order for a concentration of the chip powders in cooling water that is used to be 100 ppm or less.

(3) Regulate Crystallization of Unstretched Sheet in Specific Range

To set the haze of the film to from 0.3% to 20%, it is preferable to slightly generate a crystal while allowing an unstretched sheet to be stretchable. In addition, it is preferable to use a catalyst soluble in glycol and to set the contained metal component in a specific range, and it is preferable to adjust IV in a specific range and to set crystallinity of the unstretched film in a specific range.

To set the crystallinity of the unstretched film in a specific range, for example, a method in which plasticization is regulated during melt extrusion of polyester is preferably used, and the plasticization is preferably carried out at a temperature equal to or lower than a temperature higher than a melting point of polyester by 35°C.

Specifically, in a case of using polyethylene terephthalate having a melting point of 260°C, it is preferable to set the maximum resin temperature during melt extrusion at 295°C or lower. In this case, when plasticization is carried out at a temperature higher than 295°C, crystallization of the polyester becomes late during molding into an unstretched sheet, and thus it is difficult to set the haze in the range.

With regard to crystallization characteristics of polyester, it is preferable that a crystallization temperature be set to from 120°C to 140°C.

To suppress voids in a film which are caused by stretching, it is preferable to regulate the crystallinity of an unstretched sheet to a range of from 0.1% to 5%, and more preferably from 0.5% to 3%.

In a case in which the crystallinity of the unstretched sheet is less than 0.1%, fracture strength of a stretched film may decrease. When the crystallinity of the unstretched sheet exceeds 5%, a film tends to be fractured during stretching, and thus productivity may decrease. As a result, voids may occur in a film that is obtained, and thus fracture strength may decrease. To manufacture a film at a high stretching magnification, the unstretched sheet may have a thickness of 2.5 mm or greater. A method of manufacturing a uniform unstretched sheet having a thickness of 2.5 mm or greater is preferable. Further, both surfaces of the sheet is cooled at a cooling rate range of from 350°C/minute to 590°C/minute. An unstretched sheet having crystallinity in a specific range may be obtained according to this method. When the unstretched sheet is biaxially stretched, a polyester film having a specific haze and satisfactory surface flatness may be obtained.

[1] Process of Preparing Raw Material Polyester Resin

A polyester resin having an intrinsic viscosity IV of from 0.68 to 0.95 is preferable as a raw material resin.

The IV of the raw material resin may be adjusted by a polymerization method and polymerization conditions. When solid-phase polymerization is carried out after liquid-phase polymerization, a raw material polyester resin having the intrinsic viscosity IV of from 0.68 to 0.95 may be obtained. When the IV is 0.68 or greater, a biaxially stretched film which is less likely to be fractured during stretching and which has satisfactory strength may be obtained. When the IV

is 0.95 or less, polyester, in which deterioration due to shear heat generation during melt extrusion of polyester is less, and a concentration of a terminal carboxyl group is small, may be obtained. From this viewpoint, the IV is more preferably from 0.70 to 0.90, and still more preferably from 0.72 to 0.85.

The intrinsic viscosity IV is a value that is obtained by dividing a specific viscosity ($\eta_{sp} = \eta_r$-1), which is obtained by subtracting 1 from a ratio $\eta_r$ ($\eta/\eta_0$: relative viscosity) between a solution viscosity ($\eta$) and a solvent viscosity ($\eta_0$) at various concentrations, by each concentration, and by extrapolating this value to a state in which a concentration is zero. The IV is obtained from a viscosity of a solution that is obtained by dissolving polyester in a mixed solution of 1,1,2,2-tetrachloroethane/phenol (=2/3 [mass ratio]) at 25°C by using Ubbelohde viscometer.

A concentration (AV) of terminal carboxyl groups of the raw material resin is preferably 20 eq/ton or less, and more preferably 18 eq/ton or less. When a film is manufactured by melt-extruding a raw material resin with the AV of 20 eq/ton or less, an increase in the concentration of the terminal carboxyl groups is suppressed, and when the AV is set to 25 eq/ton or less, a polyester film having high hydrolysis resistance may be obtained. In this specification, the unit [eq/ton] that is attached to a concentration of a component in a composition represents a molar equivalent of the component per 1 ton of the composition.

The concentration AV of a terminal carboxyl group is a value that is measured by the following method. That is, 0.1 g of a raw material resin is dissolved in 10 ml of benzyl alcohol, and chloroform is added to the benzyl alcohol to obtain a mixed solution. A phenol red indicator is added dropwise to the mixed solution. The resultant solution is titrated with a reference solution (0.01 N KOH-benzyl alcohol mixed solution), and the concentration of the terminal carboxyl groups is obtained from a dropping amount.

- Raw Material Component -

The polyester resin that forms the raw material resin is preferably a polyester that contains polyethylene terephthalate or poly-1,4,cyclohexane dimethyl terephthalate as a main component. In an embodiment, the polyester resin is preferably a polyester having an ethylene terephthalate unit or CHDM unit as 80% by mole or greater of its constituent unit. The polyester resin may be obtained by subjecting a dicarboxylic acid or an ester derivative thereof and a diol compound to an esterification reaction and/or a transesterification reaction by a known method.

A main component of the dicarboxylic acid or the ester derivative thereof is terephthalic acid or an ester derivative thereof, and examples of other components include dicarboxylic acids and derivatives thereof such as aliphatic carboxylic acids such as malonic acid, succinic acid, glutaric acid, adipic acid, suberic acid, sebacic acid, dodecanedioic acid, dimer acid, eicosanedioic acid, pimelic acid, azelaic acid, methyl malonic acid, and ethyl malonic acid; alicyclic dicarboxylic acids such as adamantanedicarboxylic acid, norbornene dicarboxylic acid, isosorbide, cyclohexane dicarboxylic acid, and decalindicarboxylic acid; and aromatic dicarboxylic acids such as isophthalic acid, phthalic acid, 1,4-naphthalene dicarboxylic acid, 1,5-naphthalene dicarboxylic acid, 2,6-naphthalene dicarboxylic acid, 1,8-naphthalene dicarboxylic acid, 4,4'-diphenyl dicarboxylic acid, 4,4'-diphenyl ether dicarboxylic acid, 5-sodium sulfoisophthalic acid, phenylindane dicarboxylic acid, anthracene dicarboxylic acid, phenanthrene dicarboxylic acid, and 9,9'-bis(4-carboxyphenyl) fluorene acid.

A main component of the diol compound is ethylene glycol or cyclohexane dimethanol, and examples of other components include aliphatic diols such as 1,2-propanediol, 1,3-propanediol, 1,4-butanediol, 1,2-butanediol, and 1,3-butanediol; cyclic diols such as cyclohexane dimethanol, spiroglycol, and isosorbide; and aromatic diols such as bisphenol A, 1,3-benzene-dimethanol, 1,4-benzene-dimethanol, and 9,9'-bis(4-hydroxyphenyl) fluorine.

When synthesizing a CHDM-based polyester resin, at least 1,4-cyclohexane dimethanol (CHMD) is used as the diol compound, while a diol compound other than CHDM may be further used. At this time, as the diol compound other than the CHDM, the above-described diol compounds may be exemplified, and ethylene glycol is preferable.

As the dicarboxylic acid that is used in a case of synthesizing a CHDM-based polyester resin, the above-described dicarboxylic acids and derivatives thereof are used, and terephthalic acid is preferable. As the dicarboxylic acid, isophthalic acid (IPA) may be used in addition to terephthalic acid. An amount of IPA is preferably from 0% by mole to 15% by mole, more preferably 0% by mole to 12% by mole, and still more preferably 0% by mole to 9% by mole, with respect to a total amount of a dicarboxylic acid that is used for synthesis of the polyester resin.

A reaction catalyst or a stabilizing agent which is known in the related art may be used for the esterification reaction and/or the transesterification reaction. Examples of the reaction catalyst include an alkali metal compound, an alkaline-earth metal compound, a zinc compound, a lead compound, a manganese compound, a cobalt compound, an aluminum compound, an antimony compound, and a titanium compound, and examples of the stabilizing agent include a phosphorus compound, and a sulfur compound. In an embodiment, it is preferable to add at least one kind of compound selected from a titanium compound, an aluminum compound, and germanium compound, all of which are soluble in glycol, as a polymerization catalyst in an step before a method of manufacturing polyester is completed.

When the glycol soluble compound is used as the polymerization catalyst, precipitation of a catalyst residue (that is, insoluble particles) in polyester that is obtained may be suppressed.

For example, it is preferable to carry out polymerization by using a titanium (Ti)-based compound in a range of from 1 ppm to 30 ppm, more preferably from 2 ppm to 20 ppm, and still more preferably from 3 ppm to 15 ppm, as a value in terms of a Ti element with respect to the total mass of constituent component of polyester. In this case, from 1 ppm to 30 ppm of titanium is contained in the polyester film that is manufactured by the method that is an embodiment of the present invention.

When the amount of the Ti-based catalyst is 1 ppm or greater, satisfactory IV may be obtained, and when the amount of the Ti-based catalyst is 30 ppm or less, the concentration of the terminal carboxyl groups may be suppressed to be low, and thus this range is advantageous for improvement in hydrolysis resistance.

In an embodiment, as the raw material resin, polyester, which is obtained by subjecting multifunctional monomer (hereinafter, may be referred to as a "tri- or higher multifunctional monomer" or "multifunctional monomer") in which the total of carboxylic acid groups and hydroxyl groups is 3 or greater to a polycondensation reaction, may be used in addition to the dicarboxylic acid and diol.

Here, examples of the multifunctional monomer in which a total (a+b) of a number (a) of a carboxylic acid group and a number (b) of hydroxyl group is 3 or greater include carboxylic acids in which the number (a) of the carboxylic acid group is 3 or greater, and ester derivatives or acid anhydrides thereof; multifunctional monomers in which the number (b) of hydroxyl groups is 3 or greater; and oxyacids which contains both of hydroxyl group and a carboxylic acid group in one molecule, and in which the total (a+b) of the number (a) of the carboxylic acid group and the number (b) of hydroxyl group is 3 or greater.

Example of the carboxylic acids in which the number (a) of the carboxylic acid groups is 3 or greater include, but are not limited to, trifunctional aromatic carboxylic acids such as trimesic acid, trimellitic acid, pyromellitic acid, naphthalene tricarboxylic acid, and anthracene tricarboxylic acid; trifunctional aliphatic carboxylic acids such as methane tricarboxylic acid, ethane tricarboxylic acid, propane tricarboxylic acid, and butane tricarboxylic acid; tetrafunctional aromatic carboxylic acids such as benzene tetracarboxylic acid, benzophenone tetracarboxylic acid, naphthalene tetracarboxylic acid, anthracene tetracarboxylic acid, and perylene tetracarboxylic acid; tetrafunctional aliphatic carboxylic acids such as ethane tetracarboxylic acid, ethylene tetracarboxylic acid, butane tetracarboxylic acid, cyclopentane tetracarboxylic acid, cyclohexane tetracarboxylic acid, and adamantane tetracarboxylic acid; penta- or higher functional aromatic carboxylic acids such as pentabenzene carboxylic acid, benzene hexacarboxylic acid, naphthalene pentacarboxylic acid, naphthalene hexacarboxylic acid, naphthalene heptacarboxylic acid, naphthalene octacarboxylic acid, anthracene pentacarboxylic acid, anthracene hexacarboxylic acid, anthracene heptacarboxylic acid, and anthracene octacarboxylic acid; penta- or higher functional aliphatic carboxylic acids such as ethane pentacarboxylic acid, ethane heptacarboxylic acid, butane pentacarboxylic acid, butane heptacarboxylic acid, cyclopentane pentacarboxylic acid, cyclohexane pentacarboxylic acid, cyclohexane hexacarboxylic acid, adamantane pentacarboxylic acid, and adamantane hexacarboxylic acid; and ester derivatives or acid anhydrides thereof.

In addition, compounds in which oxyacid such as l-lactide, d-lactide, and hydroxyl benzoic acid, a derivative thereof, plural oxyacids connected to each other, or the like is added to a carboxy terminal of the carboxylic acid may be appropriately used. In addition, these compounds may be used alone or in combination of two or more kinds as necessary.

In addition, examples of the tri- or higher multifunctional monomer in which the number (b) of hydroxyl group is 3 or greater include trifunctional aromatic compounds such as trihydroxybenzene, trihydroxynaphthalene, trihydroxyanthracene, trihydroxychalcone, trihydroxyflavone, and trihydroxycoumarin; trifunctional aliphatic alcohol such as glycerin, trimethylolpropane, and propanetriol; and tetrafunctional aliphatic alcohol such as pentaerypthritol. In addition, compounds in which diols are added to hydroxyl group at a terminal endof the above-described compounds are preferably used. These compounds may be used alone or in combination of plural kinds according to necessity.

In addition, as other multifunctional monomers other than the multifunctional groups, oxyacids which contain both hydroxyl groups and carboxylic acid groups in one molecule and in which the total (a+b) of the number (a) of the carboxylic acid group and the number (b) of hydroxyl group is 3 or greater may be exemplified. Examples of the oxyacids include hydroxy isophthalic acid, hydroxy terephthalic acid, dihydroxy terephthalic acid, trihydroxy terephthalic acid.

In addition, compounds in which oxyacid such as l-lactide, d-lactide, and hydroxyl benzoic acid, a derivative thereof, plural oxyacids connected to each other, is added to a carboxy terminal end of the multifunctional monomers may be appropriately used. In addition, these compounds may be used alone or in combination of plural kinds according to necessity.

A content of the multifunctional monomer is preferably from 0.005% by mole to 2.5% by mole, more preferably from 0.020% by mole to 1% by mole, still more preferably from 0.025% by mole to 1% by mole, still more preferably from 0.035% by mole to 0.5% by mole, still more preferably from 0.05% by mole to 0.5% by mole, and still more preferably from 0.1% by mole to 0.25% by mole, with respect to the total constituent units in the polyester.

In addition, the raw material resin may be prepared by mixing crushed pieces of a resin film. As the resin film, a polyester film is very appropriate, and a polyester film that is the same kind as a polyester resin in the raw material resin is preferable. For example, the crushed pieces of the resin film are crushed materials obtained by crushing an

unnecessary film into small pieces (so-called chips) or scrap pieces.

- Terminal Blocking Agent -

In an embodiment, the polyester film may contain at least one of a terminal blocking agent or a component having a structure derived from the terminal blocking agent.

When the polyester film has a structure having a molecule (tie chain) that bridges polyester crystals, the polyester film becomes strong, and thus weather resistance becomes excellent. When the polyester film contains at least one of the terminal blocking agent or the component having a structure derived from the terminal blocking agent, development of the tie chain is not excessive, and heat resistance may be increased while suppressing embrittlement.

In an embodiment, the polyester film may be manufactured in such a manner that at least one of the terminal blocking agent or the component having a structure derived from the terminal blocking agent is contained in the polyester film. The terminal blocking agent may be mixed with a raw material polyester resin in any point of time as long as the point of time is a point of time before a molten raw material polyester resin is cooled (that is, a point of time before manufacturing of an unstretched polyester film is completed). In an embodiment, the terminal blocking agent may be mixed with the raw material polyester resin before supplying the raw material polyester resin to a raw material supply port of a twin-screw extruder. In addition, the terminal blocking agent may be mixed with the raw material polyester resin when the raw material polyester resin is melt-extruded by the twin-screw extruder. In addition, the terminal blocking agent may be mixed with a molten resin that is discharged after discharging the molten resin from the twin-screw extruder.

In a preferable embodiment, the raw material polyester resin and the terminal blocking agent are melted and mixed in such a manner that the terminal blocking agent becomes from 10% by mass to 60% by mass with respect to the total amount of the raw material polyester resin to prepare master pellets, and the master pellets are put into the twin-screw extruder, whereby at least one of the terminal blocking agent or the component having a structure derived from the terminal blocking agent may be contained in the polyester film.

The terminal blocking agent is an additive that reacts with carboxyl groups at the terminal of polyester and decreases a concentration of the terminal carboxyl groups of polyester.

Preferred examples of the terminal blocking agent include an oxazoline compound, a carbodiimide compound, and an epoxy compound. These compounds may be used alone or in combination. Particularly, in a case in which a polyester film having a crystallinity distribution of from 5% to 50% is manufactured by adding the terminal blocking agent, the concentration of the terminal carboxyl groups decreases, and hydrolysis resistant performance is improved. In addition, when the terminal blocking agent is contained in the polyester film having the crystallinity distribution range, adhesiveness with an applied layer is promoted due to a synergistic effect. That is, an application liquid penetrates into a portion of the polyester film which has low crystallinity and improves interpenetration adhesiveness, but at this time, the terminal of the polyester film reacts with the blocking agent and a volume increases, and thus the terminal is not likely to be pulled out from components of the application liquid (anchor effect). As a result, it is considered that interactivity increases, and thus the adhesiveness increases.

It is preferable that the terminal blocking agent is added in a content from 0.1% by mass to 5% by mass, more preferably from 0.3% by mass to 4% by mass, and still more preferably from 0.5% by mass to 2% by mass, with respect to the polyester resin. When the addition amount of the terminal blocking agent with respect to the polyester resin is 0.1% by mass or greater, the anchor effect tends to be exhibited, and thus adhesiveness may be further improved. On the other hand, when the addition amount is 5% by mass or less, a difficulty in arrangement of polyester molecules due to the enlarged terminal is suppressed, and thus crystals tend to be formed. As a result, a high-crystal region increases and distribution of crystallinity tends to be formed, and thus adhesiveness is improved.

As the carbodiimide compound having the carbodiimide group, a monofunctional carbodiimide and a multifunctional carbodiimide are present. Examples of the monofunctional carbodiimide include dicyclohexyl carbodiimide, diisopropyl carbodiimide, dimethyl carbodiimide, diisobutyl carbodiimide, dioctyl carbodiimide, t-butyl isopropyl carbodiimide, diphenyl carbodiimide, di-t-butyl carbodiimide, di-β-naphthyl carbodiimide, and the like. The dicyclohexyl carbodiimide or diisopropyl carbodiimide are particularly preferable.

A polycarbodiimide having a polymerization degree of 3 to 15 is preferably used as the multifunctional carbodiimide. Generally, the polycarbodiimide has a repeating unit expressed by "-R-N=C=N-" or the like, in which R represents a divalent connection group such as alkylene and arylene. Examples of the repeating unit include 1,5-naphthalene carbodiimide, 4,4'-diphenylmethane carbodiimide, 4,4'-diphenyl dimethyl methane carbodiimide, 1,3-phenylene carbodiimide, 2,4-tolylene carbodiimide, 2,6-tolylene carbodiimide, a mixture of 2,4-tolylene carbodiimide and 2,6-tolylenecarbodiimide, hexamethylene carbodiimide, cyclohexane-1,4-carbodiimide, xylylene carbodiimide, isophorone carbodiimide, dicyclohexyl methane-4,4'-carbodiimide, methyl cyclohexane carbodiimide, tetramethyl xylylene carbodiimide, 2,6-diisopropyl phenyl carbodiimide, and 1,3,5-triisopropyl benzene-2,4-carbodiimide.

The carbodiimide compound generates an isocyanate-based gas due to pyrolysis, and thus it is preferable that the terminal blocking agent be composed of a carbodiimide compound having high heat resistance. The higher the

molecular weight (polymerization degree), the more preferable in view of increasing the heat resistance. In addition, it is preferable that the terminal of the carbodiimide compound have a structure having high heat resistance. When the carbodiimide compound is once pyrolyzed, further pyrolysis tends to occur. When a temperature during melt extrusion of the raw material polyester resin is set to a as low as possible temperature, an effect of improving weather resistance and an effect of reducing thermal contraction due to the carbodiimide compound may be further effectively obtained.

With regard to the polyester film to which the carbodiimide compound is added, when being retained at a temperature of 300°C for 30 minutes, it is preferable that a generation amount of an isocyanate-based gas be from 0% by mass to 0.02% by mass. The isocyanate-based gas is a gas having an isocyanate group, and examples of the isocynate-based gas include diisopropyl phenyl isocyanate, 1,3,5-triisopropyl phenyl diisocyanate, 2-amino-1,3,5-triisopropylphenyl-6-isocyanate, 4,4'-dicyclohexyl methane diisocyanate, isophorone diisocyanate, cyclohexyl isocyanate, and the like. When the isocyanate-based gas is 0.02% by mass or less, bubbles (voids) are not likely to occur in the polyester film, and a stress concentration portion is not likely to be formed, and thus fracture or separation which tends to occur in the polyester film may be prevented. According to this, adhesion between adjacent materials may be satisfactory.

Preferred examples of the epoxy compound include a glycidyl ester compound and a glycidyl ether compound.

Specific examples of the glycidyl ester compound include benzoic acid glycidyl ester, t-Bu-benzoic acid glycidyl ester, P-toluic acid glycidyl ester, cyclohexane carboxylic acid glycidyl ester, pelargonic acid glycidyl ester, stearic acid glycidyl ester, lauric acid glycidyl ester, palmitic acid glycidyl ester, behenic acid glycidyl ester, Versatic acid glycidyl ester, oleic acid glycidyl ester, linoleic acid glycidyl ester, linolenic acid glycidyl ester, Behenolic acid glycidyl ester, Stearolic acid glycidyl ester, terephthalic acid diglycidyl ester, isophthalic acid diglycidyl ester, phthalic acid diglycidyl ester, naphthalene dicarboxylic acid diglycidyl ester, methyl terephthalic acid diglycidyl ester, hexahydrophthalic acid diglycidyl ester, tetrahydrophthalic acid diglycidyl ester, cyclohexane dicarboxylic acid diglycidyl ester, adipic acid diglycidyl ester, succinic acid diglycidyl ester, sebacic acid diglycidyl esters, dodecanedioic acid diglycidyl ester, octadecane dicarboxylic acid diglycidyl ester, trimellitic acid triglycidyl ester, and pyromellitic acid tetraglycidyl ester. These may be used alone or in combination of two or more kinds.

As the oxazoline compound, a oxazoline compound that is appropriately selected among compounds having an oxazoline group may be used, and among the compounds, bisoxazoline compound is preferable. Specific examples of the oxazoline compound include 2,2'-bis(2-oxazoline), 2,2'-bis(4-methyl-2-oxazoline), 2,2'-bis(4,4-dimethyl-2-oxazoline), 2,2'-bis(4-ethyl-2-oxazoline), 2,2'-bis(4,4'-diethyl-2-oxazoline), 2,2'-bis(4-propyl-2-oxazoline), 2,2'-bis(4-butyl-2-oxazoline), 2,2'-bis(4-hexyl-2-oxazoline), 2,2'-bis(4-phenyl-2-oxazoline), 2,2'-bis(4-cyclohexyl-2-oxazoline), 2,2'-bis(4-benzyl-2-oxazoline), 2,2'-p-phenylenebis(2-oxazoline), 2,2'-m-phenylene bis(2-oxazoline), 2,2'-o-phenylenebis(2-oxazoline), 2,2'-p-phenylenebis(4-methyl-2-oxazoline), 2,2'-p-phenylenebis(4,4-dimethyl-2-oxazoline), 2,2'-m-phenylene bis(4-methyl-2-oxazoline), 2,2'-m-phenylenebis(4,4-dimethyl-2-oxazoline), 2,2'-ethylene-bis(2-oxazoline), 2,2'-tetramethylenebis(2-oxazoline), 2,2'-hexamethylenebis(2-oxazoline), 2,2'-octamethylenebis(2-oxazoline), 2,2'-decamethylenebis(2-oxazoline), 2,2'-ethylenebis(4-methyl-2-oxazoline), 2,2'-tetramethylenebis(4,4-dimethyl-2-oxazoline), 2,2'-9,9'-diphenoxyethanebis(2-oxazoline), 2,2'-cyclohexylenebis(2-oxazoline), and 2,2'-diphenylenebis(2-oxazoline). Among these, 2-2'-bis(2-oxazoline) is most preferably used from the viewpoint that reactivity with polyester is satisfactory, and an effect of improving weather resistance is high. The bisoxazoline compounds may be used alone or in combination of two or more kinds as long as the effect of the present invention is not deteriorated.

Among the terminal blocking agents, particularly, a carbodiimide that is the "cyclic structure compound" is preferable. That is, the compound that contains the cyclic structure in which primary nitrogen and secondary nitrogen of the carbodiimide group are bonded by a bonding group can block a terminal carboxyl group of polyester as a terminal blocking agent, and thus heat and humidity resistance of the polyester film may be particularly effectively improved.

- Other Additives -

The polyester film may further contain additives such as a light stabilizing agent and an antioxidizing agent.

When containing the light stabilizing agent, ultraviolet deterioration may be prevented. Examples of the light stabilizing agent include compounds that absorb light beams such as ultraviolet rays and convert the light beams into thermal energy, materials that trap radicals that are generated when a resin absorbs light and is decomposed, and suppress a decomposition chain reaction, and the like. Preferred examples of the light stabilizing agent include compounds that absorb light beams such as ultraviolet rays and convert the light beams into thermal energy. When the light stabilizing agent is contained, even when being continuously irradiated with ultraviolet rays for a long period of time, an effect of improving a partial discharge voltage may be maintained to be high for a long period of time, or a color tone variation, strength deterioration, and the like in the resin due to ultraviolet rays are prevented.

A content of the light stabilizing agent in the polyester film with respect to a total mass of the polyester film is preferably from 0.1% by mass to 10% by mass, more preferably from 0.3% by mass to 7% by mass, and still more preferably from 0.7% by mass to 4% by mass. According to this, a decrease in a molecular weight of polyester with the

passage of a long period of time due to photo-deterioration may be suppressed, and as a result, a decrease in adhesion which occurs due to cohesive failure may be suppressed.

The polyester film may contain a slipping agent (fine particle), an ultraviolet absorbing agent, a coloring agent, a nucleating agent (crystallization agent), flame retardant, and the like as additives in addition to the light stabilizing agent.

For example, as the ultraviolet absorbing agent, an organic ultraviolet absorbing agent, an inorganic ultraviolet absorbing agent, a combination of the agents may be appropriately used without particular limitation in a range not deteriorating other characteristics of polyester. On the other hand, it is preferable that the ultraviolet absorbing agent be excellent in heat and humidity resistance and be uniformly dispersed in a resin.

Examples of the ultraviolet absorbing agent include ultraviolet absorbing agents such as salicylic acid-based absorbing agent, a benzophenone-based absorbing agent, a benzotriazole-based absorbing agent, and a cyanoacrylate-based absorbing agent as the organic ultraviolet absorbing agent, and an ultraviolet stabilizing agent such as a hindered amine-based ultraviolet stabilizing agent. Specific examples of the ultraviolet absorbing agent include salicylic acid-based p-t-butylphenlyl salicylate and p-octylphenyl salicylate, benzophenone-based 2,4-dihydroxybenzophenone, 2-hydroxy-4-methoxybenzophenone, 2-hydroxy-4-methoxy-5-sulfobenzophenone, 2,2',4,4'-tetrahydroxy benzophenone, and bis(2-methoxy-4-hydroxy-5-benzoylphenyl)methane, benzotriazole-based 2-(2'-hydroxy-5'-methylphenyl)benzotriazole, 2-(2'-hydroxy-5'-methylphenyl)benzotriazole, 2,2'-methylenebis[4-(1,1,3,3-tetramethylbutyl)-6-(2H-benzotriazol-2-yl)phenol], cyanoacrylate-based ethyl-2-cyano-3,3'-diphenyl acrylate), triazine-based 2-(4,6-diphenyl-1,3,5-triazine-2-yl)-5-[(hexyl)oxy]-phenol, hindered amine-based bis(2,2,6,6-tetramethyl-4-piperidyl) sebacate, and a polycondensate of dimethyl succinate and 1-(2-hydroxyethyl)-4-hydroxy-2,2,6,6-tetramethylpiperidine. In addition to the ultraviolet absorbing agents, nickel bis(octylphenyl) sulfide, and 2,4-di-t-butylphenyl-3',5'-di-t-butyl-4'-hydroxybenzoate, and the like may be exemplified.

Among the ultraviolet absorbing agents, from the viewpoint of high resistance against repetitive ultraviolet absorption, the triazine-based ultraviolet absorbing agent is more preferable. The ultraviolet absorbing agent may be singly added to the film as it is, or may be introduced into the film in such a manner that a monomer having performance of the ultraviolet absorbing agent is copolymerized into an organic conductive material or a water-insoluble resin.

- Polymerization of Raw Material Polyester Resin -

The raw material polyester resin may be obtained, for example, according to the following method.

The raw material polyester resin may be manufactured by a method which includes: an esterification reaction or transesterification reaction process which includes polymerizing an aromatic dicarboxylic acid or a lower alkyl ester thereof and an aliphatic diol in the presence of a titanium compound-containing catalyst and which includes adding (1) an organic chelate titanium complex as an organic chelate titanium complex in which at least one kind of the titanium compound has an organic acid as a ligand, (2) a magnesium compound, and (3) pentavalent phosphoric acid ester having no aromatic ring as a substituent group in this order; and a process of polycondensating a product generated by the esterification reaction or transesterification reaction process to generate a polycondensate.

In the esterification reaction or transesterifcation reaction, the magnesium compound is added in the presence of the organic chelate titanium complex as the titanium compound, and subsequently a specific pentavalent phosphorous compound is added. According to this, reaction activity of the titanium catalyst may be retained to be appropriately high, and a decomposition reaction during polycondensation may be effectively suppressed while applying an electrostatic application property due to magnesium. As a result, a polyester resin, which is less colored and has high electrostatic application property, and in which yellowish discoloration when being exposed to a high temperature is improved, may be obtained.

Thereby, a polyester resin, which is less accompanied with coloring during polymerization and coloring during subsequent melt film formation, which has less yellowish color as compared to an antimony (Sb) catalyst-based polyester resin of conventional art, which has a color tone and transparency which compare favorably with a germanium (Ge) catalyst-based polyester resin having relatively high transparency, and which is excellent in heat resistance, may be provided. Further, a polyester resin which has high transparency and which is less yellowish color may be obtained without using a color tone adjusting material such as a cobalt compound and a pigment.

The polyester resin may be used for a purpose (for example, an optical film, an industrial varnish, and the like) in which transparency is highly required, and it is not necessary to use an expensive germanium-based catalyst, and thus the cost may be significantly reduced. Further, contamination of catalyst-derived foreign substances which tend to be generated in the Sb-based catalyst system can be avoided. Accordingly, occurrence of defects or inferior quality during a film formation process is reduced, and thus cost reduction due to improvement in a yield may be achieved.

- Esterification Reaction or Transesterification Reaction -

In the esterification reaction or the transesterification reaction, at least one of an aromatic dicarboxylic acid or

a lower alkyl ester thereof and a diol are allowed to react with each other under the presence of a titanium compound-containing catalyst. The esterification reaction uses, as a titanium compound that is a catalyst, an organic chelate titanium complex which has an organic acid as a ligand, and includes at least adding the organic chelate titanium complex, a magnesium compound, and a pentavalent phosphoric acid ester having no aromatic ring as its substituent group in this order.

Here, a time before a polycondensation reaction is initiated is defined as an esterification process, and for example, a pipe for transfer to a polycondensation vessel from esterification is included in the esterification process.

In a case in which the organic chelate titanium complex, the magnesium compound, and the pentavalent phosphoric acid ester are added in this order, it is not necessary to add the total intended amount in this order. However, an embodiment in which each of the organic chelate titanium complex, the magnesium compound, and the pentavalent phosphoric acid ester is added in this order with an amount of 70% by mass or greater with respect to an individual total amount is preferable, and an embodiment in which each of the organic chelate titanium complex, the magnesium compound, and the pentavalent phosphoric acid ester is added in this order with an amount of 80% by mass or greater with respect to an individual total amount is more preferable.

First, at least one of an aromatic dicarboxylic acid or a lower alkyl ester thereof and a diol are mixed with a catalyst containing an organic chelate titanium complex that is a titanium compound before adding the magnesium compound and the phosphorus compound. Since a titanium compound such as the organic chelate titanium complex exhibit high catalyst activity in the esterification reaction, and thus the esterification reaction may be carried out in a satisfactory manner. At this time, the titanium compound may be added to a mixture of the dicarboxylic acid component and the diol component, or the diol component (or dicarboxylic acid component) may be mixed-in after mixing the dicarboxylic acid component (or diol component) and the titanium compound. The dicarboxylic acid component, the diol component, and the titanium compound may be mixed simultaneously. A method of the mixing is not particularly limited, and may be carried out by a known method in the related art.

In the esterification reaction, a process of adding the organic chelate titanium complex that is a titanium compound, and the magnesium compound and the pentavalent phosphorous compound as additives in this order is provided. At this time, the esterification reaction is carried out under the presence of the organic chelate titanium complex, and then addition of the magnesium compound is initiated before adding the phosphorous compound.

(Titanium Compound)

At least one kind of organic chelated titanium complex in which an organic acid is a ligand is used as the titanium compound that is a catalyst component. Examples of the organic acid include citric acid, lactic acid, trimellitic acid, and malic acid. Among these, the organic chelate complex in which citric acid or citrate is a ligand is preferable.

When using a chelate titanium complex in which citric acid is a ligand, generation of foreign substances such as fine particles is less, and thermal stability of the compound itself is higher than that of other titanium compounds. Accordingly, decomposition of the catalyst during a polymerization reaction is less. Therefore, a decrease in reactivity and a decrease in a color tone due to a side reaction are small. As a result, a polyester resin having favorable polymerization activity and color tone may be obtained. Further, in a case in which citric acid chelate titanium complex is used, when the complex is added at an esterification reaction stage, a polyester resin obtained thereby may have better polymerization activity and a better color tone and has fewer terminal carboxy groups compared to a case of adding the complex after the esterification reaction. In this regard, the following is assumed. The titanium catalyst also has a catalytic effect for the esterification reaction, and in a case in which the titanium catalyst is added at the esterification stage, an oligomer acid value is lowered when the esterification reaction is terminated, and thus the subsequent polycondensation reaction is carried out in a relatively effective manner. In addition, since the complex having citric acid as its ligand has higher hydrolysis resistance than that of titanium alkoxide or the like, the complex is not hydrolyzed during the esterification reaction, and functions effectively as a catalyst of the esterification and polycondensation reactions while maintaining intrinsic activity.

In addition, it is generally known that as a concentration of a terminal carboxylic group in a polyester resin increases, the hydrolysis resistance of the polyester resin deteriorates. When the concentration of a terminal carboxylic group of the polyester resin is lowered according to the above-described addition method, it is expected that the hydrolysis resistance will be improved.

The citric acid chelate titanium complex is easily available as a commercially available product such as VERTEC® AC-420 manufactured by Johnson Matthey.

With regard to the esterification reaction, the following embodiment is preferable. In the embodiment, a polymerization reaction is allowed to occur using a Ti catalyst, and an addition amount of Ti is preferably set to a range from 1 ppm to 30 ppm as a value in terms of an element with respect to the total mass of constituent components of the polyester resin, more preferably from 3 ppm to 20 ppm, and still more preferably from 5 ppm to 15 ppm. When the addition amount of titanium is 1 ppm or greater, it is advantageous from the viewpoint that a polymerization rate increases,

and when the addition amount is 30 ppm or less, it is advantageous from the viewpoint that a satisfactory color tone is obtained.

Examples of the titanium compound generally include oxides, hydroxides, alkoxides, carboxylates, carbonates, oxalates, halides, in addition to the organic chelate titanium complex. In addition to the organic chelate titanium complex, an additional titanium compound may be used in combination within a range not deteriorating an effect of the present invention.

Examples of the additional titanium compound include titanium alkoxides such as tetra-n-propyl titanate, tetra-i-propyl titanate, tetra-n-butyl titanate, tetra-n-butyl titanate tetramer, tetra-t-butyl titanate, tetracyclohexyl titanate, tetraphenyl titanate, and tetrabenzyl titanate, titanium oxides that are obtained by hydrolysis of titanium alkoxides, titanium-silicon or zirconium composite oxides that are obtained by hydrolysis of a mixture of titanium alkoxide and silicon alkoxide or zirconium alkoxide, titanium acetate, titanium oxalate, titanium potassium oxalate, sodium titanium oxalate, potassium titanate, sodium titanate, a mixture of titanic acid and aluminum hydroxide, titanium chloride, a mixture of titanium chloride and aluminum chloride, and titanium acetylacetate.

Methods described in Japanese Examined Patent Application Publication (JP-B) No. 8-30119, Japanese Patent No. 2543624, Japanese Patent No. 3335683, Japanese Patent No. 3717380, Japanese Patent No. 3897756, Japanese Patent No. 3962226, Japanese Patent No. 3979866, Japanese Patent No. 3996871, Japanese Patent No. 4000867, Japanese Patent No. 4053837, Japanese Patent No. 4127119, Japanese Patent No. 4134710, Japanese Patent No. 4159154, Japanese Patent No. 4269704, Japanese Patent No. 4313538, and the like are applicable to synthesis of Ti-based polyester by using the titanium compounds.

(Phosphorous Compound)

As the pentavalent phosphorous compound, at least one kind of pentavalent phosphoric acid ester having no aromatic ring as a substituent group is used. For example, trimethyl phosphate, triethyl phosphate, tri-n-butyl phosphate, trioctyl phosphate, tris(triethylene glycol) phosphate, methyl acid phosphate, ethyl acid phosphate, isopropyl acid phosphate, butyl acid phosphate, monobutyl phosphate, dibutyl phosphate, dioctyl phosphate, triethylene glycol acid phosphate, and the like may be exemplified.

From research results by the present inventors, among the above-described pentavalent phosphoric acid esters, phosphoric acid ester [$(OR)_3$-P=O; R represents an alkyl group having 1 or 2 carbon atoms] that has a lower alkyl group having 2 or less carbon atoms as a substituent group is preferable, and specifically, trimethyl phosphate and triethyl phosphate are particularly preferable.

Particularly, in a case of using, as the above-described titanium compound as a catalyst, a chelate titanium complex in which citric acid or citrate is coordinated, pentavalent phosphoric acid ester is excellent in polymerization activity and a color tone compared to trivalent phosphoric acid ester. Further, in a case of an embodiment in which pentavalent phosphoric ester having 2 or less carbon atoms is added, a balance in the polymerization activity, the color tone, and heat resistance may be particularly improved.

An addition amount of the phosphorous compound is preferably an amount which sets a value in terms of P element with respect to the total mass of constituent components of the polyester resin to be in a range from 50 ppm to 90 ppm, more preferably an amount which sets the value to be in a range from 60 ppm to 80 ppm, and still more preferably an amount which sets the value to be in a range from 65 ppm to 75 ppm.

(Magnesium Compound)

When a magnesium compound is included, an electrostatic application property is improved. Coloring tends to occur when a magnesium compound is included. However, the present invention may suppress the coloring, and may provide excellent color tone and heat resistance.

Examples of the magnesium compound include magnesium salts such as magnesium oxide, magnesium hydroxide, magnesium alkoxide, magnesium acetate, and magnesium carbonate. Among these, magnesium acetate is most preferable from the viewpoint of solubility in ethylene glycol.

In order to provide a high electrostatic application property, an addition amount of a magnesium compound is preferably an amount which sets a value in terms of a Mg element with respect to the total mass of constituent components of the polyester resin to be 50 ppm or greater, and more preferably an amount which sets the value to be in a range from 50 ppm to 100 ppm. The addition amount of the magnesium compound is an amount which sets the value to be in a range from 60 ppm to 90 ppm is preferable, and an amount which sets the value to be in a range from 70 ppm to 80 ppm is more preferable.

In the esterification reaction process, a case in which the titanium compound, that is a catalyst component, and the magnesium compound and the phosphorous compound, that are additives, are mixed in such a manner that a value Z calculated by the following Expression (i) satisfies the following Inequality (ii), and the resultant mixture is subjected

to melt polymerization is particularly preferable. Here, the content of P is an amount of phosphorus that is derived from the entirety of phosphorus compounds including pentavalent phosphate ester having no aromatic ring, and the content of Ti is an amount of titanium that is derived from the entirety of Ti compounds including an organic chelate titanium complex. In this manner, When the magnesium compound and the phosphorus compound are used in combination for the catalyst system including the titanium compound and an addition timing and an addition proportion of these are controlled in this manner, a color tone which is less yellowish may be obtained while maintaining catalyst activity of the titanium compound at an appropriately high value. Accordingly, heat resistance, which is not likely to cause yellowish coloring even when being exposed to a high temperature during a polymerization reaction or the subsequent film formation (during melting), may be obtained.

$$\text{(i) } Z = 5\times(\text{content of P [ppm]/atomic weight of P}) - 2\times(\text{content of Mg [ppm]/atomic weight of Mg}) - 4\times(\text{content of Ti [ppm]/atomic weight of Ti})$$

$$\text{(ii) } 0 \leq Z \leq +5.0$$

Since the phosphorous compound reacts with the titanium and reacts with the magnesium compound, these expressions are indexes which quantitatively express a balance between the phosphorous compound, the titanium, and the magnesium compound.

Expression (i) represents an amount of phosphorus that is capable of reacting with titanium while excluding a portion of phosphorus that reacts with magnesium from the total amount of phosphorus that is reactable. In a case in which the value of Z is a positive value, it can be said that an amount of phosphorus, which blocks titanium, is in an excessive state. Conversely, in a case in which the value of Z is a negative value, it can be said that an amount of phosphorus which is necessary to block titanium is in a deficient state. With regard to the reaction, each one atom of Ti, Mg, and P does not have the same equivalence, and thus each of the number of particles (ppm/atomic weight) in Expression is multiplied by a valence.

In the present invention, a polyester resin, which is excellent in a color tone and coloring resistance with respect to heat while having reaction activity that is necessary for the reaction, may be obtained by using the titanium compound, the phosphorus compound, and the magnesium compound, in which special synthesis is unnecessary and which are inexpensive and easily available.

In Inequality (ii), from the viewpoint of increasing the color tone and the coloring resistance with respect to heat while maintaining polymerization reactivity, it is preferable to satisfy a relationship of $+1.5 \leq Z \leq +5.0$, and more preferably $+1.5 \leq Z \leq +4.0$, and still more preferably $+1.5 \leq Z \leq +3.0$

Examples of preferred embodiments of the present invention include an embodiment which includes: adding, to aromatic dicarboxylic acid and aliphatic diol, citric acid or a chelate titanium complex which has citrate as its ligand in an amount of 1 ppm to 30 ppm before an esterification reaction is terminated; adding a weak acid magnesium salt in the presence of the chelate titanium complex in an amount of from 60 ppm to 90 ppm (more preferably, from 70 ppm to 80 ppm) after the addition of the chelate titanium complex; and adding a pentavalent phosphate ester having no aromatic ring as a substituent group in an amount of from 60 ppm to 80 ppm (more preferably, 65 ppm to 75 ppm) after the addition of the weak acid magnesium salt.

The esterification reaction may be carried out under conditions in which ethylene glycol is refluxed while removing water or alcohol generated by the reaction to the outside of a system.

The esterification reaction may be carried out in a single stage or may be carried out dividedly in multiple stages.

In a case in which the esterification reaction is carried out in a single stage, a esterification reaction temperature is preferably from 230°C to 260°C, and more preferably from 240°C to 250°C.

In a case in which the esterification reaction is carried out dividedly in multiple stages, the esterification reaction temperature of a first reaction tank is preferably from 230°C to 260°C, and more preferably from 240°C to 250°C, and the pressure is preferably from 1.0 $kg/cm^2$ to 5.0 $kg/cm^2$, and more preferably from 2.0 $kg/cm^2$ to 3.0 $kg/cm^2$. The esterification reaction temperature of a second reaction tank is preferably from 230°C to 260°C, and more preferably from 245°C to 255°C, and the pressure is preferably from 0.5 $kg/cm^2$ to 5.0 $kg/cm^2$, and more preferably from 1.0 $kg/cm^2$ to 3.0 $kg/cm^2$. Further, in a case in which the esterification reaction is carried out dividedly in three or more stages, esterification reaction conditions of an intermediate stage is preferably set to conditions between conditions of the first reaction tank and conditions of the final reaction tank.

- Polycondensation -

An esterification reaction product that is generated by the esterification reaction is subjected to a polycondensation reaction to generate polycondensate.

The polycondensation reaction may be carried out in a single stage or may be carried out dividedly in multiple stages.

An esterification reaction product such as an oligomer that is generated by the esterification reaction is subsequently supplied for a polycondensation reaction. This polycondensation reaction may be appropriately performed by supplying the reaction product to multi-stage polycondensation reaction tanks.

In a case in which the polycondensation reaction is carried out in a single stage, the polycondensation temperature is preferably from 260°C to 300°C, and more preferably from 275°C to 285°C. In addition, the pressure is preferably from 10 torr to 0.1 torr (from $1.33\times10^{-3}$ MPa to $1.33\times10^{-5}$ MPa), and more preferably from 5 torr to 0.1 torr (from $6.67\times10^{-4}$ MPa to $6.67\times10^{-5}$ MPa).

In addition, for example, in a case in which the polycondensation reaction is carried out with a three-stage reaction tank, with regard to the polycondensation reaction conditions, the following embodiment is preferable. In a first reaction tank, the reaction temperature is from 255°C to 280°C, and more preferably from 265°C to 275°C, and the pressure is preferably from 100 torr to 10 torr (from $13.3\times10^{-3}$ MPa to $1.3\times10^{-3}$ MPa), and more preferably from 50 torr to 20 torr (from $6.67\times10^{-3}$ MPa to $2.67\times10^{-3}$ MPa). In a second reaction tank, the reaction temperature is from 265°C to 285°C, and more preferably from 270°C to 280°C, and the pressure is preferably from 20 torr to 1 torr (from $2.67\times10^{-3}$ MPa to $1.33\times10^{-4}$ MPa), and more preferably from 10 torr to 3 torr (from $1.33\times10^{-3}$ MPa to $4.0\times10^{-4}$ MPa). In a third reaction tank of a final reaction tank, the reaction temperature is 270°C to 290°C, and more preferably from 275°C to 285°C, and the pressure is preferably from 10 torr to 0.1 torr (from $1.33\times10^{-3}$ MPa to $1.33\times10^{-5}$ MPa), and more preferably from 5 torr to 0.1 torr (from $6.67\times10^{-4}$ MPa to $1.33\times10^{-5}$ MPa)

A polyester resin composition which contains a titanium atom (Ti), a magnesium atom (Mg), and a phosphorous atom (P) and in which a value Z calculated by Expression (i) satisfies Inequality (ii) may be generated by the esterification reaction and the polycondensation.

In the polyester resin composition, $0 \le Z \le +5.0$ is satisfied, and thus the balance between three elements of Ti, P, and Mg is appropriately adjusted. Accordingly, the color tone and heat resistance (a decrease in yellowish coloring at a high temperature) are excellent and high electrostatic application property may be maintained while maintaining polymerization reactivity. In addition, a polyester resin which has high transparency without using a color tone adjusting material such as a cobalt compound and a pigment and which has a less yellowish color may be obtained.

As described above, Expression (i) quantitively expresses the balance between the phosphorous compound, the magnesium compound, and the titanium compound, and represents an amount of phosphorus that is capable of reacting with titanium while excluding a portion of phosphorus that reacts with magnesium from the total amount of phosphorus that is reactable. The value Z is less than 0, that is, the amount of phosphorous that reacts with titanium is too small, the catalyst activity (polymerization reactivity) of titanium increases, but heat resistance decreases, and thus the polyester resin that is obtained has a yellowish color, and is colored after polymerization, for example, during film formation (melting), the color tone further decreases. In addition, the value Z exceeds +5.0. That is, the amount of phosphorous that reacts with titanium is too much, the heat resistance and color tone of polyester that is obtained are satisfactory, but the catalyst activity decreases too much, and thus productivity deteriorates. In addition, an effect of a decomposition reaction increases due to an increase in a retention time of the polyester resin in a system, and the color tone may decrease or terminal carboxylic acid may increase in some cases.

In an embodiment, from the above-described reasons, it is preferable that the Inequality (ii) preferably satisfies $+1.5 \le Z \le +5.0$, more preferably satisfies $+1.5 \le Z \le +4.0$, and still more preferably satisfies $+1.5 \le Z \le +3.0$.

Measurement of each element of Ti, Mg, and P may be carried out by quantifying each element in PET using high-resolution-type high-frequency inductively coupled plasma mass spectrometry (HR-ICP-MS, product name: AttoM, manufactured by SII Nano Technology Inc.), and by calculating a content [ppm] from the results that are obtained.

An amount (acid value (AV)) of terminal carboxyl groups (-COOH) with respect to the total mass of the polyester resin composition, that is, the concentration of the terminal carboxyl groups is preferably 25 eq/t (ton) or less. When the concentration of the terminal carboxyl group is 25 eq/ton or less, a hydrolysis reaction caused by $H^+$ of the terminal COOH group of a polyester molecule may be reduced, and thus the hydrolysis resistance of the polyester film is improved. The concentration of the terminal carboxyl group is preferably in a range of from 5 eq/t to 25 eq/t. The lower limit of the concentration of the terminal carboxyl group is preferably 5 eq/t, from the viewpoint that an amount of the carboxyl groups may not be too small.

The intrinsic viscosity (IV) of the polyester resin composition that is obtained by melt polymerization may be appropriately selected according to a purpose, but is preferably in a range of from 0.40 to 0.65, more preferably in a range of from 0.45 to 0.65, and still more preferably in a range of from 0.50 to 0.63. When the IV is 0.40 or greater, cohesive failure is not likely to occur at a close contact interface with an adherend, and thus satisfactory adhesion is

easily obtained. When the IV is 0.65 or less, polyester in which the concentration of the terminal carboxyl groups is less may be obtained in the melt polymerization.

- Solid-Phase Polymerization -

After the polycondensation is terminated, the polyester resin that is obtained is processed into a pellet and the solid-phase polymerization may be carried out using the pellet.

The solid-phase polymerization may be carried out by a continuous method (a method in which a resin is filled in a tower, the resin is allowed to be retained for a predetermined time while being heated, and then the resin is sequentially transmitted), or a batch method (a method in which a resin is filled in a container, and is heated for a predetermined time). Specifically, with regard to the solid-phase polymerization, methods described in Japanese Patent No. 2621563, Japanese Patent No. 3121876, Japanese Patent No. 3136774, Japanese Patent No. 3603585, Japanese Patent No. 3616522, Japanese Patent No. 3617340, Japanese Patent No. 3680523, Japanese Patent No. 3717392, and Japanese Patent No. 4167159 may be used.

A solid-phase polymerization temperature is preferably from 170°C to 240°C, more preferably from 180°C to 230°C, and still more preferably from 190°C to 220°C. When the temperature is in the above-described ranges, it is preferable for accomplishment of the hydrolysis resistance. In addition, a solid-phase polymerization time is preferably from 5 hours to 100 hours, more preferably from 10 hours to 75 hours, and still more preferably from 15 hours to 50 hours. When the time is in the above-described ranges, it is preferable for accomplishment of the hydrolysis resistance. In addition, the solid-phase polymerization is preferably carried out in vacuum or in a nitrogen atmosphere.

The IV of the polyester resin composition after the solid-phase polymerization is preferably in a range from 0.68 to 0.95, and more preferably in a range from 0.70 to 0.85.

The component having a melting point of 300°C or higher may be generated by allowing polyester having a specific surface area larger than that of chips to have a molecular weight higher than that of the chips by the solid-phase polymerization. Examples of the polyester include chip powders adhered to polyester chips which are supplied for the solid-phase polymerization and has an intrinsic viscosity of from 0.40 to 0.65, and string-shaped materials generated due to contact with a pipe wall surface in an air-blowing pipe, and the like. Accordingly, when the component having a melting point of 300°C or higher is set to 1000 ppm or less, a concentration of the chip powders in the polyester chips that are supplied for the solid-phase polymerization is preferably set to 500 ppm or less. In addition, the polyester chip after the solid-phase polymerization is preferably subjected to dust removal by a dust separator in a step of an air blowing path before the melt extrusion. As a method of setting the chip powders in the polyester chips that are supplied for the solid-phase polymerization to 500 ppm or less, the following method may be exemplified. In the method, chipping of molten polyester is carried out using a cutter in water, and the chip powders are removed by a filter during circulation while supplying pure water in order for a concentration of the chip powders in cooling water that is used to be 100 ppm or less.

[2] Formation of Unstretched Film

When forming an unstretched film, a polyester resin to be described later is melt-extruded onto a cooling drum in a sheet, and the resultant melt-extruded sheet is exposed to cooling air from a side opposite to the cooling drum, whereby the melted polyester sheet is cooled and solidified. The thickness of the sheet-shaped polyester is preferably from 2.5 mm to 7.0 mm.

-Extruder -

The melt extrusion may be carried out using an extruder. The extruder may be a single-screw extruder or a two-screw extruder. To allow a raw material polyester resin to be sufficiently melted and to carry out extrusion while suppressing deterioration such as hydrolysis, pyrolysis, and the like, for example, a twin-screw extruder provided with a barrel that has a supply port and an extruder outlet, two screws that have a diameter of 140 mm or greater and rotate in the barrel, and a temperature control unit that is disposed at the periphery of the barrel and controls a temperature of the barrel is preferably used.

The melt extrusion is preferably carried out as follows. The raw material polyester resin is supplied to the twin-screw extruder, a resin temperature in the extruder is controlled to have the maximum value in a range of 295°C or less at a position of from 40% to 80% of the total length of the extruder from the upstream end of the extruder, and the resin temperature at the extruder outlet is preferably controlled to from 275°C to 285°C.

Fig.1 schematically shows an example of a configuration of the two-screw extruder used when executing a method of manufacturing a polyester film which is an embodiment of the present invention. Fig. 2 shows an example of a flow for executing the method of manufacturing a polyester film.

The two-screw extruder 100 shown in Fig. 1 includes a cylinder 10 (barrel) that has a supply port 12 and an extruder outlet 14, two screws 20A and 20B that rotate in the cylinder 10, and a temperature control unit 30 that is disposed at the periphery of the cylinder 10 and controls a temperature inside the cylinder 10. A raw material supply device 46 is provided in front of the supply port 12. In addition, as shown in Fig. 2, a gear pump 44, a filter 42, and a die 40 are provided in front of the extruder exit 14.

- Cylinder-

The cylinder 10 has the supply port 12 that supplies a raw material resin, and the extruder outlet 14 from which a heated and melted resin is extruded.

It is necessary that an inner wall surface of the cylinder 10 is formed using a material which is excellent in heat resistance, abrasion resistance, and anti-corrosive properties, and which is capable of securing friction with a resin. -While nitride steel in which an inner surface is subjected a nitriding treatment is generally used, chromium-molybdenum steel, nickel-chromium-molybdenum steel, and stainless steel may be used after being subjected to a nitriding treatment. Particularly, in a use in which abrasion resistance and corrosion resistance are required, it is effective to use a bimetallic cylinder in which an anti-corrosive and abrasion resistant alloy such as nickel, cobalt, chromium, and tungsten is lined on an inner wall surface of the cylinder 10 by a centrifugal casting method or to form a thermally sprayed ceramic film.

The cylinder 10 has vents 16A and 16B for evacuation. When evacuation is carried out through the vents 16A and 16B, volatile components such as moisture in the resin inside the cylinder 10 may be effectively removed. When the vents 16A and 16B are appropriately disposed, a raw material (pellet, powder, flake, and the like) in a non-dried state, a crushed waste (fluff) of the film which occurs in the middle of film formation, and the like may be used as a raw material resin as is.

With regard to the vents 16A and 16B, when considering a relationship with degassing efficiency, it is necessary to appropriately set an opening area and the number of vents. It is preferable that the twin-screw extruder 100 be provided with the vents 16A and 16B at one or greater sites. In addition, when the number of the vents 16A and 16B is too large, there is a concern that a molten resin may overflow from the vents and thus retention-deteriorated foreign substances may increase. Accordingly, it is preferable to provide the vent at one site or two sites.

In addition, when a resin retained on a wall surface in the vicinity of the vent or precipitated volatile components are dropped to the inside of the extruder 100 (cylinder 10), the dropped resin or volatile components may come to the surface as foreign substances in a product, and thus it needs to take care. With regard to the retention, it is effective to adjust a shape of a vent lid, or it is effective to appropriately select an upper vent and a side vent. With regard to the precipitation of the volatile components, a method of preventing precipitation due to heating of a pipe and the like is generally used.

For example, in a case of extruding polyethylene terephthalate (PET), suppressing of hydrolysis, pyrolysis and oxidative decomposition has a great effect on a quality of a product (film).

For example, the resin supply port 12 is evacuated or nitrogen purging is carried out, the oxidative decomposition may be suppressed.

In addition, when the vents 16A and 16B are provided at plural sites, even in a case in which an amount of moisture in a raw material is approximately 2000 ppm, the same extrusion as a case of extruding a dried resin in which the amount of moisture is 50 ppm or less using a single screw may be carried out.

To suppress resin decomposition due to shear heat generation, it is preferable that a kneading segment and the like be provided as less as possible in a range in which extrusion and degassing are compatible with each other.

In addition, as the pressure of the screw outlet (extruder outlet) 14 increases, the shear heat generation increases, and thus it is preferable to lower the pressure of the extruder outlet 14 as low as possible in a range capable of securing the degassing efficiency due to the vents 16A and 16B and extrusion stability.

When evacuation is carried out through the vents 16A and 16B, the volatile components such as moisture in the resin inside the cylinder may be effectively removed. When the vent pressure is too low, there is a concern that the molten resin may overflow to the outside of the cylinder 10. In addition, when the vent pressure is too high, there is a concern that the removal of the volatile components may be insufficient, and thus hydrolysis of a film that is obtained tends to occur. From the viewpoints that overflow of the molten resin from the vents 16A and 16B is prevented and the volatile components are selectively removed, it is preferable to set the vent pressure to from 0.01 Torr to 5 Torr (1.333 Pa to 666.5 Pa), and more preferably from 0.01 Torr to 4 Torr (1.333 Pa to 533.2 Pa).

- Biaxial Screw -

The two screws 20A and 20B that are rotated by a drive unit 21 including a motor and gears are provided inside the cylinder 10. As a screw diameter D increases, mass production is possible, but melt unevenness tends to occur. The screw diameter D is preferably from 30 mm to 250 mm, and more preferably from 50 mm to 200 mm.

The twin-screw extruder is largely divided into an engagement type and non-engagement type of two screws 20A and 20B, and a kneading effect is larger in the engagement type compared to the non-engagement type. In the embodiment of the present invention, either the engagement type or the non-engagement type may be used, but from the viewpoints of sufficiently kneading the raw material resin and of suppressing the melt unevenness, the engagement type is preferably used.

A rotation direction of the two screws 20A and 20B is divided into the same direction and opposite direction. The screws 20A and 20B that rotate in directions opposite to each other has a kneading effect higher than that of the same direction rotation type, and the same direction rotation type has a self-cleaning effect and is effective for prevention of retention in the extruder.

A shaft direction of the screw is divided into a parallel direction and an oblique direction, and a conical type that is used in a case of applying strong shearing is present.

In the twin-screw extruder, screw segments having various shapes may be used. With regard to the shape of the screws 20A and 20B, for example, a full fly screw in which a set of equal-pitch spiral flights 22 are provided is used.

When a segment such as kneading disk or rotor that applies shearing is used at a heating and melting portion, the raw material resin may be melted in a relatively reliable manner. In addition, when a reverse screw or seal ring is used, a resin is blocked, and a melt seal may be formed when draining the vents 16A and 16B. For example, as shown in Fig. 1, kneading portions 24A and 24B that promote melting of the above-described raw material resin may be provided in the vicinity of the vents 16A and 16B.

A temperature adjusting zone (cooling portion) that cools the molten resin is effective in the vicinity of the outlet of the extruder 100. In a case in which heat transfer efficiency of the cylinder 10 is higher than shear heat generation, for example, when a short-pitch screw 28 is provided at the temperature adjusting zone (cooling portion), a resin moving speed on a wall surface of the cylinder 10 increases, and thus temperature adjusting efficiency may be raised.

- Temperature Control Unit -

The temperature control unit 30 is provided at the periphery of the cylinder 10. In the extruder 100 shown in Fig. 1, heating and cooling devices C1 to C9 that are divided into 9 pieces toward the extruder outlet 14 from the raw material supply port 12 in a longitudinal direction and constitute the temperature control unit 30. For example, division into respective regions (zones) of heating and melting portions C1 to C7 and cooling portion C8 and C9 is made by the heating and cooling devices C1 to C9 that are dividedly disposed around the cylinder 10, as described above, and the inside of the cylinder 10 may be controlled to a desired temperature for each region.

Usually, a band heater or sheathing wire aluminum cast heater is used for heating, but there is no limitation thereto. For example, a heating-medium circulation heating method may also be used. On the other hand, with regard to cooling, air cooling using a blower is typical, but a method of allowing water or oil to flow through a pipe (water path) that is wound around the cylinder 10 may also be used.

- Die -

The die 40, which ejects the molten resin extruded from the extruder outlet 14 in a film shape (strip shape), is provided at the extruder outlet 14 of the cylinder 10. In addition, the filter 42 that prevents a non-molten resin or foreign substance from being mixed-in to the film is provided between the extruder outlet 14 of the cylinder 10 and the die 40. Hereinafter, a time (time necessary for processes indicated by both arrows in Fig. 2) taken before the raw material resin heated and melted in the barrel is extruded in a film shape from the die after passing through the extruder outlet is referred to as a "retention time."

- Gear Pump -

It is important to decrease a variation in an extrusion amount as much as possible so as to improve thickness accuracy. The gear pump 44 may be provided between the extruder 100 and the die 40 to significantly decrease the variation in the extrusion amount. When a predetermined amount of resin is supplied from the gear pump 44, the thickness accuracy may be improved. Particularly, in the case of using a twin-screw extruder, pressure-raising capability of the extruder itself is low, and thus it is preferable to realize extrusion stability by the gear pump 44.

When the gear pump 44 is used, a pressure variation of the gear pump 44 on a secondary side may be set to be 1/5 or less than that on a primary side, and a resin pressure variation range may be set within a range of $\pm 1\%$. As other advantages, filtration by a filter is possible without raising a pressure of a screw tip portion, and thus prevention of an increase in a resin temperature, an improvement in transfer efficiency, and shortening of a retention time in the extruder may be expected. In addition, a variation in an amount of resin supplied from a screw with the passage of time due to an increase in a filtration pressure may be prevented. However, when the gear pump 44 is provided, the length

of a facility increases depending on a facility selecting method, and thus a retention time of a resin increases. Therefore, a molecular chain may be cut due to a shear stress of the gear pump portion, and thus it needs to take care.

In the gear pump 44, when a difference between the primary pressure (input pressure) and the secondary pressure (output pressure) becomes too great, a load of the gear pump 44 increases, and thus shear heat generation increases. Therefore, the difference pressure during operation is set to within 20 MPa, preferably 15 MPa, and more preferably 10 MPa. In addition, for a uniform film thickness, it is effective to control a screw rotation of the extruder or to use a pressure adjusting valve so as to make the primary pressure of the gear pump 44 constant.

It is preferable to mold the polyester film as follows. A polyester resin having an intrinsic viscosity IV of from 0.68 to 0.95 is supplied as a raw material from the supply port. The polyester resin is heated and melted in the barrel while controlling a temperature of an inner wall of the barrel on an extruder outlet side to a temperature lower than a melting point Tm(°C) of the polyester resin by the temperature control unit in order for the inner wall to function as a cooling portion, and then the molten polyester resin is extruded from the extruder outlet. Then, the molten polyester resin is melt-extruded in a film shape after an average retention time of 10 minutes to 20 minutes under conditions satisfying the following Inequality (1).

$$6.0\times10^{-6}\times D^3 \leq Q/N \leq 1.1\times10^{-5}\times D^3 \qquad \text{Inequality (1)}$$

(In Inequality (1), D represents a screw diameter (mm) of the twin-screw extruder, N represents the number of revolutions (rpm) of a screw, and Q represents an extrusion amount (kg/hr).)

According to the extrusion method, the polyester resin may be melt-extruded in a sheet shape while suppressing deterioration of the polyester resin having the IV of from 0.68 to to 0.95.

In addition, for example, in the case of extruding PET, it is preferable to carry out evacuation or nitrogen purging with respect to the resin supply port so as to further suppress hydrolysis, pyrolysis, and oxidative decomposition. In addition, it is preferable to provide the vent at plural sites, because hydrolysis of the raw material polyester resin due to moisture may be suppressed.

In addition, to suppress resin decomposition due to shear heat generation, it is preferable that a kneading segment and the like be provided as less as possible in a range in which extrusion and degassing are compatible with each other.

In addition, as the pressure of the screw outlet (extruder outlet) increases, the shear heat generation increases, and thus it is preferable to lower the pressure of the extruder outlet as low as possible in a range capable of securing the degassing efficiency due to the vent and extrusion stability.

From the viewpoint of increasing a cooling effect at the temperature adjusting zone (cooling portion) that is provided downstream the extruder to cool the molten resin, a pitch of a screw located in the cooling portion is preferably from 0.5D to 0.8D with respect to the screw diameter D.

It is important to reduce a variation in the extrusion amount as much as possible to improve thickness accuracy during extrusion into a sheet shape. To decrease the variation in the extrusion amount as much as possible, the gear pump may be provided between the extruder and the die. When a constant amount of resin is supplied from the gear pump, the thickness accuracy may be improved. Particularly, in the case of using the twin-screw extruder, pressure-raising capability of the extruder itself is low, and thus it is preferable to realize extrusion stability by the gear pump.

- Heating and Melting -

A raw material (raw material resin) of the above-described polyester resin having the intrinsic viscosity IV of from 0.68 to 0.95 is prepared, and the raw material resin is supplied from the supply port by rotating the screw while heating the barrel by the temperature control unit.

The raw material resin supplied to the inside of the barrel is melted by heat generation due to friction between parts of the resin along with rotation of the screw, friction between the resin and the screw or the barrel, and the like in addition to the heating by the temperature control unit, and then the resin gradually moves toward the extruder outlet along with the rotation of the screw.

The raw material resin that is supplied to the inside of the barrel is heated to a temperature higher than the melting point Tm (°C). When the resin temperature is too low, melting becomes deficient during melt extrusion, and thus ejection from the die becomes difficult. In addition, when the resin temperature is too high, the concentration of the terminal carboxyl groups significantly increases due to pyrolysis, and thus a decrease in hydrolysis resistance may be caused.

Specifically, the raw material (raw material resin) of the polyester resin is supplied from the supply port 12 by rotating the screw while heating the cylinder 10 using the temperature control unit 30. In addition, it is preferable to cool

the supply port 12 for prevention of heat transfer in order to prevent a pellet of the raw material resin and the like from being heated and fused to each other and to protect a screw drive facility such as a motor.

The raw material resin supplied to the inside of the cylinder is melted by heat generation due to friction between parts of the resin along with rotation of the screws 20A and 20B, friction between the resin and the screws 20A and 20B or the cylinder 10, and the like in addition to the heating by the temperature control unit 30, and then the resin gradually moves toward the extruder outlet 14 along with the rotation of the screws.

The raw material resin that is supplied to the inside of the cylinder is heated to a temperature higher than the melting point Tm (°C). When the resin temperature is too low, melting becomes deficient during melt extrusion, and thus ejection from the die 40 becomes difficult. In addition, when the resin temperature is too high, the concentration of the terminal COOH groups significantly increases due to pyrolysis, and thus a decrease in hydrolysis resistance may be caused.

In an embodiment, the melt extrusion is carried out as follows. The heating temperature by the temperature control unit 30 and the number of revolutions of the screws 20A and 20B are adjusted in order for the resin temperature in the extruder to have a maximum value of 295°C or less at a position of from 40% to 80% of the total length of the extruder from the upstream end of the extruder, and in order for the resin temperature at the extruder outlet to be 275°C to 285°C. In addition, the upstream end of the extruder represents an original position at which a groove of the screw is located.

When the maximum value of the resin temperature in the twin-screw extruder is lower than a temperature which is higher than the melting point of the resin by 10°C (a temperature of melting point + 10°C), a part of the molten resin is solidified, and thus a non-molten resin may be generated. When the maximum value is higher than a temperature which is higher than the melting point of the resin by 35°C (melting point + 35°C), a crystallization temperature is raised, and it may be difficult to regulate the crystallinity to a specific range. In addition, the concentration of the terminal COOH groups of the resin increases, and thus the hydrolysis resistance may largely decrease. From these viewpoints, in an embodiment, the maximum value of the resin temperature in the twin-screw extruder is set to from the melting point of the resin + 10°C to the melting point of the resin + 35°C, more preferably from the melting point of the resin + 15°C to the melting point of the resin + 35°C, and still more preferably from the melting point of the resin + 20°C to the melting point of the resin + 30°C.

In addition, when the maximum value of the resin temperature in the twin-screw extruder is shown at a position less than 40% of the total length of the extruder from the upstream end of the extruder, heat generation increases, and thus it is difficult to sufficiently lower the resin temperature at the outlet. In addition, when the maximum value is shown at a position exceeding 80% of the total length, the resin cooling effect obtained by the cooling becomes insufficient. From these viewpoints, in the present invention, the maximum value of the resin temperature in the twin-screw extruder is set to a position of from 40% to 80% of the total length of the extruder from the upstream end of the extruder, and preferably a position of from 45% to 70% of the total length of the extruder, and more preferably a position of from 50% to 60% of the total length of the extruder.

With regard to the resin temperature at the outlet of the twin-screw extruder, in general melt extrusion of the related art, usually, extrusion is carried out at approximately 300°C, and when the resin temperature at the extruder outlet is lower than 275°C, non-molten foreign substances may be generated. In addition, when the resin temperature exceeds 285°C, the terminal COOH increases, and thus hydrolysis resistance may be greatly decreased. From these viewpoints, in the embodiment of the present invention, the resin temperature at the extruder outlet may be set to from 275°C to 285°C, preferably from 278°C to 283°C, and still more preferably from 280°C to 282°C.

As means for controlling the resin temperature at the extruder outlet to a range of from 275°C to 285°C, air cooling may be employed, but it is preferable to control the temperature at the cylinder outlet by a thermal medium of a liquid. For example, in the heating and cooling device C9 that is disposed in the vicinity of the cylinder outlet, when a water path is provided to surround the cylinder and a liquid such as water is allowed to pass in the water path, the resin temperature at the extruder outlet may be effectively decreased, and may be controlled with accuracy.

A cylinder temperature at the tip portion on an extruder outlet side is preferably lower than the melting point of the polyester resin. When the cylinder temperature at the tip portion on the extruder outlet side is controlled to a temperature lower than the melting point of the polyester resin, the resin at the extruder outlet is effectively cooled, and thus the resin temperature may be controlled to from 275°C to 285°C. However, when the cylinder temperature is too low, there is a concern that solidification of the molten resin may be caused. Therefore, the cylinder temperature at the tip portion on the extruder outlet side is preferably set to a temperature equal to or higher than a temperature lower than the melting point of the polyester resin by 150°C, and more preferably a temperature equal to or higher than a temperature which is lower than the melting point of the polyester resin by 100°C.

Work of the screw is transferred to the resin as frictional heat, and is largely associated with the resin temperature. In the embodiment of the present invention, the extrusion amount (kg/h) is set to Q, and thermal capacity (J/kgK) of the polyester resin is set to Cp, it is preferable that a heat exchange amount Epoly of the polyester resin satisfy the following Inequality (2).

$$\text{Epoly} + 20\ \text{QCp} < \text{Esp} < \text{Epoly} + 50\ \text{QCp} \qquad (2)$$

In addition, specific power of the extruder with respect to the polyester resin may be calculated from a screw current and a screw voltage as an amount of work of the screw.

In addition, the heat exchange amount Epoly (J/s) of the polyester resin is calculated by the following Expression.

$$\text{Epoly} = \text{QCp}(T_{out} - T_{in}) + \text{QE}$$

(Here, Q represents an ejection amount (kg/s) of the resin, Cp represents heat capacity (J/kg°C) of a resin, $T_{out}$ represent a resin temperature (°C) at the extruder outlet, $T_{in}$ represents a temperature (°C) of a raw material, and E represents latent heat of fusion (J/kg)).

In addition, theoretically, when applying the heat exchange amount Epoly, the polyester resin is melted, but from the viewpoints of reliably suppressing an increase in the terminal COOH while reliably suppressing remaining of the non-molten resin and solidification of the molten resin, it is preferable to add an amount of heat (amount of work) to the heat exchange amount of the polyester resin in a constant range.

When the specific power Esp of the extruder with respect to the polyester resin is larger than (Epoly + 20 QCp), the remaining of the non-molten resin and the solidification of the molten resin may be suppressed. On the other hand, when the specific power Esp is less than (Epoly + 50 QCp), an increase in terminal COOH may be suppressed. From the above-described viewpoints, it is preferable that the specific power Esp of the extruder with respect to the polyester resin satisfy a relationship of the following Inequality (3), and more preferably a relationship of the following Inequality (4).

$$\text{Epoly} + 25\ \text{QCp} < \text{Esp} < \text{Epoly} + 40\ \text{QCp} \qquad (3)$$

$$\text{Epoly} + 25\ \text{QCp} < \text{Esp} < \text{Epoly} + 35\ \text{QCp} \qquad (4)$$

In addition, it is preferable that a temperature-rising crystallization temperature Tc (°C) of a strand that is cooled with water after melt-extruding the polyester resin with the twin-screw extruder satisfy a relationship of $130 < Tc < 150$. As described above, with respect to the product (strand) that is obtained by melt-extruding the polyester resin while controlling the resin temperature inside the twin-screw extruder and the resin temperature at the extruder outlet and by putting the extruded polyester resin in water, the temperature-rising crystallization temperature Tc(°C) is measured by DSC (Differential Scanning Calorimetry). When the non-molten resin remains, Tc is low (approximately 120°C). When Tc is larger than 130, the non-molten resin is substantially not present. When Tc is less than 150, decomposition of the resin is suppressed, and sufficient weather resistance may be obtained.

- Vent Pressure -

When evacuation is carried out through the vents, the volatile components such as moisture in the resin inside the barrel may be effectively removed. When the vent pressure is too low, there is a concern that the molten resin may overflow to the outside of the barrel. In addition, when the vent pressure is too high, there is a concern that the removal of the volatile components may be insufficient, and thus hydrolysis of a film that is obtained tends to occur. From the viewpoints that overflow of the molten resin from the vents is prevented and the volatile components are selectively removed, it is preferable to set the vent pressure to 0.01 Torr to 5 Torr (1.333 Pa to 666.5 Pa), and more preferably 0.01 Torr to 4 Torr (1.333 Pa to 533.2 Pa).

- Average Retention Time -

An average time (average retention time) after the raw material resin is heated and melted in the barrel and is emitted from the extruder outlet, and before the raw material is extruded from the die in a film shape is preferably from 10 minutes to 20 minutes. When the average retention time is less than 10 minutes, the non-molten resin tends to remain. On the other hand, when the average retention time exceeds 20 minutes, the concentration of the terminal carboxyl groups increases due to pyrolysis, and thus the hydrolysis resistance decreases. From these viewpoints, the average retention time is preferably from 10 minutes to 20 minutes, and more preferably from 10 minutes to 15 minutes.

Here, the average retention time is defined by the following Expression.

$$\text{Average retention time (second)} = [\{\text{volume of a pipe downstream the extruder (cm}^3) \times \text{density of a molten body (g/cm}^3) \times 3600\}/1000] \div \text{extrusion amount (kg/h)}$$

- Cooling -

As described above, the raw material resin is heated and melted in the barrel. On the other hand, the inner wall of the barrel on an extruder outlet side is controlled to serve as a cooling portion having a temperature equal to or lower than the melting point Tm (°C) of the polyester resin (raw material resin) by the temperature control unit. As the cooling portion, when the inner wall of the barrel on the extruder outlet side is controlled to a temperature equal to or lower than the melting point Tm (°C) of the raw material resin, excessive heating of the resin and an increase in the concentration of the terminal carboxyl groups may be suppressed. From the viewpoint of reliably suppressing the increase in the concentration of the terminal carboxyl groups, the temperature at the cooling portion is preferably in a range of from (Tm-150)°C to Tm°C, and more preferably in a range of from (Tm-100)°C to (Tm)°C.

The length of the cooling portion is preferably set to 4D to 11D with respect to the screw diameter D. When the length of the cooling portion is 4D or greater, the melted and heated resin is effectively cooled, and thus an increase in the concentration of the terminal carboxyl groups is suppressed. On the other hand, the length of the cooling portion is 11D or less, the resin is prevented from being excessively cooling and solidified, and thus the melt extrusion may be smoothly carried out.

It is preferable that the resin temperature $T_{out}$ at the extruder outlet be set to Tm + 30°C or less. However, when the resin temperature $T_{out}$ at the extruder outlet is too low, there is a concern that a part of the molten resin may be solidified, and thus the resin temperature $T_{out}$ at the extruder outlet is preferably set to from Tm to (Tm+25)°C, and more preferably from (Tm+10)°C to (Tm+20)°C.

- Melt Extrusion -

After the raw material resin is heated and melted in the barrel and is extruded from the extruder outlet, it is preferable to carry out the melt extrusion in a film shape for an average retention time of from 10 minutes to 20 minutes under conditions satisfying the following Inequality (5) by controlling the number of revolutions N (rpm) of a screw and the extrusion amount Q (kg/hr) in consideration of the screw diameter D.

$$6.0\times10^{-6}\times D^3 \leq Q/N \leq 1.1\times10^{-5}\times D^3 \qquad \text{Inequality (5)}$$

When Q/N is less than $6.0\times10^{-6}\times D^3$, the resin generates heat at a high temperature due to high revolution of the screw, and the concentration of the terminal carboxyl groups increases due to pyrolysis. When Q/N exceeds $1.1\times10^{-5}\times D^3$, a resin filling ratio immediately below the vents increases, and thus the molten resin tends to overflow from the vents, and the vent pressure decreases. Therefore, hydrolysis of the resin in the extruder progresses, and thus the concentration of the terminal carboxyl groups is apt to increase. Further, it is easy for the non-molten resin to be mixed-in to the film, and thus strength of the film decreases. This becomes a cause of film fracture during a stretching process.

On the other hand, when the melt extrusion is carried out under conditions satisfying Inequality (5), the overflow of the resin from the vents is prevented, and thus the number of revolutions N of the screw becomes relatively slow. In addition, excessive heating is suppressed by the cooling portion before the extruder outlet, and heat generation due to contact between the resin and the screw or the barrel is suppressed, and thus an increase in concentration of the terminal carboxyl groups due to pyrolysis may be suppressed.

From the above-described viewpoints, it is preferable to carry out the melt extrusion under conditions satisfying the following Inequality (6), and more preferably under conditions satisfying the following Inequality (7).

$$7\times10^{-6}\times D^3 \leq Q/N \leq 1\times10^{-5}\times D^3 \qquad \text{Inequality (6)}$$

$$8\times10^{-6}\times D^3 \leq Q/N \leq 9\times10^{-6}\times D^3 \qquad \text{Inequality (7)}$$

When the number of revolutions N of the screw is too small, temperature unevenness due to the temperature

control unit occurs, and thus a non-molten resin tends to form. When the number of revolutions N of the screw is too large, heat generation excessively occurs, and this reads to an increase in the concentration of the terminal carboxyl groups. The number of revolution N of the screw is preferably from $1.9\times10^2\times D^{-0.5}$ rpm to $8.4\times10^2\times D^{-0.5}$ rpm, and more preferably from $6.3\times10^2\times D^{-0.5}$ rpm to $7.9\times10^2\times D^{-0.5}$ rpm.

When the extrusion amount Q is too small, excessive heating tends to occur, and when the extrusion amount Q is too large, a non-molten resin tends to be generated. The extrusion amount Q is preferably from $1.1\times10^{-3}\times D^{2.5}$ kg/hr to $7.6\times10^{-3}\times D^{2.5}$ kg/hr, and more preferably from $3.8\times10^{-3}\times D^{2.5}$ kg/hr to $7.1\times10^{-3}\times D^{2.5}$ kg/hr.

The resin extruded from the extruder outlet of the barrel is extruded from a die (for example, a cooling roll) through a filter to mold the resin in a film shape.

Humidity before the melt (molten resin) comes into contact with the cooling roll (air gap) after being extruded from the die is preferably adjusted to from 5%RH to 60%RH, and more preferably from 15%RH to 50%RH. When the humidity in the air gap is set to the above-described range, an amount of COOH or an amount of OH on a film surface may be adjusted. In addition, the amount of carboxylic acid on the film surface may be reduced due to adjustment to low humidity.

According to the above-described method, the resin temperature is raised once and then is lowered at the cooling portion, and thus an increase in an amount of the terminal COOH may be suppressed, and occurrence of non-molten foreign substances may be suppressed. In addition to this, an effect of easily controlling an increase in a haze of the film may be obtained. Particularly, when a cooling drum and conditions of air cooling from an opposite surface are combined during thick film formation in an embodiment of the present invention, an amount of the haze due to crystallization in the vicinity of the central portion in a thickness direction of a sheet may be controlled.

The thickness of an unstretched film is preferably from 2.5 mm to 8 mm, more preferably from 2.5 mm to 7 mm, and still more preferably from 2.5 mm to 5 mm. When the thickness is made to be large, a time taken before the extruded melt is cooled to a glass transition temperature (Tg) or less may be lengthened. For the time, the COOH groups on the film surface are diffused into the inside of the polyester, and thus the amount of COOH on the surface may be reduced.

In the polyester that is melt-extruded, a half-value width of a temperature-lowering crystallization temperature is preferably from 25°C to 50°C.

Here, physical properties in which the half-value width of the temperature-lowering crystallization temperature is from 25°C to 50°C may be provided to the polyester (molten resin) during melt extrusion from the extruder. That is, the physical properties in which the half-value width of the temperature-lowering crystallization temperature is from 25°C to 50°C may not be provided before the raw material polyester resin is put into the extruder, and the physical properties in which the half-value width of the temperature-lowering crystallization temperature is from 25°C to 50°C are preferably provided during extrusion from the extrusion die after being melted and passing through the extruder.

When the half-value width of the temperature-lowering crystallization exceeds 50°C, there is a tendency that a crystallization speed of the unstretched sheet becomes too low. When the half-value width is lower than 25°C, the crystallization speed of the unstretched sheet becomes too high, and thus stretching characteristics may decrease.

When the half-value width of the temperature-lowering crystallization temperature of polyester that is melt-extruded is in the above-described range, crystallization in a cooling process, to be described later, may be suppressed. More specifically, when the half-vale width of the temperature-lowering crystallization temperature is set to 25°C or higher, generation of a spherocrystal in a cooling process may be suppressed, and when the half-value width is set to 50°C or lower, crystal growth may be suppressed.

The temperature-lowering crystallization temperature represents a temperature at the top of an exothermic peak which is obtained by a coordinate system in which an amount of heat is shown in the vertical axis and a temperature is shown in the horizontal axis when measuring the amount of heat of the molten resin using a differential scanning calorimetry (DSC) manufactured by Shimadzu Corporation while cooling the molten resin, and is also referred to as Tc. The half-value width (full width at half maximum) of temperature-lowering crystallization temperature (Tc) represents a peak width of the exothermic peak.

Details of a method of measuring the half-value width are as follows.

(1) 10 mg of a polyester sheet is weighed as a sample, the sample is set on an aluminum pan, and an amount of heat with respect to a temperature is measured by a differential scanning calorimetry (DSC) (product name: DSC-60, manufactured by Shimadzu Corporation) while raising a temperature from room temperature to a final temperature of 300°C at a temperature raising rate of 10°C/min.

(2) After reaching the final temperature of 300°C, the temperature is lowered to a final temperature of 60°C at a temperature lowering rate of -10°C/min without retention.

(3) A temperature at the top of a convex exothermic peak that is detected during temperature lowering from 300°C to 60°C is set as the temperature-lowering crystallization temperature (Tc), and a width of the exothermic peak is set as the half-value width. More specifically, with regard to a DSC curve that is created by plotting from a high

temperature side to a low temperature side in a coordinate system in which an amount of heat of the sample is shown in the vertical axis and a temperature is shown in the horizontal axis, a temperature width between a temperature at which a peak starts to rise from a baseline of the DSC curve by exothermic absorption, and a temperature at which the exothermic absorption disappears and reaches the baseline is set as the half-value width.

The half-value width of the temperature-lowering crystallization temperature (Tc) is preferably from 25°C to 40°C, and more preferably from 30°C to 37°C.

In addition, the half-value width of the temperature-lowering crystallization temperature is preferably from 160°C to 220°C. When the half-value width of the temperature-lowering crystallization temperature is 160°C or higher, a cooling rate may be made to be large (a temperature difference with a coolant is small at a low temperature, and a cooling rate may not be secured), and when the half-value width of the temperature-lowering crystallization temperature is 220°C or lower, starting of crystallization may be made to be slow. More preferably, the half-value width of the temperature-lowering crystallization temperature is from 170°C to 210°C.

For example, the half-value width of the temperature-lowering crystallization temperature of polyester that is melt-extruded may be regulated by applying a variation such as a pressure variation to the molten resin in the extruder. Specifically, examples of the variation include variation of a molten resin extrusion pressure, that is, a back pressure, variation of a temperature distribution of the molten resin by varying a temperature in the extruder, and variation of the number of revolutions of the screw of the extruder.

When the half-value width is set to from 25°C to 50°C by varying the back pressure, the temperature distribution, the number of revolutions of the screw, and the like, a pyrolysate tends to be generated in the molten resin. When the pyrolysate is contained in the molten resin, even when a spherocrystal is generated in the molten resin, crystal growth is not likely to occur. As a result, it is considered that crystallization of the polyester sheet may be controlled.

Specifically, when a pressure or a temperature is varied as follows, the half-value width of the temperature-lowering crystallization temperature of the molten resin may be easily set to from 25°C to 50°C. In the following numerical value range of the variation of the pressure or the temperature, when the numerical value is smaller than the lower limit, it is difficult to set the half-value width of the temperature-lowering crystallization temperature to 25°C, and when the numerical value is larger than the upper limit, there is a concern that pyrolysis of the molten resin excessively occurs, and thus on the contrary, crystallization of polyester may be promoted.

It is preferable to vary the back pressure by pressurization in a range from 0.5% to 1.5% with respect to an average pressure in the extruder barrel, and more preferably in a range from 0.8% to 1.1%.

It is preferable to vary the temperature distribution of the molten resin by heating in a range from 0.5% to 4% with respect to an average temperature in the extruder barrel, and more preferably in a range from 0.8% to 2.5%.

In addition, with regard to the control of the half-value width of the temperature-lowering crystallization temperature of polyester, the back pressure, the temperature distribution, and the number of revolutions of the screw may be varied alone, and in combination of two or more thereof.

When the temperature-lowering crystallization temperature of polyester is controlled, as described above, the crystallization speed of the sheet-shaped polyester is easily controlled, and thus occurrence of crystallization in the vicinity of the center in a sheet thickness direction is controlled in combination with the following cooling method.

- Cooling Process -

In the cooling process, it is preferable to cool down the sheet-shaped polyester that is melt-extruded in such a manner that a surface temperature of the polyester is lowered at a rate from 350°C/min to 590°C/min.

In the present invention, since the thickness of the polyester sheet (unstretched film) is large, a difference between a cooling rate of the polyester surface that is a cooling surface and a cooling rate inside the polyester tends to occur. When the cooling rate is slow, a spherocrystal is generated inside the polyester sheet, and a void tends to be generated or fracture tends to occur during stretching. Therefore, with regard to the cooling of the polyester, it is preferable to carry out compulsory cooling from a surface opposite to a cooling drum.

The cooling rate of the molten resin is preferably from 370°C/min to 590°C/min, and more preferably from 400°C/min to 590°C/min.

With regard to cooling means, from the viewpoint of prevention of adhesion of an oligomer onto a sheet surface during a continuous operation, and from the viewpoint of ease of control of a crystallization speed in the vicinity of the center of the polyester sheet in a thickness direction, it is preferable to cool the molten resin extruded from the extruder with cold air and to cool the molten resin by bringing the molten resin into contact with a cooling cast drum.

With regard to the cooling with the cold air, low-temperature cold air is preferable, but the cooling cost of air that is supplied increases, and thus the cooling may be carried out at a temperature in the vicinity of room temperature in a range capable of controlling a haze of the sheet-shaped polyester.

Specifically, it is preferable to set the temperature of the cold air to from 0°C to 50°C, more preferably from 5°C

to 40°C, and still more preferably from 10°C to 35°C. In addition, with regard to a wind velocity, a high wind velocity is preferable from the viewpoint of cooling, but if the wind velocity is excessively raised, flatness of the sheet surface is damaged. Accordingly, it is preferable to set the wind velocity to from 20 m/sec to 70 m/sec, more preferably from 40 m/sec to 65 m/sec, and still more preferably from 50 m/sec to 60 m/sec.

The temperature of the cooling cast drum is preferably from -10°C to 30°C, more preferably from 5°C to 25°C, and still more preferably from 0°C to 15°C. Further, from the viewpoint of increasing cooling efficiency by increasing adhesiveness between the molten resin and the cooling cast drum, it is preferable that static electricity be applied before the molten resin comes into contact with the cooling cast drum.

In addition, it is preferable to adjust an intended haze of the sheet by varying the temperature and wind velocity of the cooling air, and the temperature of the cooling drum.

In the case of cooling the molten resin using the cooling cast drum, it is preferable that the polyester sheet be separated from the cooling cast drum when a surface temperature of the cooled polyester sheet is a temperature satisfying the following Inequality (8).

$$Tg - 10 < TL < Tg \qquad \text{Inequality (8)}$$

[In Inequality (8), Tg represents a glass transition temperature (°C) of polyester, and TL represents a surface temperature of cooled polyester.]

That is, it is preferable to separate the polyester sheet from the cooling cast drum when the surface temperature TL of the cooled polyester sheet is lower than the glass transition temperature Tg of polyester. In addition, it is preferable to separate the polyester sheet from the cooling cast drum before the surface temperature TL of the cooled polyester sheet becomes a temperature equal to or lower than the glass transition temperature Tg of polyester by 10°C.

When the surface temperature TL of the cooled polyester sheet is lower than the glass transition temperature Tg of polyester, the polyester sheet is sufficiently solidified, and thus flexibility decreases, and a damage such as elongation of a part of the polyester sheet may be suppressed during separation. When the separation is carried out when the surface temperature TL of the cooled polyester sheet is higher than a temperature that is lower than the glass transition temperature Tg of polyester by 10°C, defects such as cracking of the polyester sheet may be suppressed.

In addition, although not particularly limited, the glass transition temperature (Tg) of polyester that is a raw material of the polyester sheet is preferably from 65°C to 80°C, and more preferably from 70°C to 80°C.

Further, it is preferable to carry out the separation of the cooled polyester from the cooling cast drum using a separating roll that is disposed to face the cooling cast drum.

When the cooled polyester is separated from the cooling cast drum using the separating roll, separation may be carried out without applying a tensile stress biased to the cooled polyester, and thus the cooled polyester is not likely to be damaged.

In addition, it is preferable that the roll diameter of the separating roll have a size satisfying the following Inequality (9) with the roll diameter of the cooling cast drum.

$$(D1/D2) < 7 \qquad \text{Inequality (9)}$$

[In Inequality (9), D1 represents the roll diameter of the cooling cast drum, and D2 represents the roll diameter of the separating roll.]

Further, it is more preferable that the roll diameter of the separating roll have a size satisfying the following Inequality (9-2) with the roll diameter of the cooling cast drum.

$$3 \leq (D1/D2) < 7 \qquad \text{Inequality (9-2)}$$

[In Inequality (9-2), D1 represents the roll diameter of the cooling cast drum, and D2 represents the roll diameter of the separating roll.]

When D1/D2 is 3 or greater, in the case of separating the cooled polyester from the cooling cast drum, the polyester may be separated without being inclined along the separating roll.

The glass transition temperature Tg of polyester is measured using the DSC. Specifically, 10 mg of a polyester sheet is weighed as a sample, and the sample is set on an aluminum pan. When measuring an amount of heat with respect to a temperature by the DSC device while raising a temperature from room temperature to a final temperature of 300°C at a temperature raising rate of 10°C/min, a temperature at which a DSC curve is bent is set as the glass

transition temperature. In addition, the melting point (melting temperature) Tm of polyester is obtained as a temperature at the top of a concave endothermic peak that is obtained in the DSC curve.

According to the method of manufacturing the polyester sheet, a polyester sheet having a thickness of from 2.5 mm to 8 mm may be obtained. In addition, when the thickness exceeds 5 mm, a cooling rate in the vicinity of the central portion of the molten resin in a thickness direction excessively decreases, and thus a haze tends to increase rapidly. Therefore, means for further raising the cooling rate may be used in combination. Specifically, preferred examples of the means include a method of carrying out cooling using a latent heat of evaporation by mixing mist of water in the cooling air.

The thickness of the sheet is preferably from 2.5 mm to 7 mm, and more preferably from 2.5 mm to 5 mm. When the thickness of the polyester sheet is less than 3 mm, in the case of setting the thickness of the film after biaxial stretching to 200 μm or greater, it is necessary to set a stretching magnification to a low magnification, and this leads to a film having a small fracture stress.

With regard to a preferred biaxially stretched film, for example, in a case of manufacturing a biaxially stretched film of 250 μm which has an internal haze of 1.5%, an external haze of 2.0%, and a fracture stress of 210 MPa, it is preferable to mold an unstretched polyester film that is formed on the cooling drum, for example, to have a thickness of from 3.0 mm to 3.5 mm and an external haze of from 30% to 80%.

The unstretched polyester film, which is obtained in this manner and which has a preferable thickness of from 2.5 mm to 7.0 mm, is stretched in the following stretching process.

[3] Stretching

The unstretched polyester film (polyester sheet) that is obtained in the process of forming an unstretched film is heated, for example, in such a manner that an average temperature T1 (°C) satisfies a relationship expressed by the following Inequality (10), and a temperature of a surface becomes higher than a temperature of the center by 0.3°C or greater and less than 15°C, and then stretching is carried out in longitudinal and lateral directions (a conveying direction and a width direction).

$$Tg - 20°C < T1 < Tg + 25°C \qquad \text{Inequality (10)}$$

[In Inequality (10), Tg represents a glass transition temperature (°C) of the polyester resin.]

In an embodiment, it is preferable that the unstretched polyester film be stretched by stretching rolls while being heated by a near infrared heater or a far infrared heater after being heated by a preheating roll.

It is preferable to heat the unstretched polyester film supplied for the stretching in such a manner that in a temperature of the film, an average temperature T1 (°C) satisfies a relationship expressed by Expression (1), and the surface temperature becomes higher than the center temperature by 0.3°C or greater and less than 15°C. When the unstretched polyester film having a thickness of from 2.5 mm to 7.0 mm is used, and the temperature of the film is controlled to a specific range, the vicinity of the film surface may be made smooth to a certain degree capable of suppressing occurrence of scratch during stretching, and orientation inside the film may be maintained. Accordingly, a thick unstretched polyester film having a thickness of from 2.5 mm to 7.0 mm can be stretched while suppressing occurrence of scratches and without decreasing orientation of the film, and thus the polyester film that is obtained by the stretching method is excellent in both hydrolysis resistance and voltage withstand performance while maintaining smoothness of the film surface.

The average temperature of the unstretched polyester film T1 (°C) represents an average value of the surface temperature and the center temperature of the heated unstretched polyester film.

In addition, with regard to the stretching method, details of the method of measuring the temperature are as follows.

The surface temperature of the film is measured by attaching a thermocouple to two surfaces (both surfaces) of the film that is an object to be measured. The center temperature of the film is measured by burying a thermocouple in the central portion of the film, which is an object to be measured, in a film thickness direction.

With regard to a measurement range of the surface temperature and the center temperature of the film, a measurement initiation point is set to a position located before a stretching initiation point by 3 m (length in a film conveying direction), and a range from the measurement initiation point to the stretching initiation point is set as the measurement range. Here, the "stretching initiation point" represents a point at which the unstretched polyester film that is conveyed comes into contact with stretching rolls.

The measurement is carried out by measuring both the surface temperature and the center temperature of the film whenever 100 msec elapses from the measurement initiation point and the measurement initiation.

The average temperature T1 (°C) is calculated by calculating average values of the surface temperature and the center temperature that are measured for each measurement point, and by arithmetically averaging the average values.

A difference between the surface temperature and the center temperature of the film is calculated by calculating values obtained by subtracting the measured center temperature from the measured surface temperature for each measurement point, and by arithmetically averaging the values.

As a method of controlling the temperature of the unstretched polyester film in such a manner that the average temperature T1 (°C) satisfies a relationship expressed by Expression (1), and the surface temperature becomes higher than the center temperature by 0.3°C or greater and less than 15°C, an embodiment of adjusting a temperature of the preheating roll, an embodiment of adjusting the temperature of the preheating roll and a temperature in the vicinity of the preheating roll, and an embodiment of adjusting a distance between rolls and a film conveying speed may be exemplified.

More preferably, the average temperature T1 (°C) of the unstretched polyester film satisfies a relationship of the following Inequality (10-2).

$$Tg - 10°C < T1 < Tg + 20°C \qquad \text{Inequality (10-2)}$$

[In Inequality (10-2), Tg represents a glass transition temperature (°C) of the polyester resin.]

In the relationship between the surface temperature and the center temperature of the unstretched polyester film heated by the preheating roll, it is preferable that the surface temperature is higher than the center temperature by from 1°C to 10°C.

With regard to the stretching, it is preferable that a surface temperature of the preheating roll used for heating of the unstretched polyester film and a peripheral ambient temperature be a temperature T2 (°C) satisfying a relationship expressed by the following Inequality (11).

$$Tg - 25°C < T2 < Tg + 40°C \qquad \text{Inequality (11)}$$

[In Inequality (11), Tg represents a glass transition temperature (°C) of the polyester resin.]

In a case in which two or more preheating rolls are provided, with regard to the surface temperature and the peripheral ambient temperature of the preheating rolls, it is preferable that the surface temperature of all of the preheating rolls and the peripheral ambient temperature of the preheating rolls satisfy the relationship indicated by Inequality (11).

When both of the surface temperature of the preheating rolls and the peripheral ambient temperature are the temperature T2 (°C) satisfying the relationship indicated by Inequality (11), occurrence of scratches during stretching may be more effectively suppressed.

The surface temperature of each of the preheating rolls may be obtained by measuring the surface of the preheating roll using a radiation thermometer (product name: model number RT60 manufactured by CHINO corporation).

The peripheral ambient temperature of the preheating roll is a measured value obtained by measuring a temperature (°C) of a peripheral space of the surface of the preheating roll at a position which is not affected by heat radiation from the preheating roll using a thermocouple.

As a method of adjusting the peripheral ambient temperature of the preheating roll to satisfy the relationship indicated by Inequality (11), blowing of hot air, heating by an IR heater, casing of the periphery of the preheating roll using a heat insulating material, and the like may be exemplified.

As a very suitable embodiment of a stretching method, the following method may be exemplified. In a state in which the ambient temperature of the preheating roll is managed, the unstretched polyester film is preheated by the preheating roll, longitudinal uniaxial stretching for stretching in a conveying direction is carried out from a site at which heating is initiated by a near infrared heater using stretching rolls adjusted to have a predetermined speed ratio, and then lateral stretching is carried out by a tenter.

In biaxial stretching, for example, the polyester sheet may be subjected to longitudinal stretching in a longitudinal direction of the polyester sheet at a stretching stress of from 5 MPa to 20 MPa and at a stretching magnification of from 2.5 times to 4.5 times, and lateral stretching in a width direction at a stretching magnification of from 2.5 times to 5 times.

More specifically, the polyester sheet is guided to a roll group heated at a temperature of from 70°C to 120°C, and is subjected to the longitudinal stretching in the longitudinal direction (that is, a film travel direction) at a stretching stress of from 5 MPa to 20 MPa and a stretching magnification of from 2.5 times to 4.5 times, and more preferably at a stretching stress of from 8 MPa to 18 MPa and a stretching magnification of from 3.0 times to 4.0 times. After the longitudinal stretching, it is preferable to cool the polyester sheet by a roll group at a temperature of from 20°C to 50°C.

Subsequently, the polyester is guided to a tenter while both ends of the polyester sheet are gripped with clips, and the polyester sheet is preferably subjected to lateral stretching under an atmosphere heated to a temperature from 80°C to 180°C in a direction perpendicular to the longitudinal direction, that is, a width direction at a stretching stress of from 8 MPa to 20 MPa and a stretching magnification of from 3.4 times to 4.5 times, and more preferably at a stretching stress of from 10 MPa to 18 MPa and a stretching magnification of from 3.6 times to 5 times.

A stretched area magnification (longitudinal stretching magnification × lateral stretching magnification) by the biaxial stretching is preferably from 9 times to 20 times. When the area magnification is 9 times or less, the fracture stress of a biaxially stretched film decreases, and weather resistant performance of the film decreases, and thus this magnification is not preferable.

When the area magnification of the stretching is 20 times or greater, stretching tension becomes enormous, and thus the cost of facilities (high-tension roll and ultrahigh-torque motor) capable of enduring the stretching tension increases. In addition, the film tends to be fractured during stretching, and thus productivity decreases.

The stretched area magnification is more preferably from 10 times to 18 times.

From the viewpoint of uniformity of the fracture stress and the like in two axial directions including the longitudinal direction and the lateral direction of the film, a longitudinal stretching magnification/lateral stretching magnification is preferably from 0.5 to 1.3, and more preferably 0.6 to 1.2.

The biaxial stretching method may be either a biaxial stretching method in which the longitudinal stretching and the lateral stretching are separately performed as described above or a simultaneous biaxial stretching method in which the longitudinal stretching and the lateral stretching are carried out simultaneously.

The polyester film may be provided or may not be provided with one or plural functional layers such as a colored layer (including a light reflective layer that reflects solar light) that is colored with a coloring agent, and an easy adhesive layer that reinforces adhesiveness with a constituent base material (for example, a sealing material such as EVA) of a cell side substrate on a surface of the polyester film as necessary. In the case of providing the functional layer, an undercoat layer may be provided between a surface of the polyester film that functions as a polymer support and the functional layer.

In the case of providing the functional layer, an application liquid that forms the functional layer may be applied to the biaxially stretched polyester film and the resultant coated film may be dried. In addition, a method in which the application liquid is applied to the uniaxially stretched polyester film, the resultant coated film is dried, and then stretching is carried out in a direction different from the first stretching may be employed. Further, the application liquid may be applied to the unstretched polyester film, the resultant coated film may be dried, and then the unstretched may be stretched in two directions.

(Undercoat Layer)

The thickness of the undercoat layer is preferably in a range of 2 μm or less, more preferably in a range of from 0.005 μm to 2 μm, and still more preferably in a range of from 0.01 μm to 1.5 μm. When the thickness is 0.005 μm or greater, occurrence of application unevenness is easily avoided, and when the thickness is 2 μm or less, stickiness of the polymer support may be avoided, and thus satisfactory workability may be obtained.

It is preferable that the undercoat layer contain one or greater kinds of polymers selected from the group consisting of a polyolefin resin, acrylic resin, a polyester resin, and a polyurethane resin.

As the polyolefin resin, for example, a modified polyolefin copolymer is preferable. As the polyolefin resin, a commercially available product may be used, and examples of the polyolefin resin include ARROW BASE® SE-1013N, ARROW BASE®SD-1010, ARROW BASE® TC-4010, and ARROW BASE® TD-4010 (manufactured by UNITIKA LTD.); HIGH-TECH S3148, HIGH-TECH S3121, and HIGH-TECH S8512 (trade name, manufactured by TOHO Chemical Industry Co., Ltd.); CHEMIPEARL® S-120, CHEMIPEARL® S-75N, CHEMIPEARL® V100, CHEMIPEARL® EV210H (manufactured by Mitsui Chemicals, Inc.); and the like. In an embodiment, ARROW BASE® SE-1013N (manufactured by UNITIKA LTD.) that is a ternary copolymer of low-density polyethylene, ester acrylate, and maleic anhydride is preferably used.

Preferred examples of the acrylic resin include polymers that contain polymethyl methacrylate, polymethyl methacrylate, or the like, and the like. As the acrylic resin, a commercially available product may be used, and for example, AS-563A (product name, manufactured by Daicel Finechem Ltd.) may be preferably used.

Preferred examples of the polyester resin include polyethylene terephthalate (PET), polyethylene-2,6-naphthalate (PEN), and the like. As the polyester resin, a commercially available product may be used, and for example, VYLONAL® MD-1245 (manufactured by TOYOBO CO., LTD.) may be preferably used.

As the polyurethane resin, for example, a carbonate-based urethane resin is preferable, and for example, SUPERFLEX® 460 (manufactured by DAI-ICHI KOGYO SEIYAKU CO., LTD.) may be preferably used.

Among these, from the viewpoint of securing adhesiveness between the polymer support and the white colored layer, the polyolefin resin is preferably used. The polymers may be used alone, or in combination of two or more kinds.

In the case of using the polymers in combination of two or more kinds, a combination of the acrylic resin and the polyolefin resin is preferable.

When the undercoat layer contains a cross-linking agent, durability of the undercoat layer may be improved. Examples of the crosslinking agent include an epoxy cross-linking agent, an isocyanate cross-linking agent, a melamine cross-linking agent, a carbodiimide cross-linking agent, an oxazoline cross-linking agent, and the like. In an embodiment, the cross-linking agent that is contained in the undercoat layer is preferably the oxazoline cross-linking agent. As the cross-linking agent having an oxazoline group, EPOCROS® K2010E, EPOCROS® K2020E, EPOCROSS®K2030E, EPOCROSS®) WS-500, and EPOCROSS® WS-700 (all manufactured by Nippon Shokubai Co., Ltd.), and the like may be used.

It is preferable that an addition amount of the cross-linking agent in the easy adhesive layer be from 0.5% by mass to 30% by mass with respect to a total mass of binder that constitutes the undercoat layer, more preferably from 5% by mass to 20% by mass, and still more preferably equal to or greater than 3% by mass and less than 15% by mass. Particularly, when the addition amount of the cross-linking agent is 0.5% by mass or greater, a sufficient cross-linking effect is obtained while maintaining strength and adhesiveness of the undercoat layer. In addition, when the addition amount is 30% by mass or less, the pot life of an application liquid may be maintained relatively long, and when the addition amount is less than 15% by mass, an application surface morphology may be improved.

It is preferable that the undercoat layer contain a surfactant such as an anionic surfactant or a nonionic surfactant. A range of the surfactant that may be used in the undercoat layer is the same as the range of a surfactant that may be used in the while colored layer. Among these, the nonionic surfactant is preferable.

In the case of adding the surfactant, the addition amount of the surfactant is preferably from 0.1 $mg/m^2$ to 10 $mg/m^2$, and more preferably from 0.5 $mg/m^2$ to 3 $mg/m^2$. When the addition amount of the surfactant is 0.1 $mg/m^2$ or greater, occurrence of a fish eye is suppressed and thus satisfactory layer formation may be obtained. When the addition amount is 10 $mg/m^2$ or less, adhesion between the polymer support and the white colored layer may be carried out in a satisfactory manner.

The undercoat layer may contain a light stabilizing agent, a slipping agent (fine particle), an ultraviolet absorbing agent, a coloring agent, a nucleating agent (crystallization agent), a flame retardant, and/or the like as additives.

As a method of providing the undercoat layer, a known coating method is appropriately employed. For example, a reverse roll coater, a gravure coater, a rod coater, an air doctor coater, a coating method using spray or brush, and the like may be used. In addition, the polymer support may be immersed in an undercoat layer forming aqueous solution.

In an embodiment, from the viewpoint of cost reduction, the undercoat layer is preferably formed by a method including a so-called in-line coating method of coating an undercoat layer forming composition on the polymer support in a process of forming the polymer support.

With regard to manufacturing of the polymer support including the undercoat layer, specific examples in the embodiment include a method that includes at least (1) supplying an unstretched sheet including a polymer that forms the polymer support, (2) stretching the unstretched sheet in one direction (first direction) parallel with a plane of the unstretched sheet on which the undercoat layer is to be formed (first stretching), (3) applying the undercoat layer forming composition on at least one surface of the sheet that is stretched in the first direction, and (4) stretching the sheet on which the undercoat layer forming composition is applied in a direction perpendicular to the first direction within the undercoat layer forming plane (second stretching).

More specifically, for example, a method including (1)' the polymer that constitutes the polymer support is extruded and is casted on the cooling drum while employing an electrostatic close contact method in combination to obtain the unstretched sheet, (2)' the unstretched sheet is stretched in a longitudinal direction (MD), (3)' the undercoat layer forming aqueous solution is applied on one surface of the longitudinally stretched sheet, (4)' the sheet on which the undercoat layer forming aqueous solution is applied is stretched in a lateral direction (TD), and the like may be used.

In this manner, when the unstretched sheet is stretched in at least one direction in advance, the undercoat layer forming composition is applied to the unstretched sheet, and then the polymer support and the undercoat layer are formed by a process of stretching at least one time in a direction perpendicular to the above-described direction, adhesiveness between the polymer support and the undercoat layer may be improved, uniformity of the undercoat layer may be increased, and the undercoat layer may be made a thinner.

Drying and heat treatment conditions during formation of the undercoat layer depend on the thickness of the applied layer and conditions of a device, but it is preferable that the sheet be transferred to a second stretching process immediately after the coating, and be dried at a preheating zone in the second stretching process or a second stretching zone. In this case, usually, the drying and heat treatment is carried out at a temperature of approximately from 50°C to 250°C.

In addition, the surface of the undercoat layer and the surface of the polymer support may be subjected to a corona discharge treatment and other surface activation treatments.

A concentration of a solid content in the aqueous application solution that may be used as the undercoat layer forming composition is preferably 30% by mass or less, and more preferably 10% by mass or less. The lower limit of

the concentration of the solid content is preferably 1% by mass, more preferably 3% by mass, and still more preferably 5% by mass. According to the above-described ranges, an undercoat layer having a satisfactory surface morphology may be formed.

- Thermal Fixation -

It is preferable to carry out a thermal fixation process continuously in the tenter to complete crystalline orientation of the biaxially stretched film that is obtained and to apply flatness and dimensional stability. The film after the biaxial stretching is preferably subjected to the thermal fixation process in which tension is set to from 1 kg/m to 10 kg/m, and a temperature is set to from 170°C to 230°C. When the thermal fixation process is carried out under these conditions, the flatness and the dimensional stability are improved, and for example, a difference in a moisture content measured with an interval of 10 cm may be set to from 0.01% by mass to 0.06% by mass.

Preferably, the thermal fixation treatment is carried out at a temperature equal to or higher than the glass transition temperature (Tg) of the polyester that is a raw material of the polyester sheet and lower than the melting point (Tm) thereof for from 1 second to 30 seconds, and the film is uniformly and gradually cooled to room temperature. Generally, when the thermal fixation treatment temperature (Ts) is low, thermal shrinkage of the film is large. Therefore, it is preferable that the thermal treatment temperature be high so as to apply high thermal dimensional stability. However, when the thermal treatment temperature is set to be too high, orientation crystallinity decreases. As a result, a moisture content in the film that is formed increases, and thus hydrolysis resistance may deteriorate. Therefore, the thermal fixation treatment temperature (Ts) of the polyester film is set to satisfy a relationship of 40°C ≤ (Tm-Ts) ≤ 90°C, more preferably a relationship of 50°C ≤ (Tm-Ts) ≤ 80°C, and still more preferably a relationship of 55°C ≤ (Tm-Ts) ≤ 75°C.

The polyester film that is obtained may be used as a back sheet that constitutes a solar cell module. However, an ambient temperature during use of the module may increase to approximately 100°C, and thus it is preferable that the thermal fixation treatment temperature (Ts) be from 160°C to Tm-40°C (provided that, Tm-40°C > 160°C), more preferably from 170°C to Tm-50°C (provided that, Tm-50°C > 170°C), and still more preferably from 180°C to Tm-55°C (provided that, Tm-55°C > 180°C). With regard to the thermal fixation treatment temperature, it is preferable to carry out the thermal fixation while sequentially lowering a temperature difference in a range of 1 °C to 100°C in regions divided into two or more parts.

- Thermal Relaxation -

The polyester film may be subjected to a relaxation treatment to relax from 1% to 12% in the width direction or the longitudinal direction as necessary.

The thermally fixed polyester film is usually cooled to the Tg or lower temperature, and both end portions of the polyester film which are gripped by clips are cut and the polyester film is wound in a roll shape. At this time, it is preferable that the polyester film is treated to relax from 1% to 12% in the width direction and/or the longitudinal direction in a temperature range from the Tg to a final thermal fixation treatment temperature.

It is preferable to gradually carry out cooling from the final thermal fixation temperature to room temperature at a cooling rate of from 1°C to 100°C for every second in consideration of dimensional stability. Particularly, it is preferable to gradually carry out cooling from Tg+50°C to Tg at a cooling rate of from 1°C to 100°C for every second. Means for carrying out the cooling and relaxation treatment is not particularly limited, and means known in the related art may be used. However, particularly, it is preferable to carry out the treatment while sequentially carrying out the cooling in plural temperature regions in consideration of improvement in dimensional stability of the polyester film.

When manufacturing the polyester film, stretching, which is used for a stretched film of the related art, such as multi-stage longitudinal stretching, re-longitudinal stretching, re-lateral and longitudinal stretching, and lateral and longitudinal stretching may be carried out to improve strength of the polyester film. The sequence of the longitudinal stretching and the lateral stretching may be reversed from each other.

EXAMPLES

Hereinafter, the present invention will be described in more detail with reference to examples, but the present invention is not limited to the following examples within a range not departing from the scope of the present invention. "Part" is based on a mass unless otherwise stated.

A property value was measured and evaluated by the following method.

(1) Intrinsic Viscosity (IV)

Polyester was dissolved in a mixed solution of 1,1,2,2-tetrachloroethane/phenol (=2/3 [mass ratio]) at 25°C by

using Ubbelohde viscometer, and the IV was measured at 25°C according to the above-described method using Ubbelohde viscometer.

(2) Concentration (AV) of Terminal Carboxyl Group

0.1 g of a polyester sample was dissolved in 10 ml of benzyl alcohol, and chloroform was added to the benzyl alcohol to obtain a mixed solution. A phenol red indicator was added dropwise to the mixed solution. The resultant solution was titrated with a reference solution (0.01 N KOH-benzyl alcohol mixed solution), and the concentration of the terminal carboxyl groups was obtained from a dropping amount.

(3) Fracture Strength, Fracture Elongation

The polyester film was cut to prepare 10 samples having the size of 1 cm (width) × 20 cm in each of a film production flow direction (MD) and a film width direction (TD). Tension test was carried out with respect to these samples using a tensilon universal tension tester (product name: RTC-1210, manufactured by ORIENTECH Co., LTD.). With regard to measurement, a region spaced from an end by 5 cm in each of both ends of the sample was chucked under an environment of 25°C and 60%RH, a length of a portion to be stretched was set to 10 cm, and a drawing rate was set to 20%/minute for every minute to obtain the fracture elongation and the fracture strength. In addition, an average value of the fracture elongation and an average value of the fracture strength of the 10 samples in the directions MD and TD were obtained, respectively.

(4) Internal Haze and External Haze

The biaxially stretched film was put in a quartz cell having a thickness of 10 mm in which tricresyl phosphate was filled, and then the internal haze (Hin) was measured using an SM color computer manufactured by Suga Test Instruments Co., Ltd., product name: SM-T-H1 type.

In addition, the external haze was directly measured by the same apparatus without immersing the biaxially stretched film in the tricresyl phosphate.

(5) Void in Film

The biaxially stretched film was cut using a sharp cutter, and a cut surface was ground with a microtome. Then, the cut surface was observed by an electron microscope with a magnification of 1000 times. After the observation, the number of voids having the maximum length of 1 μm or greater was converted into the number per 400 $\mu m^2$ of observation area.

(6) Amount of Metal in Polyester

Measurement was carried out using high-resolution-type high-frequency inductively coupled plasma mass spectrometry (HR-ICP-MS, product name: AttoM, manufactured by SII Nano Technology Inc.).

(7) Hydrolysis Resistance

The polyester film was subjected to a humidity and heat treatment in such a manner that the polyester film was left as is for 80 hours under an environment of 120°C and 100%RH. Fracture elongation of the film before and after the humidity and heat treatment was measured by the same method as the method of measuring the fracture elongation. With regard to a fracture elongation retention rate, less than 50% was indicated by B, 50% or greater and less than 60% was indicated by A, 60% or greater and less than 70% was indicated by S, 70% or greater and less than 80% was indicated by SS, and 80% or greater was indicated by SSS.

Fracture elongation retention rate (%) = [fracture elongation after humidity and heat test]/[fracture elongation before humidity and heat test]

(8) Electrical Insulating Property

A sample, which was left as is indoors of 23°C and 65%RH for one night, was used as a sample for measuring a partial discharge voltage of the polyester film, and the the partial discharge voltage was measured using a partial discharge tester (product name: KPD2050, manufactured by KIKUSUI ELECTRONICS CORP.)

With respect to each of (i) a case of setting one surface of the film as the sample to an upper electrode side,

and (ii) case of setting the one surface to a lower electrode side, measurement was carried out at arbitrary in-plane 10 sites of the film to obtain an average value of the measured values of the 10 sites. A higher value between the obtained average value with regard to (i) and the obtained average value with regard to (ii) was set as a partial discharge voltage V0. Test conditions were as follows.

<Test Conditions>

- A three-stage pattern, which includes a first stage pattern of simply raising a voltage from 0 V to a predetermined test voltage, a second stage pattern of maintaining the predetermined test voltage, and a third stage pattern of simply lowering the voltage from the predetermined test voltage to 0 V, was selected as an output voltage application pattern in an output sheet.
- A frequency was set to 50 Hz.
- A test voltage was set to 1 kV.
- Time T1 for the first stage was set to 10 sec, time T2 for the second stage was set to 2 sec, and time T3 for the third stage was set to 10 sec.
- A count method in a pulse count sheet was set to "+" (plus), and a detection level was set to 50%.
- An amount of electric charges in a range sheet was set to range 1000 pC.
- In a protection sheet, a voltage check box was checked and then 2 kV was input. In addition, a pulse count was set to 100000.
- In a measurement mode, an initiation voltage was set to 1.0 pC and an extinction voltage was set to 1.0 pC.

The partial discharge voltage V0 measured by the conditions was determined according to the following criteria and was shown.

A: 1 kV or greater
B: Less than 1 kV

(9) Stretching Property

In biaxial stretching of the unstretched sheet, a case in which stretching was carried out without fracture for 24 hours was indicated by A, and a case in which fracture occurred even once was indicated by B.

The partial discharge voltage, the stretching properties, the hydrolysis resistance, and overall evaluation results of the polyester film are collectively described in Table 2.

The overall evaluation expresses suitability of the polyester film for a solar cell back sheet by four stages.

SS: The polyester film is particularly excellent, and may be appropriately used for the back sheet.
S: The polyester film is very excellent, and may be appropriately used for the back sheet.
A: The polyester film may be appropriately used for the back sheet.
B: The polyester film is poor in performance and/or productivity, and thus the polyester film is not suitable for the back sheet.

[Examples 1 to 20, and Comparative Examples 1 to 6]

In this manner, respective polyester films of Examples and Comparative Examples were prepared.

[Preparation of Polyether Film]

(Preparation of Polyether Film of Example 1)

<Synthesis of Raw Material Polyester Resin 1>

As described below, a polyester resin (Ti catalyst-based PET) was obtained by a continuous polymerization apparatus by using a direct esterification method which includes directly reacting terephthalic acid and ethylene glycol with each other, distilling water off, carrying out esterification, and then carrying out polycondensation under a reduced pressure.

(1) Esterification Reaction

In a first esterification reaction tank, 4.7 tons of high purity terephthalic acid and 1.8 tons of ethylene glycol were mixed over 90 minutes to form slurry, and the slurry was continuously supplied to the first esterification reaction tank at a flow rate of 3800 kg/h. Further, an ethylene glycol solution of a citric acid chelate titanium complex (VERTEC® AC-420, manufactured by Johnson Matthey) in which the citric acid is coordinated with a Ti metal was continuously supplied, and a reaction was carried out at a temperature inside the reaction tank of 250°C for an average retention time of approximately 4.3 hours under stirring. At this time, the citric acid chelate titanium complex was continuously added in such a manner that an addition amount of Ti became 9 ppm in terms of an element. At this time, the acid value of an oligomer that was obtained was 600 eq/ton.

This reaction product was transferred to a second esterification reaction tank, and the reaction product was allowed to react under stirring at a temperature inside the reaction tank of 250°C for an average retention time of 1.2 hours, whereby an oligomer having an acid value of 200 eq/ton was obtained. The inside of the second esterification reaction tank was divided into three zones, an ethylene glycol solution of magnesium acetate tetrahydrate was continuously supplied from a second zone in such a manner that an addition amount of Mg became 75 ppm in terms of an element, and subsequently an ethylene glycol solution of trimethyl phosphate was continuously supplied from a third zone in such a manner that an addition amount of P became 65 ppm in terms of an element.

(2) Polycondensation Reaction

The esterification reaction product obtained as described above was continuously supplied to a first polycondensation reaction tank, and polycondensation was carried out under stirring at a reaction temperature of 270°C and a pressure inside the reaction tank of 20 torr ($2.67\times10^{-3}$ MPa) for an average retention time of approximately 1.8 hours.

Further, the reaction product was transferred to a second polycondensation reaction tank, and in this reaction tank, a reaction (polycondensation) was carried out under stirring under the conditions of a temperature inside the reaction tank of 276°C and a pressure inside the reaction tank of 5 torr ($6.67\times10^{-4}$ MPa) for an average retention time of approximately 1.2 hours.

Subsequently, the reaction product was further transferred to a third polycondensation reaction tank, and in this reaction tank, a reaction (polycondensation) was carried out under conditions of a temperature inside the reaction tank of 278°C and a pressure inside the reaction tank of 1.5 torr ($2.0\times10^{-4}$ MPa) for an average retention time of 1.5 hours, whereby a reaction product (polyethylene terephthalate (PET)) was obtained.

Subsequently, the reaction product that was obtained was ejected in cold water into a strand shape, and the strands were immediately cut to prepare pellets of a polyester resin (cross-section: major axis of approximately 4 mm and minor axis of approximately 2 mm, and length: approximately 3 mm).

Measurement was carried out with respect to the polyester resin that was obtained using a high-resolution-type high-frequency inductively coupled plasma mass spectrometry (HR-ICP-MS; product name: AttoM, manufactured by SII Nano Technology, Inc.) as described below. From the measurement, it was found that Ti was 9 ppm, Mg was 75 ppm, P was 60 ppm, and the total of the P component and the metal components in polyester was 144 ppm. P was slightly reduced as compared to the initial addition amount. It was assumed that this reduced portion was volatilized during the polymerization process.

In the polymer that was obtained, the intrinsic viscosity (IV) was 0.58, and the amount of terminal COOH (AV) was 20 eq/ton.

- Solid-Phase Polymerization -

A PET sample that was polymerized as described above was processed into pellets (diameter of 3 mm and a length of 7 mm), and the resin pellets that were obtained were subjected to solid-phase polymerization according to a batch method.

After the resin pellets were put into a container, the solid-phase polymerization was carried out in a vacuum under the following conditions while stirring the resin pellets.

A preliminary crystallization treatment was carried out at 150°C, and the solid-phase polymerization reaction was carried out at 190°C for 30 hours.

The polyester resin (PET-1) that was obtained after the solid-phase polymerization hadan intrinsic viscosity (IV) of 0.78 dl/g, and an amount of terminal COOH (AV) ofs 15 eq/ton.

- Formation of Unstretched Film -

The raw material polyester-1 after the solid-phase polymerization was dried to have a moisture content of 20

ppm or less, and then the dried polyester was extruded using a twin-screw extruder described below.

A double-vent type and same-direction-rotation engagement type twin-screw extruder, which was provided with screws of the following configuration in a cylinder having vents formed at two sites, and heaters (temperature control units) provided at the periphery of the the cylinder to control a temperature by dividing the cylinder into 9 zones in the longitudinal direction, as described in Fig. 1, was prepared as the extruder.

Screw diameter D: 65 mm
Length L [mm]/screw diameter D [mm]: 31.5 (width of one zone: 3.5 D)
Screw shape: a plasticization kneading portion was provided immediately before a first vent, and a degassing promotion kneading portion was provided immediately before a second vent

A gear pump, a metal fiber filter, and a die were connected to a portion after an extruder outlet of the twin-screw extruder, and a set temperature of a heater that heated the die was set to 280°C and an average retention time was set to 10 minutes.

Gear pump: Two-gear type
Filter: Metal fiber sintered filter (hole diameter: 20 $\mu$m)
Die: Lip interval of 4 mm

- Melt Extrusion -

The temperature of each of the respective zones (C1 to C9) of the twin-screw extruder was set to as follows, and melt extrusion was carried out.

C1: 70°C, C2: 270°C, C3 to C6: 280°C, C7: 270°C, C8: 260°C, and C9: 260°C

The number of revolutions of the screws was set to 120 rpm, a raw material resin was supplied from the supply port 12, the raw material was heated and melted, the extrusion amount was set to 250 kg/h, and then the melt extrusion was carried out. At this time, the highest resin temperature of the plasticization in the extruder was 290°C.

The melt extruded from the extruder outlet was allowed to pass through the gear pump and the metal fiber filter, and was extruded from the die to a cooling (chill) roll. The extruded melt was brought into close contact with the cooling roll using an electrostatic application method. As the cooling roll, a hollow chill roll was used. The cooling roll was configured in such a manner that a temperature could be adjusted using water as a thermal medium. The temperature of water was set to 10°C.

Cold air of 25°C was blown to the molten resin at a wind velocity of 60 m/sec from a cold air generating apparatus provided to face the cooling roll, and thus a surface temperature of the polyester decreased at a cooling rate of 450°C/min.

With regard to a conveying region (air gap) from the die outlet to the cooling roll, the conveying region was enclosed, and humidity control air was introduced to the conveying region to adjust humidity to 30%RH.

The cooling rate was obtained as follows. The surface temperature of polyester was measured at an interval of 5 seconds after the melted polyester (molten resin) was extruded onto the cooling cast drum until the resultant cooled polyester was separated from the cooling cast drum. On the basis of the surface temperature, simulation of a temperature inside the sheet was carried out to obtain the longest cooling time period taken to decrease from 220°C to 120°C, and this longest time period was converted into the cooling rate.

When the surface temperature (TL) reached 70°C, the cooled polyester was separated from the cooling cast drum using a separating roll disposed to face the cooling cast drum.

When a roll diameter of the cooling cast drum was set to D1 and a roll diameter of the separating roll was set to D2, a roll having dimensions in which D1/D2 was 6.3 was used as the separating roll.

The thickness of the unstretched film was measured by an automatic thickness meter (WEBFREX®, manufactured by Yokogawa Electric Corporation) that was provided at a rear side of the separating roll.

In this manner, a polyester sheet having a thickness of 4 mm was obtained. In the polyester sheet, a temperature-lowering crystallization temperature was 185°C and crystallinity calculated from a density method was 1.2%.

- Preparation of Biaxially Stretched Film -

The unstretched film was biaxially stretched by the following method to obtain a PET film.

An ambient temperature at the periphery of the preheating roll was controlled by a warm air generator using a ceramic heater, and the ambient temperature was adjusted to 30°C by supplying warm air of 42°C. Subsequently, the unstretched film obtained as described above was conveyed using 15 preheating rolls which had a diameter of 180 mm

to 200 mm, and in which an installation distance (distance between surfaces of the rolls) was set to 10 mm and a surface temperature was set to a range of 75°C to 85°C. At this time, a difference between the surface temperature and the center temperatue of the film which were measured by the method was 3.5°C.

Then, the unstretched film was preheated by near infrared heaters provided at upper and lower sides of the unstretched film to a temperature of 90°C. The unstretched film was stretched at a magnification of 3.5 times in a conveying direction (longitudinal direction) of the film using two stretching rolls which were provided back and front of the near infrared heater and which were different in a peripheral speed.

The longitudinally stretched film was conveyed in a contact manner by five cooling rolls which had a diameter of 350 mm and a surface temperature of 20°C and were disposed in a staggered arrangement, whereby the longitudinally stretched film was cooled to 40°C.

Subsequently, the longitudinally stretched film was guided to a tenter while both ends being gripped with clips, and was stretched in a lateral direction at a magnification of 4.4 times.

In the tenter, a temperature of a preheating zone was set to 110°C, a temperature of a stretching zone was set to 120°C, a temperature of a thermal fixation zone was set to 200°C, and a temperature of a thermal relaxation zone was set to 175°C. At the thermal relaxation zone, the film was subjected to relaxation shrinkage at 10% with respect to a zone width of the stretching portion.

In this manner, in Example 1, the biaxially stretched polyester film was obtained without fracture for 24 hours. The characteristics and the like of the obtained polyester film are described in Tables 1 and 2.

(Preparation of Polyether Film of Example 2 and Example 3)

Biaxially stretched films were obtained by the same method as Example 1 except that the highest temperature of the twin-screw extruder during plasticization and the temperature of the cooling roll were changed as shown in Table 1, and an ejection amount of extrusion and a slit height of the die during formation of the unstretched film were changed as shown in Table 1.

(Preparation of Polyether Film of Example 4)

A biaxially stretched film was obtained by the same method as Example 1 except that 4.6 tons of terephthalic acid and 0.1 tons of isophthalic acid were added to 1.8 tons of ethylene glycol and 0.6 tons of cyclohexanedimethanol and mixed to prepare a slurry raw material, and polyester was synthesized using the raw material and was subjected to solid-phase polymerization.

(Preparation of Polyester Film of Example 5)

A biaxially stretched film was prepared by the same method as Example 1 except that trimellitic acid was mixed in and added to ethylene glycol of trimethyl phosphate such that the trimellitic acid became 0.5% by mole of a terephthalic acid component of the polyester to obtain the polyester, and the polyester was subjected to the solid-phase polymerization.

(Preparation of Polyester Film of Example 6 and Example 7)

Biaxially stretched films were prepared by the same method as Example 1 except that instead of the ethylene glycol solution of a citric acid chelate titanium complex (VERTEC®AC-420, manufactured by Johnson Matthey) in which the citric acid is coordinated with a Ti metal, an ethylene glycol solution of germanium dioxide (manufactured by MERCK KGaA) or an ethylene glycol solution of aluminium acetylacetonate (manufactured by MERCH KGaA) were added as a polymerization catalyst in an amount of 50 ppm in terms of Ge and in an amount of 30 ppm in terms of Al, respectively, to prepare polyester, and subsequently the polyester was subjected to the solid-phase polymerization.

(Preparation of Polyester Film of Example 8)

A biaxially stretched film was prepared in the same manner as Example 1 except that STABAXOL® P100 (manufactured by Rhein Chemie Rheinau GmbH; described as "CI" in Table 1) in a proportion of 0.1% by weight with respect to the mass of the polyester resin was put into the two-screw extruder together with the polyester resin during melt extrusion.

(Preparation of Polyester Film of Examples 9 to 15)

As shown in Table 1, biaxially stretched films were prepared in the same manner as Example 8 except that the

addition amount of STABAXOL® P100 was changed or the following compounds were used instead of the STABAXOL® P100.

(a) Carbodiimide compound
STABAXOL® P100 (manufactured by Rhein Chemie Rheinau GmbH; described as "CI" in Table 1)
(b) Epoxy compound
CARDURA E10P (product name, manufactured by Hexion Speciality Chemicals) (described as "EP" in Table 1)
(c) Oxazoline compound
EPOCROSS® RPS-1005 manufactured by Nippon Shokubai Co., Ltd. (described as "OX" in Table 1)

(Preparation of Polyester Film (CHDM-Based Polyester Film) of Examples 16 and 17)

Polyester containing 80% by mole or greater of a 1,4-cyclohexanedimethanol component was prepared by a batch polymerization apparatus according to a transesterification method as described below.

• First Process

Dimethyl terephthalate was used as a dicarboxylic acid component. 1,4-cyclohexanedimethanol was used as a diol component in a molar amount of 2.5 times that of the dicarboxylic acid. Ethylene glycol was used as necessary. As a catalyst, ethylene glycol solution of a citric acid chelate titanium complex (VERTEC® AC-420, manufactured by Johnson Matthey) in which the citric acid is coordinated with a Ti metal was used in an amount of 9 ppm in terms of an amount of a Ti element with respect to the final polyester on the basis of weight, and magnesium acetate tetrahydrate was used in an amount of 75 ppm in terms of an amount of a Mg element. These were charged to a transesterfication reaction layer in a predetermined amount, the inside of the tank was set to a nitrogen atmosphere, the temperature inside of the reaction tank was raised from room temperature to 230°C for 3 hours, and transesterification reaction was allowed to occur under stirring. Methanol that was generated by the reaction was taken out from a rectifying column connected to the transesterification reaction. The temperature was raised to 250°C for 2 hours, and the reaction was allowed to occur until distillation of methanol was stopped.

• Second Process

After the transesterification reaction was terminated, the ethylene glycol solution of trimethyl phosphate was added to the content inside the transesterfication reaction tank so that the concentration (content) of a phosphorous element became 60 ppm with respect to the mass of the polyester, and then stirring was continued for 5 minutes.

• Third Process

The content inside the transesterification reaction tank was transferred to a polycondensation reaction tank that was connected to the transesterification reaction in series, and then polymerization reaction was carried out. The polycondensation reaction was carried out under conditions in which the final reaching temperature was 285°C and a degree of vacuum was 0.1 Torr to obtain polyester. Subsequently, after the inside of the polycondensation reaction tank was returned to the atmospheric pressure using nitrogen and was pressurized to 0.1 MPa, the polycondensation reaction was allowed to occur. A reaction product that was obtained was ejected in a strand shape, and the strands were cooled with water and were immediately cut to prepare pellets (cross-section: major axis of approximately 4 mm and minor axis of approximately 2 mm, and length: more than approximately 3 mm) of CHDM-based polyester resin.

• Fourth Process

The polyester pellets that were obtained as described above were dried at 160°C for 6 hours and were crystallized.

Example 16

In the method, 1,4-cyclohexanedimethanol was used as a sole diol component to prepare polyester composed of polycyclohexanedimethanol terephthalate. The intrinsic viscosity of the polyester was 0.80 and a melting point thereof was 281 °C. A biaxially stretched film of Example 16 was prepared by the same method as Example 1 except that these polyester pellets were used instead of the polyester pellets in Example 1. Conditions that were used for preparation and characteristics of the prepared biaxially stretched film are described in Table 1 and Table 2.

Example 17

In the method, each of 80% by mole of 1,4-cyclohexanedimethanol and 20% by mole of ethylene terephthalate were used as the diol component to prepare polyester. The intrinsic viscosity of the polyester was 0.81 and a melting point thereof was 276°C. A biaxially stretched film of Example 17 was prepared by the same method as Example 1 except that these polyester pellets were used instead of the polyester pellets in Example 1. Conditions that were used for preparation and characteristics of the prepared biaxially stretched film are described in Table 1 and Table 2.

(Preparation of Polyester Film of Examples 18 and 19)

(Preparation of Biaxially Stretched Polyester Film Obtained by Adding Cyclic Carbodiimide Compound)

Biaxially stretched films were prepared by the same method as Example 1 except that the following cyclic carbodiimide compound (1) or (2) was put into the twin-screw extruder together with the polyester resin during the melt extrusion. However, the addition amount of the cyclic carbodiimide compound was set to 1% by mass with respect to the polyester resin.

• Cyclic Carbodiimide (1)

Cyclic carbodiimide (1), which is a compound having a molecular weight of 516 and described in Examples of JP-A No. 2011-256337 and which was synthesized with reference to a synthetic method described in Reference Example 2 of JP-A No. 2011-256337, was used in Example 18.

• Cyclic Carbodiimide (2)

Cyclic carbodiimide (2), which is a compound having a molecular weight of 252 and described in Examples of JP-A No. 2011-256337 and which was synthesized with reference to a synthetic method described in Reference Example 1 of JP-A No. 2011-256337, was used in Example 19.

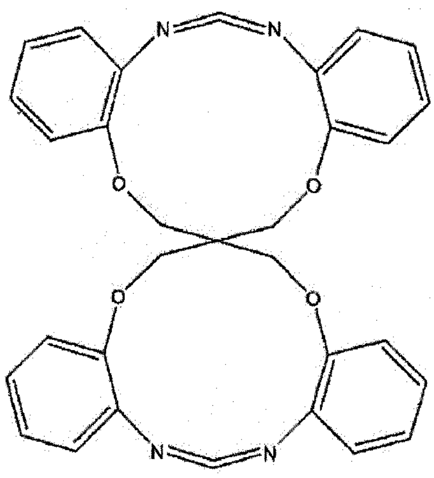

Cyclic carbodiimide (1)

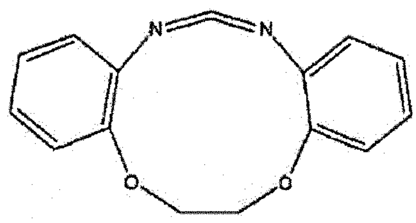

Cyclic carbodiimide (2)

(Comparative Example 1)

A biaxially stretched film was prepared by the same method as Example 2 except that instead of the ethylene glycol solution of a citric acid chelate titanium complex (VERTEC®AC-420, manufactured by Johnson Matthey) in which the citric acid is coordinated with a Ti metal, an ethylene glycol solution of antimony trioxide (manufactured by Nippon Seiko Co., Ltd.) was added as a polymerization catalyst in an amount of 250 ppm in terms of an amount of Sb with respect to the polyester to obtain polyester in which the content of Sb was 210 ppm, and this polyester was subjected to the solid-phase polymerization.

(Comparative Examples 2 to 3)

Biaxially stretched films were prepared in the same manner as Example 1 except that the temperature of the extruder during the melt extrusion and the cooling rate on the cooling roll were changed as shown in Table 1.

[0294] Table 1

| | Highest temperature during plasticization | Crystallization temperature of unstretched sheet | Cooling rate at cooling roll | Thickness of unstretched sheet | Crystallinity of unstretched sheet | Film thickness | Polymer |
|---|---|---|---|---|---|---|---|
| | °C | °C | °C/min | μm | % | [μm] | [% by mole of PET] |
| Ex. 1 | 290 | 135 | 450 | 3100 | 1.2 | 250 | 100 |
| Ex. 2 | 292 | 137 | 550 | 4340 | 2.1 | 350 | 100 |
| Ex. 3 | 293 | 137 | 580 | 5580 | 3.8 | 450 | 100 |
| Ex. 4 | 270 | 140 | 500 | 7440 | 3.4 | 600 | 83 (CHDM=15, IPA=2) |
| Ex. 5 | 290 | 136 | 400 | 3100 | 0.8 | 250 | 99.5 (trimellitic acid = 0.5) |
| Ex. 6 | 293 | 139 | 500 | 4350 | 1.6 | 350 | 100 |
| Ex. 7 | 293 | 136 | 500 | 4350 | 2.1 | 350 | 100 |
| Ex. 8 | 290 | 135 | 450 | 3100 | 1.4 | 250 | CI: 0.1 wt% |
| Ex. 9 | 290 | 135 | 450 | 3100 | 1.6 | 250 | CI: 0.3 wt% |
| Ex. 10 | 290 | 133 | 450 | 3100 | 2.1 | 250 | CI: 1 wt% |
| Ex. 11 | 290 | 131 | 450 | 3100 | 2.5 | 250 | CI: 3 wt% |
| Ex. 12 | 290 | 131 | 450 | 3100 | 2.8 | 250 | CI: 5 wt% |
| Ex. 13 | 290 | 130 | 450 | 3100 | 3.1 | 250 | CI: 6 wt% |
| Ex. 14 | 290 | 133 | 450 | 3100 | 2.2 | 250 | EP: 1 wt% |
| Ex. 15 | 290 | 133 | 450 | 3100 | 2.2 | 250 | OX: 1 wt% |
| Ex. 16 | 310 | 140 | 550 | 3100 | 2.5 | 250 | 0 (CHDM=100) |
| Ex. 17 | 305 | 138 | 450 | 3100 | 2.0 | 250 | 20 (CDHM=80) |
| Ex. 18 | 290 | 137 | 450 | 3100 | 1.1 | 250 | 100 |
| Ex. 19 | 290 | 135 | 450 | 3100 | 1.2 | 250 | 100 |
| Comp. Ex. 1 | 280 | 127 | 400 | 4340 | 6.5 | 350 | 100 |
| Comp. Ex. 2 | 310 | 146 | 360 | 3100 | 0.1 or less | 250 | 100 |
| Comp. Ex. 3 | 300 | 146 | 320 | 2150 | 0.1 or less | 175 | 100 |

Table 1-continued.

| | Fracture strength | Internal haze | Difference from external haze | Void (1 μm or greater) | AV | IV | Catalyst and the like |
|---|---|---|---|---|---|---|---|
| | [Mpa] | [%] | [%] | [voids/400 $\mu m^2$] | [eq/t] | | Total of Ti/Al/Ge and others [ppm] |
| Ex. 1 | 210 | 1.9 | 0.2 | 0 | 17 | 0.74 | 144 (Ti= 9, Mg= 75, P=60) |
| Ex. 2 | 235 | 5.2 | 0.8 | 0 | 17 | 0.74 | 144 (Ti= 9, Mg= 75, P=60) |
| Ex. 3 | 245 | 12.0 | 1.2 | 0.3 | 17 | 0.74 | 144 (Ti= 9, Mg= 75, P=60) |
| Ex. 4 | 220 | 8.0 | 1.8 | 0 | 20 | 0.78 | 144 (Ti= 9, Mg= 75, P=60) |
| Ex. 5 | 225 | 8.0 | 1.3 | 0.7 | 23 | 0.88 | 144 (Ti= 9, Mg= 75, P=60) |
| Ex. 6 | 235 | 4.0 | 0.9 | 0 | 24 | 0.69 | 185 (Ge=50, Mg= 75, P=60) |
| Ex. 7 | 245 | 10.5 | 1.9 | 0.6 | 19 | 0.71 | 175 (Al=30, Mg= 75, P=60) |
| Ex. 8 | 210 | 2.5 | 0.2 | 0 | 16 | 0.74 | 144 (Ti=9, Mg= 75, P=60) |
| Ex. 9 | 210 | 3.0 | 0.3 | 0 | 15 | 0.74 | 144 (Ti=9, Mg= 75, P=60) |
| Ex. 10 | 205 | 4.5 | 0.3 | 0 | 15 | 0.74 | 144 (Ti=9, Mg= 75, P=60) |
| Ex. 11 | 200 | 6.2 | 0.4 | 0 | 14 | 0.74 | 144 (Ti=9, Mg= 75, P=60) |
| Ex. 12 | 200 | 6.5 | 0.5 | 0 | 13 | 0.74 | 144 (Ti=9, Mg= 75, P=60) |
| Ex. 13 | 195 | 10.0 | 0.8 | 0 | 12 | 0.74 | 144 (Ti=9, Mg= 75, P=60) |
| Ex. 14 | 215 | 3.5 | 0.3 | 0 | 15 | 0.74 | 144 (Ti=9, Mg= 75, P=60) |
| Ex. 15 | 215 | 3.6 | 0.3 | 0 | 15 | 0.74 | 144 (Ti=9, Mg= 75, P=60) |
| Ex. 16 | 230 | 1.5 | 0.6 | 0.8 | 17 | 0.78 | 144 (Ti=9, Mg= 75, P=60) |
| Ex. 17 | 215 | 1.3 | 0.3 | 0.3 | 18 | 0.78 | 144 (Ti=9, Mg= 75, P=60) |
| Ex. 18 | 210 | 1.8 | 0.2 | 0 | 8 | 0.75 | 144 (Ti=9, Mg= 75, P=60) |
| Ex. 19 | 210 | 1.9 | 0.2 | 0 | 6 | 0.75 | 144 (Ti=9, Mg= 75, P=60) |
| Comp. Ex. 1 | 260 | 25.0 | 6.0 | 13 | 24 | 0.74 | 345 (Sb=210, Mg=75, P=60) |
| Comp. Ex. 2 | 185 | 3.8 | 0.3 | 0.6 | 24 | 0.66 | 144 (Ti=9, Mg= 75, P=60) |
| Comp. Ex. 3 | 183 | 0.8 | 0.1 | 0 | 17 | 0.74 | 144 (Ti=9, Mg= 75, P=60) |

Table 2

| | Partial discharge voltage | Stretching property | Hydrolysis resistance | Overall evaluation |
|---|---|---|---|---|
| Example 1 | A | A | S | S |
| Example 2 | A | A | S | S |
| Example 3 | A | A | S | A |
| Example 4 | A | A | A | A |
| Example 5 | A | A | S | S |
| Example 6 | A | A | A | A |
| Example 7 | A | A | S | A |
| Example 8 | A | A | S | S |
| Example 9 | A | A | S | S |
| Example 10 | A | A | S | S |
| Example 11 | A | A | S | S |
| Example 12 | A | A | S | S |
| Example 13 | A | A | S | A |
| Example 14 | A | A | S | S |
| Example 15 | A | A | S | S |
| Example 16 | A | A | SSS | SS |
| Example 17 | A | A | SS | SS |
| Example 18 | A | A | SSS | SS |
| Example 19 | A | A | SSS | SS |
| Comparative Example 1 | A | B | B | B |
| Comparative Example 2 | A | A | B | B |
| Comparative Example 3 | B | A | S | B |

[Examples 20 to 38]

<Preparation of Solar Cell Module>

Solar cell modules of Examples 20 to 38 were prepared as described below by using the respective polyester films of Example 1 to Example 19 as a back sheet for a solar cell.

Reinforced glass having a thickness of 3.2 mm, a first EVA sheet (product name: SC50B, manufactured by RIKEN FABRO Co.), a crystalline solar cell, a second EVA sheet [product name: SC50B, manufactured by RIKEN FABRO Co.], and any one sheet of the polyester film of Examples 1 to 19 were layered with each other in this order and were hot-pressed using a vacuum laminator (manufactured by Nisshinbo Holdings Inc.) to allow the first EVA sheet, the crystalline solar cell, the second EVA sheet, and the back sheet to adhere to each other. Specifically, evacuation was carried out at 128°C for 3 minutes by using the vacuum laminator, and compression was carried out for 2 minutes for temporary adhesion, and then an adhesion treatment was carried out in a dry oven at 150°C for 30 minutes.

In this manner, the crystalline solar cell modules of Examples 20 to 38 were prepared. Power generation operation was carried out using the solar cell modules that were prepared, and all of the solar cell modules show satisfactory power generation performance as a solar cell.

## Claims

**1.** A biaxially stretched polyester film having:

a thickness of from 200 μm to 800 μm;
fracture strength in both a longitudinal stretching direction (MD) and a lateral stretching direction (TD) of from 180 MPa to 300 MPa;
an internal haze (Hin) of from 0.3% to 20%;
a difference (ΔH = Hsur - Hin) between an external haze (Hsur) and the internal haze (Hin) of 2% or less; and
an intrinsic viscosity of from 0.68 to 0.90,

wherein the biaxially stretched polyester film is formed of a polyester that comprises an ethylene terephthalate unit or a 1,4-cyclohexane dimethylene terephthalate unit as 80% by mole or greater of its constituent unit and that has a concentration of terminal carboxyl groups of 25 eq/ton or less,
wherein the external haze (Hsur) represents a scattering magnitude of reflected light on a surface of the film,
and wherein with respect to the internal haze (Hin), the biaxially stretched film is put in a quartz cell in which tricresyl phosphate is filled and which has a thickness of 10 mm, and then the internal haze is measured by using a haze meter, while the external haze (Hsur) is directly measured by the same apparatus without immersing the biaxially stretched film in the tricresyl phosphate;
with respect to the fracture strength, tension test of a polyester film is carried out by using a tensilon universal tension tester under an environment of 25°C and 60%RH, and a drawing rate of 20%/minute, wherein the polyester film has a size of 1 cm (width) × 20 cm in each of a film production flow direction (MD) and a film width direction (TD) and fracture strength values in the directions MD and TD are obtained; and
with respect to the intrinsic viscosity, a polyester is dissolved in a mixed solution of 1,1,2,2-tetrachloroethane/phenol (=2/3 [mass ratio]) at 25°C and the intrinsic viscosity is measured at 25°C by using Ubbelohde viscometer.

**2.** The biaxially stretched polyester film according to claim 1, wherein a content of voids with a maximum length of 1 μm or greater is one void or less per 400 $\mu m^2$ of the biaxially stretched polyester film, wherein the content of voids of the biaxially stretched film is measured by using an electron microscope with a magnification of 1000 times, wherein a sample for the measurement is prepared by cutting the film and grinding a cut surface of the film with microtome.

**3.** The biaxially stretched polyester film according to claim 1 or 2, wherein:

the biaxially stretched polyester film comprises a polyester that is synthesized using, as a polymerization catalyst, at least one selected from the group consisting of a titanium compound, an aluminum compound and a germanium compound, all of which are soluble in glycol; and
a total of a content of a phosphorous element and a content of a metal element in the polyester is from 10 ppm to 300 ppm.

**4.** The biaxially stretched polyester film according to any one of claims 1 to 3,
wherein the biaxially stretched polyester film is formed of a polyester that comprises a 1,4-cyclohexane dimethylene terephthalate unit as 0.1% by mole to 20% by mole or 80% by mole to 100% by mole of its constituent unit.

**5.** A method of producing the biaxially stretched polyester film according to any one of claims 1 to 4, the method comprising:

preparing a raw material polyester resin that is synthesized using, as a polymerization catalyst, at least one selected from the group consisting of a titanium compound, an aluminum compound and a germanium compound, all of which are soluble in glycol, and in which a total of a content of a phosphorous element and a content of a metal element is 300 ppm or less;
plasticizing the raw material polyester resin at a temperature in a range from a temperature higher than a melting point of the raw material polyester resin by 10°C to a temperature higher than the melting point of the raw material polyester resin by 35°C, melt-extruding the polyester resin, and cooling the melt-extruded polyester resin to form an unstretched polyester film having a thickness of from 2.5 mm to 7.0 mm; and
longitudinally stretching and laterally stretching the unstretched polyester film to form a biaxially stretched polyester film having a thickness of from 200 μm to 800 μm.

**6.** The method according to claim 5, wherein an intrinsic viscosity IV of the raw material polyester resin is from 0.68 to 0.95.

**7.** The method according to claim 5 or 6, wherein a compound including a cyclic structure, in which a primary nitrogen

and a secondary nitrogen of a carbodiimide group are bonded by a bonding group, is added to the raw material polyester resin before the cooling at an amount of from 0.1% by mass to 5% by mass with respect to a mass of the raw material polyester resin.

**8.** A solar cell module comprising the biaxially stretched polyester film according to any one of claims 1 to 4.

**Patentansprüche**

**1.** Biaxial gestreckte Polyesterfolie, mit:

einer Dicke von 200 $\mu$m bis 800 um;
einer Bruchfestigkeit in sowohl Längs-Streckrichtung (MD) als auch Quer-Streckrichtung (TD) von 180 MPa bis 300 MPa;
einer internen Trübung (Hin) von 0,3 % bis 20 %;
einem Unterschied ($\Delta$H = Hsur - Hin) zwischen der externen Trübung (Hsur) und der internen Trübung (Hin) von 2 % oder weniger; und
einer Grenzviskosität von 0,68 bis 0,90,

worin die biaxial gestreckte Polyesterfolie aus einem Polyester gebildet ist, der eine Ethylenterephthalat-Einheit oder eine 1,4-Cyclohexandimethylenterephthalat-Einheit in einer Menge von 80 Mol% oder mehr von dessen Aufbaueinheiten aufweist und eine Konzentration von endständigen Carboxylgruppen von 25 Äquivalent/t oder kleiner aufweist,
worin die externe Trübung (Hsur) das Ausmaß der Streuung von reflektiertem Licht auf einer Oberfläche des Films darstellt,
und worin im Hinblick auf die interne Trübung (Hin) die biaxial gestreckte Folie in eine Quarzzelle gegeben wird, worin Tricresylphosphat eingefüllt wird, und welche eine Dicke von 10 mm aufweist, und dann die interne Trübung unter Verwendung eines Trübungsmessers gemessen wird, wohingegen die externe Trübung (Hsur) direkt mit der gleichen Vorrichtung ohne Eintauchen der biaxial gestreckten Folie in Tricresylphosphat gemessen wird;
worin im Hinblick auf die Bruchfestigkeit ein Zugtest einer Polyesterfolie unter Verwendung eines universalen Tensilon-Zugtesters in einer Umgebung bei 25°C und 60 % relativer Luftfeuchtigkeit durchgeführt wird und eine Zuggeschwindigkeit von 20 %/Minute verwendet wird, worin die Polyesterfolie eine Größe von 1 cm (Breite) $\times$ 20 cm in jeder von der Folienherstellungs-Fließrichtung (MD) und der Folienbreitenrichtung (TD) aufweist und die Bruchfestigkeitswerte in den Richtungen MD und TD erhalten werden; und
worin im Hinblick auf die Grenzviskosität der Polyester in einer gemischten Lösung aus 1,1,2,2-Trichlorethan/Phenol (= 2/3 [Masseverhältnis]) bei 25°C gelöst wird und die Grenzviskosität bei 25°C mit einem Ubbelohde-Viskosimeter gemessen wird.

**2.** Biaxial gestreckte Polyesterfolie gemäß Anspruch 1, worin die Anzahl von Hohlräumen mit einer maximalen Länge von 1 $\mu$m oder größer einen Hohlraum oder weniger je 400 $\mu m^2$ der biaxial gestreckten Polyesterfolie beträgt, worin die Anzahl von Hohlräumen in der biaxial gestreckten Folie unter Verwendung eines Elektronenmikroskops mit einer Vergrößerung von 1.000-fach gemessen wird, worin eine Probe für die Messung durch Schneiden der Folie und Mahlen einer geschnittenen Oberfläche der Folie mit einem Mikrotom zubereitet wird.

**3.** Biaxial gestreckte Polyesterfolie gemäß Anspruch 1 oder 2, worin:

die biaxial gestreckte Polyesterfolie einen Polyester umfasst, der unter Verwendung von zumindest einem, ausgewählt aus der Gruppe, bestehend aus einer Titanverbindung, einer Aluminiumverbindung und einer Germaniumverbindung, als Katalysator synthetisiert ist, die alle in Glykol löslich sind; und
die Summe der Menge des Elements Phosphor und der Menge eines Metallelements in dem Polyester von 10 ppm bis 300 ppm beträgt.

**4.** Biaxial gestreckte Polyesterfolie gemäß irgendeinem der Ansprüche 1 bis 3, worin die biaxial gestreckte Polyesterfolie aus einem Polyester gebildet ist, der eine 1,4-Cyclohexandimethylenterephthalat-Einheit in einer Menge von 0,1 mol% bis 20 mol% oder 80 mol% bis 100 mol% von dessen Aufbaueinheiten umfasst.

**5.** Verfahren zur Herstellung der biaxial gestreckten Polyesterfolie gemäß irgendeinem der Ansprüche 1 bis 4, wobei das Verfahren umfasst:

Vorbereiten eines Ausgangsmaterial-Polyesterharzes, das unter Verwendung von zumindest einem, das ausgewählt ist aus der Gruppe, bestehend aus einer Titanverbindung, einer Aluminiumverbindung und einer Germaniumverbindung, die alle in Glykol löslich sind, als Katalysator synthetisiert ist, und worin die Summe der Menge des Elements Phosphor und der Menge eines Metallelements 300 ppm oder weniger beträgt;
Plastifizieren des Ausgangsmaterial-Polyesterharzes bei einer Temperatur im Bereich von einer Temperatur, die um 10°C höher ist als der Schmelzpunkt des Ausgangsmaterial-Polyesterharzes, bis zu einer Temperatur, die um 35°C höher ist als der Schmelzpunkt des Ausgangsmaterial-Polyesterharzes, Schmelzextrudieren des Polyesterharzes und Kühlen des schmelzextrudierten Polyesterharzes, um eine ungestreckte Polyesterfolie mit einer Dicke von 2,5 mm bis 7,0 mm zu bilden; und
Strecken der ungestreckten Polyesterfolie in Längs- und Querrichtung, um eine biaxial gestreckte Polyesterfolie mit einer Dicke von 200 $\mu$m bis 800 $\mu$m zu bilden.

**6.** Verfahren gemäß Anspruch 5, worin die Grenzviskosität IV des Ausgangsmaterial-Polyesterharzes von 0,68 bis 0,95 beträgt.

**7.** Verfahren gemäß Anspruch 5 oder 6, worin eine Verbindung, die eine cyclische Struktur umfasst, worin ein primärer Stickstoff und ein sekundärer Stickstoff einer Carbodiimidgruppe durch eine Verbindungsgruppe verbunden sind, zu dem Ausgangsmaterial-Polyesterharz vor dem Kühlen in einer Menge von 0,1 Masse-% bis 5 Masse-%, bezogen auf die Masse des Ausgangsmaterial-Polyesterharzes, zugegeben wird.

**8.** Solarzellenmodul, umfassend die biaxial gestreckte Polyesterfolie gemäß irgendeinem der Ansprüche 1 bis 4.

**Revendications**

**1.** Film de polyester étiré biaxialement, comprenant :

- une épaisseur de 200 $\mu$m à 800 $\mu$m ;
- une résistance à la rupture à la fois dans une direction d'étirement longitudinale (MD) et dans une direction d'étirement latérale (TD) allant de 180 MPa à 300 MPa ;
- un voile interne (Hin) de 0,3% à 20 % ;
- une différence ($\Delta$H = Hsur- Hin) entre un voile externe (Hsur) et le voile interne (Hin) de 2 % ou inférieure ; et
- une viscosité intrinsèque de 0,68 à 0,90,

le film de polyester étiré biaxialement étant formé d'un polyester qui comprend une unité de téréphtalate d'éthylène ou une unité de téréphtalate de 1, 4-cyclohexane diméthylène représentant 80 % en moles ou plus de son unité constituante, et qui possède une concentration en groupes carboxyle terminaux de 25 éq/tonne ou inférieure,
dans lequel le voile externe (Hsur) représente une intensité de diffusion de la lumière réfléchie sur une surface du film, et dans lequel concernant le voile interne (Hin), le film étiré biaxialement est placé dans une cellule en quartz remplie de phosphate de tricrésyle et qui a une épaisseur de 10 mm, puis le voile interne est mesuré en utilisant un appareil de mesure de voile, tandis que le voile externe (Hsur) est directement mesuré par le même appareil sans immersion du film étiré biaxialement dans le phosphate de tricrésyle ;
concernant la résistance à la rupture, un test de tension d'un film de polyester est effectué en utilisant un testeur de tension universel Tensilon dans un environnement de 25°C et 60 % d'humidité relative, et un taux d'étirage de 20 %/minute, le film de polyester ayant une taille de 1cm(largeur)x20cm, dans chaque direction parmi une direction de flux de production du film (MD) et une direction de largeur de film (TD), et des valeurs de résistance à la rupture dans les directions MD et TD sont obtenues ; et
concernant la viscosité intrinsèque, un polyester est dissous dans une solution mélangée de 1,1,2,2-tétrachloroéthane/phénol (=2/3 [rapport en masse]) à 25°C, et la viscosité intrinsèque est mesurée à 25°C en utilisant un viscosimètre Ubbelohde.

**2.** Film de polyester étiré biaxialement selon la revendication 1, dans lequel une teneur en vides d'une longueur maximale de 1$\mu$m ou supérieure représente un vide ou moins pour 400 $\mu m^2$ du film de polyester étiré biaxialement, la teneur en vides du film étiré biaxialement étant mesurée en utilisant un microscope électronique avec un grossissement de 1000 fois,
dans lequel un échantillon de mesure est préparé en coupant le film et en broyant une surface coupée du film avec un microtome.

3. Film de polyester étiré biaxialement selon la revendication 1 ou 2, dans lequel :

   - le film de polyester étiré biaxialement comprend un polyester qui est synthétisé en utilisant, comme catalyseur de polymérisation, au moins un composé choisi dans le groupe constitué par un composé de titane, un composé d'aluminium et un composé du germanium, qui sont tous solubles dans du glycol ; et
   - un total d'une teneur d'un élément de phosphore et d'une teneur d'un élément métallique dans le polyester est de 10 ppm à 300 ppm.

4. Film de polyester étiré biaxialement selon l'une quelconque des revendications 1 à 3, dans lequel le film de polyester étiré biaxialement est formé d'un polyester qui comprend une unité de téréphtalate de 1,4-cyclohexane diméthylène représentant de 0,1 % en moles à 20 % en moles ou 80 % en moles à 100 % en moles de son unité constituante.

5. Procédé de fabrication du film de polyester étiré biaxialement selon l'une quelconque des revendications 1 à 4, le procédé comprenant :

   - préparer une résine de polyester de départ qui est synthétisée en utilisant, comme catalyseur de polymérisation, au moins un composé choisi dans le groupe consistant en un composé de titane, un composé d'aluminium et un composé du germanium, qui sont tous solubles dans du glycol, et dans lequel un total d'une teneur d'un élément de phosphore et d'une teneur d'un élément métallique est de 300 ppm ou inférieur;
   - plastifier la résine de polyester à une température comprise dans une plage allant d'une température supérieure de 10°C à un point de fusion de la résine de polyester de départ à une température supérieure de 35°C au point de fusion de la résine de polyester de départ, extruder la résine de polyester à l'état fondu, et refroidir la résine de polyester extrudée à l'état fondu pour former un film de polyester non étiré ayant une épaisseur de 2,5 mm à 7,0 mm ; et
   - étirer longitudinalement et étirer latéralement le film de polyester non étiré pour former un film de polyester étiré biaxialement ayant une épaisseur de 200 μm à 800 μm.

6. Procédé selon la revendication 5, dans lequel une viscosité intrinsèque IV de la résine de polyester de départ est de 0,68 à 0,95.

7. Procédé selon la revendication 5 ou 6, dans lequel un composé comprenant une structure cyclique, dans laquelle un atome d'azote primaire et un atome d'azote secondaire d'un groupe carbodiimide sont liés par un groupe de liaison, est ajouté à la résine de polyester de départ avant le refroidissement en une quantité de 0,1 % en masse à 5 % en masse par rapport à une masse de la résine de polyester de départ.

8. Module de cellules solaires comprenant le film de polyester étiré biaxialement selon l'une quelconque des revendications 1 à 4.

FIG. 1

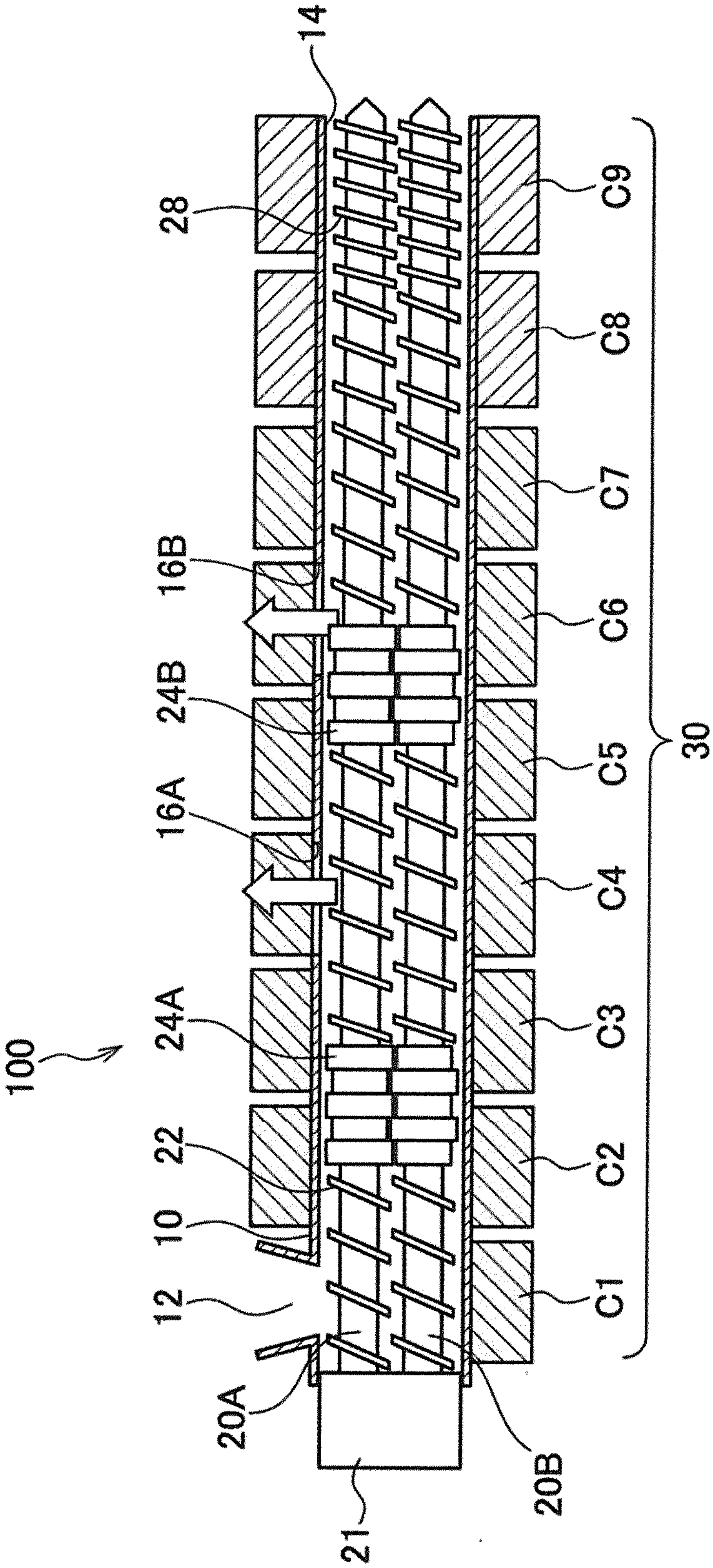
100
10
12
14
16A
16B
20A
20B
21
22
24A
24B
28
30
C1
C2
C3
C4
C5
C6
C7
C8
C9

FIG. 2

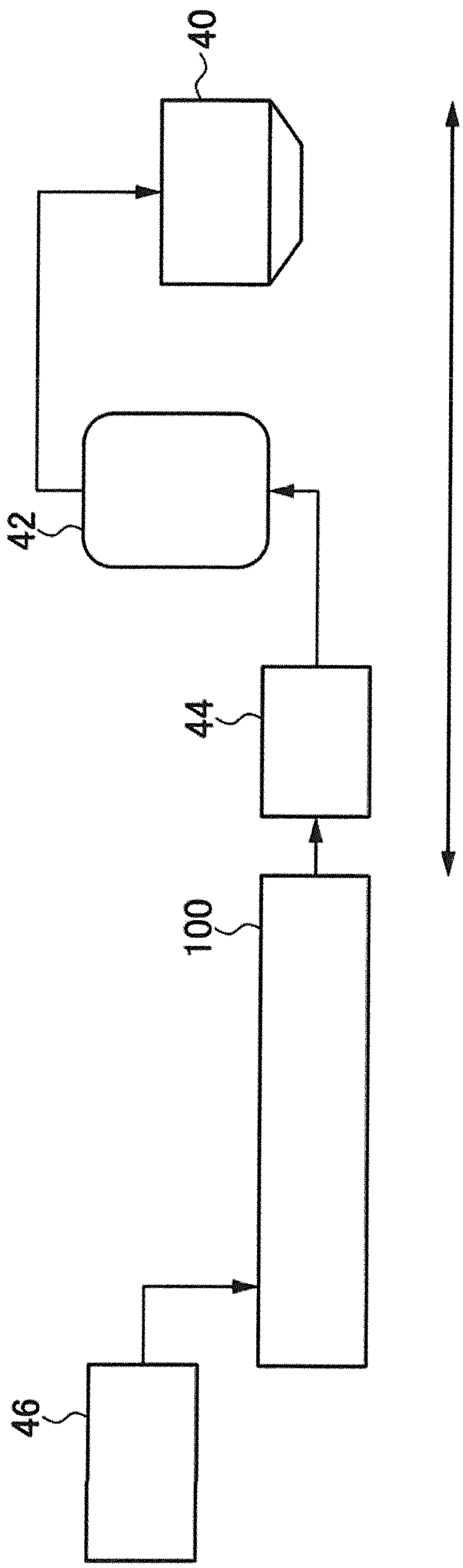

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006253264 A
- JP 2008166338 A
- JP 2010260903 A
- JP 2011153209 A
- JP 2009149066 A
- JP 2011256337 A
- JP 8030119 B
- JP 2543624 B
- JP 3335683 B
- JP 3717380 B
- JP 3897756 B
- JP 3962226 B
- JP 3979866 B
- JP 3996871 B
- JP 4000867 B
- JP 4053837 B
- JP 4127119 B
- JP 4134710 B
- JP 4159154 B
- JP 4269704 B
- JP 4313538 B
- JP 2621563 B
- JP 3121876 B
- JP 3136774 B
- JP 3603585 B
- JP 3616522 B
- JP 3617340 B
- JP 3680523 B
- JP 3717392 B
- JP 4167159 B